(19) Europäisches Patentamt
European Patent Office
Office européen des brevets

(11) **EP 4 198 258 A1**

(12) **EUROPEAN PATENT APPLICATION**

(43) Date of publication:
**21.06.2023 Bulletin 2023/25**

(51) International Patent Classification (IPC):
***E21B 43/00*** (2006.01)

(21) Application number: **21306844.8**

(22) Date of filing: **17.12.2021**

(52) Cooperative Patent Classification (CPC):
**E21B 43/00;** E21B 2200/20

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **TotalEnergies OneTech**
**92400 Courbevoie (FR)**

(72) Inventors:
• **VESSAIRE, Cyrille**
**PAU (FR)**
• **RODRIGUEZ MARTINEZ, Alejandro**
**PAU (FR)**
• **CHANCELIER, Jean-Philippe**
**PAU (FR)**

(74) Representative: **Bandpay & Greuter**
**30, rue Notre-Dame des Victoires**
**75002 Paris (FR)**

(54) **MULTIPERIOD OPTIMIZATION OF OIL AND/OR GAS PRODUCTION**

(57) The disclosure notably relates to a computer-implemented method for multiperiod optimization of oil and/or gas production. The method comprises providing a controlled dynamical system. The controlled dynamical system describes the evolution over time of a state of an oil and/or gas reservoir. The method further comprises providing a time-dependent admissible set of controls. The controls describe actions respecting constraints for controlling oil and/or gas flow and/or pressure. The method further comprises providing time-dependent observations of the content of the reservoir. The method further comprises optimizing, with respect to the state of the reservoir, the controls and the observations, an expected value over a given time span of an objective production function of the state, the controls and the observations. This constitutes an improved solution for oil and/or gas production.

**Description**

**TECHNICAL FIELD**

The disclosure relates to the field of computer programs and systems, and more specifically to a method, system and program for multiperiod optimization of oil and/or gas production.

**BACKGROUND**

Oil and gas production projects usually span over several decades and involve complex planning and decision making. The lifetime of a hydrocarbon field is usually decomposed in five phases: exploration, where reservoirs containing hydrocarbon are found; appraisal, to give a value to a field; development, where infrastructure is planned and installed; production, where hydrocarbon is finally produced; abandonment, where the field stops producing and the infrastructures are decommissioned and removed. An increasing concern is to improve the oil and/or gas production, and thus to optimize it.

However, there is still a need for improved solutions for oil and/or gas production optimization.

**SUMMARY**

It is therefore provided a computer-implemented method for multiperiod optimization of oil and/or gas production. The method comprises providing a controlled dynamical system. The controlled dynamical system describes the evolution over time of a state of an oil and/or gas reservoir. The method further comprises providing a time-dependent admissible set of controls. The controls describe actions respecting constraints for controlling oil and/or gas flow and/or pressure. The method further comprises providing time-dependent observations of the content of the reservoir. The method further comprises optimizing, with respect to the state of the reservoir, the controls and the observations, an expected value over a given time span of an objective production function of the state, the controls and the observations.

The method may comprise one or more of the following:

- the controlled dynamical system comprises evolution equations derived from material balance equations and/or black oil models;
- the controlled dynamical system is of the type:

$$x_{t+1} = f(x_t, u_t),$$

where $t$ represents the time, $x_t$ the state of the reservoir at time $t$, and $u_t$ the controls at time $t$, and where $f$ is of the type:

$$f\colon (x,u) \mapsto \begin{pmatrix} x^{(1)} - \Phi^{(1)}(x,u) \\ x^{(2)} - \Phi^{(2)}(x,u) + \left[x^{(1)}R_s\left(x^{(5)}\right) - \\ \left(x^{(1)} - \Phi^{(1)}(x,u)\right)R_s\left(\Xi(x,u)\right)\right] \\ x^{(3)} - \Phi^{(3)}(x,u) \\ x^{(5)}\left(1 + c_f(\Xi(x,u) - x^{(5)})\right) \\ \Xi(x,u) \end{pmatrix}$$

where:

- $x = (x^{(1)}, x^{(2)}, x^{(3)}, x^{(4)}, x^{(5)})$,
- $R_s$ represents dissolved gas,
- $c_f$ represents the pore compressibility of the reservoir,
- $(x,u)\colon \mapsto \Phi(x,u)$ represents production values as a function of $(x, u)$,
- $\Xi$ is a function such that $P^R_{t+1} = \Xi(x_t, u_t)$, where $P^R$ represents a reservoir pressure;

- the optimizing comprises solving an optimization problem of the type:

$$\min_{X,O,U} \mathbb{E}\left[\sum_{t=0}^{\mathcal{T}-1} L_t(X_t, U_t) + K(X_{\mathcal{T}})\right]$$

$$s.t. L_{X_0} = \mu_0$$

$$X_{t+1} = f(X_t, U_t), \forall t \in \mathbb{T},$$

$$O_t = h(X_t), \forall t \in \mathbb{T},$$

$$U_t \in U_t^{ad}(X_t), \forall t \in \mathbb{T},$$

$$\sigma(U_t) \subset \sigma(O_0, \dots, O_t, U_0, \dots, U_{t-1}), \forall t \in \mathbb{T},$$

where:

  ◦ $X, O, U$ are respectively the state of the reservoir, the observations, and the controls,
  ◦

$$\mathbb{T} = \{0, \dots, \mathcal{T}\}$$

is a finite set of time steps, where $\mathcal{T}$ is a positive integer,
◦ $L_t$ is the objective production function at time $t$,

◦ $K(X_{\mathcal{T}})$ is an objective final production function,
◦ $\mu_0$ is a probability distribution representing an initial state of the reservoir,
◦ $X_{t+1} = f(X_t, U_t)$ corresponds to the dynamical system, ◦ h is an observation function,

◦ $U_t^{ad}$ represents a set of admissible controls at time $t$;

-   the observations comprise partial observations;
-   the observations depend only on the state of the reservoir;
-   the observations are observations functions of the form

$$O_t = h(X_t),$$

where $X_t$, $O_t$ represent respectively the state of the reservoir and the observations at time $t$, and where $h$ is of the type

$$h(x) = \begin{pmatrix} x^{(5)} \\ \omega^{ct}\left(x^{(3)}, x^{(4)}, x^{(5)}\right) \\ g^{or}\left(x^{(2)}, x^{(4)}, x^{(5)}\right) \end{pmatrix},$$

where $\omega^{ct}$ is a function representing a water-cut and $g^{or}$ is a function representing a gas-oil ratio, and where $x = (x^{(1)}, x^{(2)}, x^{(3)}, x^{(4)}, x^{(5)})$;
-   the optimization comprises solving an optimization problem that is a Deterministic Partially Observed Markov Decision Process (det-POMDP);

- the optimization comprises discretizing the optimization problem;
- discretizing the optimization problem comprises providing a discrete control set and a discrete observation set and building a discrete space state by recursively applying the dynamics on a given initial state with associated controls, the discrete space state being a set of the space states reachable from the given initial state;
- discretizing the optimization problem comprises constructing a state of beliefs, which are probabilities on the discrete state space; and/or
- the Deterministic Partially Observed Markov Decision Process has monotonicity, such that the state of reachable beliefs is included in a subset of the probability space.

It is further provided a computer program comprising instructions for performing the method.

It is further provided a computer readable storage medium having recorded thereon the computer program.

It is further provided a computer system comprising a processor coupled to a memory, the memory having recorded thereon the computer program.

## BRIEF DESCRIPTION OF THE DRAWINGS

Non-limiting examples will now be described in reference to the accompanying drawings, where:

- FIG.s 1 to 12 illustrate the method; and

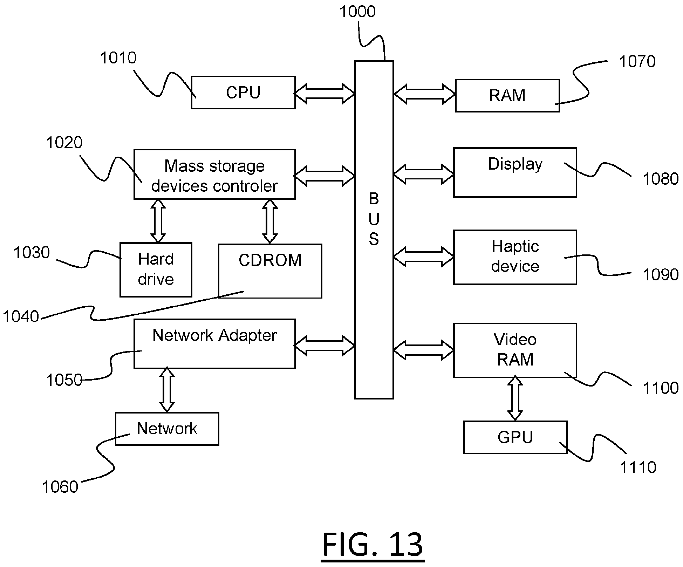

- FIG. 13 shows an example of the system.

## DETAILED DESCRIPTION

It is proposed a computer-implemented method for multiperiod optimization of oil and/or gas production. The method comprises providing a controlled dynamical system. The controlled dynamical system describes the evolution over time of a state of an oil and/or gas reservoir. The method further comprises providing a time-dependent admissible set of controls. The controls describe actions respecting constraints for controlling oil and/or gas flow and/or pressure. The method further comprises providing time-dependent observations of the content of the reservoir. The method further comprises optimizing, with respect to the state of the reservoir, the controls and the observations, an expected value over a given time span of an objective production function of the state, the controls and the observations.

The method forms an improved solution for oil and/or gas production optimization.

Notably, the method performs multiperiod optimization of oil and/or gas production, i.e. allows to optimize a production of oil and/or gas over a given time span that comprises several time periods. For that, the method optimizes an expected value of an objective production function over a given time span (i.e. that encompasses several time periods, *e.g.* several years or months forming a production phase or at least a part thereof) with respect to time-evolving variables of the function which are the state of the underlying reservoir, observations of the content of the reservoir, and admissible controls that describe actions respecting constraints for controlling oil and/or gas flow and/or pressure. Furthermore, the method describes the time-evolution of the state of the reservoir as a controlled dynamical system such that the time evolution of the state variable accounts for the controls and the observations. This improves robustness of the optimization and enables multiperiod optimization with high accuracy.

The output of the optimization is the expected value of the objective function optimized over the given time span with respect to the state of the reservoir, the controls and the observations. This value represents an objective oil and/or gas production value over the given time-span and allows to take real-time decisions and/or actions for oil and/or gas production by exploiting a real-world reservoir. The method may further comprise displaying the optimized value. The method may be performed several times, each execution of the method yielding a respective output optimized value, and the method may then further comprise displaying a graph representing the respective optimized values (*e.g.* for different reservoir configurations) and/or performing statistics on the optimized values, *e.g.* to take real-time decisions and/or actions for oil and/or gas production by exploiting a real-world reservoir. The controls obtained as a result of the optimization are policies, *i.e.* functions of the observations that may be then used in real-time with real-world observations.

The method may be included in an oil and/or gas production process (*e.g.* for a single reservoir or for several reservoirs connected to one another) which may comprise:

- performing the method thereby obtaining an optimized expected value over a time span of an objective function that represents an optimal production of the time span for a real-world reservoir or for several real-world reservoirs connected to one another and thereby also obtaining optimal controls for the real-world reservoir(s) as functions of (*e.g.* partial observations) of the content of the real-world reservoir(s), the controls describing actions respecting constraints for controlling oil and/or gas flow and/or pressure;
- taking production decisions based on the optimized value, such as drilling and/or positioning injection wells and/or production wells and/or positioning valves and/or pipes; and/or
- performing physical actions based on the decisions, such as physically drilling and/or physically positioning injection wells and/or production wells and/or physically positioning valves and/or pipes.

The method is now further discussed.

The method is for multiperiod optimization of production of oil and/or gas from the reservoir. The method thus optimizes the production over the given time span that encompasses several periods, *e.g.* several years or months of production, *e.g.* several decades of production.

The method comprises providing a controlled dynamical system. The controlled dynamical system describes the evolution over time of a state of an oil and/or gas reservoir, where the time evolution of the state depends on the current state and controls. In other words, the dynamically system describes how the state of the reservoir evolves over time given the controls. The state may be a vector comprising one or more variables each representing a physical quantity describing a property of the reservoir. The one or more variables are time-evolving variables, and may comprise any one or any combination of (*e.g.* all of): the time-evolving amount of oil in the reservoir, the time-evolving amount of free gas in the reservoir, the time-evolving amount of water in the reservoir, the time-evolving total pore volume of the reservoir, and/or the time-evolving reservoir pressure. The dynamical system is controlled, which means that the state variable at a given time depends on the time-dependent controls, *e.g.* at previous time. The time-dependent state and/or controls may further depend on the time-dependent observations. The providing of the controlled dynamical system may comprise establishing the controlled dynamical system, *e.g.* by deriving the equations thereof. The controlled dynamical system may comprise evolution equations derived from material balance equations and/or black oil models. In such a case, deriving the controlled dynamical system may comprise deriving the controlled dynamical system from material balance equations and/or black oil models. The controlled dynamical system may be of the type:

$$x_{t+1} = f(x_t, u_t),$$

where *t* represents the time, $x_t$ the state of the reservoir at time *t*, and $u_t$ the controls at time *t*, and where *f* is of the type:

$$f:(x,u) \mapsto \begin{pmatrix} x^{(1)} - \Phi^{(1)}(x,u) \\ x^{(2)} - \Phi^{(2)}(x,u) + \left[ x^{(1)} R_s(x^{(5)}) - \left( x^{(1)} - \Phi^{(1)}(x,u) \right) R_s(\Xi(x,u)) \right] \\ x^{(3)} - \Phi^{(3)}(x,u) \\ x^{(5)} \left( 1 + c_f(\Xi(x,u) - x^{(5)}) \right) \\ \Xi(x,u) \end{pmatrix} \qquad (S)$$

where:

- $x = (x^{(1)}, x^{(2)}, x^{(3)}, x^{(4)}, x^{(5)})$,
- $R_s$ represents dissolved gas,
- $c_f$ represents the pore compressibility of the reservoir,
- $(x, u): \mapsto \Phi(x, u) = (\Phi^{(1)}(x, u), \Phi^{(2)}(x, u), \Phi^{(3)}(x, u))$ represents production values as a function of $(x, u)$,
- $\Xi$ is a function such that $P_{t+1}^R = \Xi(x_t, u_t)$, where $P^R$ represents a reservoir pressure.

The component variables $x^{(1)}, x^{(2)}, x^{(3)}, x^{(4)}, x^{(5)}$ of the state *x* may respectively be the time-evolving amount of oil in the reservoir, the time-evolving amount of free gas in the reservoir, the time-evolving amount of water in the reservoir, the time-evolving total pore volume of the reservoir, and the time-evolving reservoir pressure. $\Phi$ may be a general production function which may comprise, as coordinates, the production of oil $\Phi^{(1)}$, the production of free gas $\Phi^{(2)}$, and the production or injection of water $\Phi^{(3)}$. In examples,

$$\Phi(x,u) = \tilde{\Phi}(h(x), u)$$

where $\tilde{\Phi}$ is a vector function with three coordinates representing respectively the production of oil as a function of $(h(x),u)$, the production of free gas as a function of $(h(x),u)$, and the production or injection of water as a function of $(h(x),u)$, where $h(x)$ is an observation function that takes as input $x$ and that outputs the observation of the content of the reservoir corresponding to $x$.

The method further comprises providing a time-dependent admissible set of controls. The controls describe actions respecting constraints for controlling oil and/or gas flow and/or pressure. For example, the controls may include opening or closing a valve and/or or a pipe, and/or choosing a well-head, and/or a bottom-hole pressure. The time-dependent admissible set of controls may be a mapping which at each given time, takes as input the state of the reservoir at the given time and returns the set of controls that are allowable for this state. The set of allowable controls may depend on the reservoir pressure, which constrains the different pressure in the production system. Additionally or alternatively, the set of allowable controls may depend on the production network, for example some pipes can be controlled while others cannot and/or maintenance forces facilities to be closed at different periods.

The method further comprises providing time-dependent observations of the content of the reservoir. The time-dependent observations consists in an observation function that takes as input at each given time the state of the reservoir at the given time, and in examples also the controls at the given time, and returns an observation at the given time of the content of the reservoir. The observation may be a vector comprising (*e.g.* consisting of) coordinates comprising any one or any combination of (*e.g.* all of): reservoir pressure at the given time, the time-evolving water-cut at the given time (*e.g.* as a function of the amount of water in the reservoir at the given time, of the total pore volume of the reservoir at the given time, and of the reservoir pressure at the given time), and/or the gas-oil ratio at the given time (*e.g.* as a function of the amount of free gas in the reservoir at the given time, of the total pore volume of the reservoir at the given time, and of the reservoir pressure at the given time).

The method may further comprise providing an initial value for the state of the reservoir (*e.g.* provided as a probability distribution). The starting point may further comprise an initial value of the observations.

The method then comprises optimizing, with respect to the state of the reservoir, the controls and the observations, an expected value over a given time span of an objective production function of the state, the controls and the observations. Optimizing with respect to the state of the reservoir, the controls and the observations means that the state, the controls and the observations are the free variables of the optimization. The optimization thus searches for the values of these variables that tend to optimize (*e.g.* minimize or maximize) the expected value over a given time span of the objective production function. The optimization is constrained by constraints between the linking state, controls and observations, the constraints being given by the controlled dynamical system (*e.g.* by the function $f$ discussed above and the observation function). The given time span may be a time-interval that encompasses several production periods, *i.e.* several periods where parameters of the production and/or affecting the production vary from one period to another, *e.g.* several months or years or decades. Optimizing may comprise applying any suitable optimization algorithm. Optimizing may for example apply a multi-stage optimization method, *e.g.* using a Dynamic Programming algorithm, as discussed in implementations hereinbelow. The objective production function may be any production function, such as any function that capture the oil and/or gas that can be produced, *e.g.* depending on material and/or cost constraints. The objective production function may in examples be of the type:

$$L_t(x, \mathrm{u}) = r_t^T \Phi(x, u) - c^T u$$

where $\Phi$ is the general production function which has been previously discussed, $r_t^T$ is a vector price for the production of each fluid (oil, gas and water) and $c$ is a cost associated with the controls, such as a functioning cost of a pump which re-injects water in the reservoir

The optimizing may solving, *i.e.* using any suitable optimization method such as a multi-stage optimization method using a Dynamic Programming algorithm, an optimization problem of the type:

$$\min_{X,O,U} \mathbb{E}\left[ \sum_{t=0}^{\mathcal{T}-1} L_t(X_t, U_t) + K(X_\mathcal{T}) \right] \qquad (P)$$

$$s.t. L_{X_0} = \mu_0$$

$$X_{t+1} = f(X_t, U_t), \forall t \in \mathbb{T},$$

$$O_t = h(X_t), \forall t \in \mathbb{T},$$

$$U_t \in U_t^{ad}(X_t), \forall t \in \mathbb{T},$$

$$\sigma(U_t) \subset \sigma(O_0, \ldots, O_t, U_0, \ldots, U_{t-1}), \forall t \in \mathbb{T},$$

where:

- *X, O, U* are respectively the state of the reservoir, the observations, and the controls,
- 

$$\mathbb{T} = \{0, \ldots, \mathcal{T}\}$$

  is a finite set of time steps, where $\mathcal{T}$ is a positive integer,
- $L_t$ is the objective production function at time *t*,
- $K(X_{\mathcal{T}})$ is an objective final production function,
- $\mu_0$ is a probability distribution representing an initial state of the reservoir,
- $X_{t+1} = f(X_t, U_t)$ corresponds to the dynamical system,
- h is an observation function,
- $U_t^{ad}$ represents a set of admissible controls at time *t*.

The function *f* in the optimization problem may be the function

$$f : (x, u) \mapsto \begin{pmatrix} x^{(1)} - \Phi^{(1)}(x, u) \\ x^{(2)} - \Phi^{(2)}(x, u) + [x^{(1)} R_s(x^{(5)}) - \\ (x^{(1)} - \Phi^{(1)}(x, u)) R_s(\Xi(x, u))] \\ x^{(3)} - \Phi^{(3)}(x, u) \\ x^{(5)} \left(1 + c_f(\Xi(x, u) - x^{(5)})\right) \\ \Xi(x, u) \end{pmatrix}$$

given by equation (S) and which has been previously discussed.

In examples, observations comprise partial observations. In other words, the time-dependent observations represent time-dependent partial observations, *i.e.* the content of the reservoir is only partially observed by the observations. This allows to perform the optimization even if the content of the reservoir is partially observed, which in practice, in oil and/or gas production, may often be the case. For example, the observations may depend only on the state of the reservoir, *e.g.* the mapping that yields the observations at a given time takes as input only the state at the given time, and thus does not directly account for the effects of the controls applied at the given time. In examples, the observations are observations functions of the form

$$O_t = h(X_t),$$

where $X_t, O_t$ represent respectively the state of the reservoir and the observations at time *t*, and where *h* is of the type

$$h(x) = \begin{pmatrix} x^{(5)} \\ \omega^{ct}\big(x^{(3)}, x^{(4)}, x^{(5)}\big) \\ g^{or}\big(x^{(2)}, x^{(4)}, x^{(5)}\big) \end{pmatrix},$$

where $\omega^{ct}$ is a function representing a water-cut and $g^{or}$ is a function representing a gas-oil ratio, and where $x = (x^{(1)}, x^{(2)}, x^{(3)}, x^{(4)}, x^{(5)})$. The component variables $x^{(1)}$, $x^{(2)}$, $x^{(3)}$, $x^{(4)}$, $x^{(5)}$ of the state $x$ may respectively be the time-evolving amount of oil in the reservoir, the time-evolving amount of free gas in the reservoir, the time-evolving amount of water in the reservoir, the time-evolving total pore volume of the reservoir, and the time-evolving reservoir pressure, as previously-discussed.

When the observations are partial observations, the optimization may comprise solving an optimization problem that is a Deterministic Partially Observed Markov Decision Process (det-POMDP). For example, the previously discussed optimization problem (P):

$$\min_{X,O,U} \mathbb{E}\left[\sum_{t=0}^{\mathcal{T}-1} L_t(X_t, U_t) + K(X_{\mathcal{T}})\right]$$

$$s.t. L_{X_0} = \mu_0$$

$$X_{t+1} = f(X_t, U_t), \forall t \in \mathbb{T},$$

$$O_t = h(X_t), \forall t \in \mathbb{T},$$

$$U_t \in U_t^{ad}(X_t), \forall t \in \mathbb{T},$$

$$\sigma(U_t) \subset \sigma(O_0, \ldots, O_t, U_0, \ldots, U_{t-1}), \forall t \in \mathbb{T},$$

may be a Deterministic Partially Observed Markov Decision Process (det-POMDP). The concept of det-POMDP is known per se in the art and the method may use any suitable method for solving such problems for performing the optimization, such as performing a multi-stage optimization method using a Dynamic Programming algorithm, as discussed hereinafter.

The optimization may comprise discretizing the optimization problem. Discretizing the optimization problem may comprise providing a discrete control set and a discrete observation set and building a discrete space state by recursively applying the dynamics (*i.e.* the controlled dynamical system) on a given initial state with associated controls. The discrete space state is a set of the space states reachable from the given initial state. Discretizing the optimization problem may further comprise constructing a state of beliefs, which are probabilities on the discrete state space. A belief indicates a probability for a given state to be reached from the initial state. The Deterministic Partially Observed Markov Decision Process may in examples have monotonicity, such that the state of reachable beliefs is included in a subset of the probability space, for example a fan-like or com-like subset. Monotonicity means that the det-POMDP is such that, if two sequences of controls lead to a same state when staring in a given state, then applying the two sequences of controls to another state either leads to a same result (*i.e.* leads to a same state), or one sequence leads to a cemetery point. The cemetery point is a point that may be added to the state space (*i.e.* so that the discrete state space may comprise the cemetery point) and that represents an unreachable state when considering past and present observations. Monotonicity of the det-POMDP thus allows to save computational time and computation resources for the optimization.

Implementations and aspects of the method, including mathematical concepts involved in the method, are now discussed.

In implementations, the controlled dynamical system that describes the reservoir's state (behavior) overtime consists of a controlled dynamical system which gives the evolution over time of physical quantities which characterize the hydrocarbon field under exploitation. In these implementations, the underlying equations are derived from material balance equations on the reservoir and under the hypothesis that the fluids contained in the reservoir follow a model known under the name of "black-oil models". Still in these implementations, the optimization may solve an optimization problem over time for an oil and gas production system which may be formulated with a deterministic formulation, the optimization problem being governed by the controlled dynamical system.

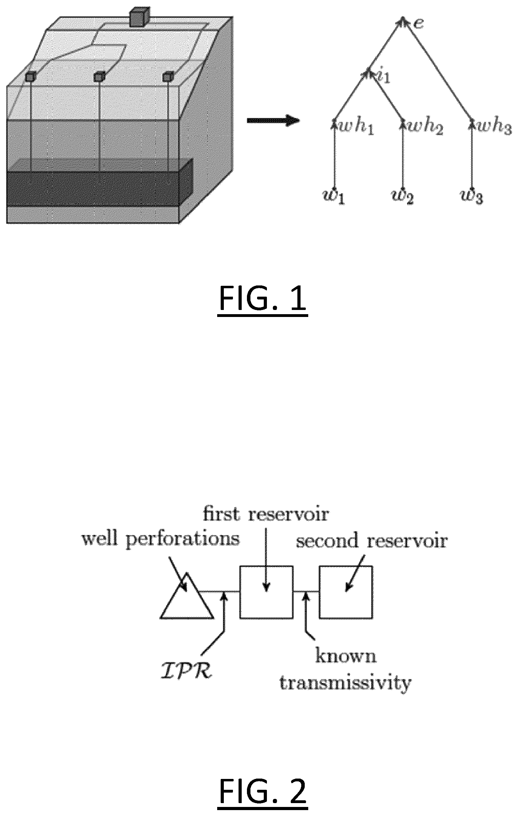

In the presently-discussed implementations, the reservoir is part of a production system that consists of the reservoir and of production assets such as pipes, wells, chokes. The topology of the production assets is represented as a graph $\mathcal{G} = (\mathbb{V}, \mathbb{A})$ where $\mathbb{V}$ is the set of vertices and $\mathbb{A} \subset \mathbb{V}^2$ is the set of arcs. Control variables are indexed by either nodes or edges. The different production assets are placed on the graphs, with the pipes as the arcs and the rest of the assets such as the well-heads are the nodes. FIG. 1 illustrates such a graphs, where the well's perforations are represented as nodes ($\omega_i$) where the fluid produced enter the graph. On the other nodes, there are assets such as well-head chokes($\omega h_j$), or joints between different pipes ($i_1$). Although not shown on FIG. 1, such graphs may comprise valves to open or close pipes. There is also an export point $e$.

All the relevant operational constraints and features, such as pressure loss on the pipes, mass balance of the fluids at each node, allowed pressure and flow rate ranges in different assets or unavailability due to maintenance are modeled as constraints using variables defined on the arcs and nodes of the graph. Indeed, the graph allows to define different controls that can be applied on the system, such as opening or closing valves, or changing the well-head pressure.

The implementations optimize the system over the whole production phase (*i.e.* over multiple years), so multiple time steps belonging to a finite set

$$T = \{0, ..., \mathcal{T}\}$$

are considered, where $\mathcal{T}$ is a positive integer. The time steps may correspond to months or years. The optimization problem may be formulated as follows

$$\mathcal{J}^*(x_0) = \max_{x,u} \ \sum_{t=0}^{\mathcal{T}-1} \rho^t \mathcal{L}_t(x_t, u_t) + \rho^{\mathcal{T}} \mathcal{K}(x_{\mathcal{T}}) \qquad (2.1\text{a})$$

$$s.t. \ \ x_0 \ given \ , \qquad\qquad\qquad (2.1\text{b})$$

$$x_{t+1} = f(x_t, u_t) \ , \ \ \forall t \in \mathbb{T} \setminus \{\mathcal{T}\} \ , \qquad (2.1\text{c})$$

$$u_t \in \mathcal{U}_t^{ad}(x_t) \ , \ \ \forall t \in \mathbb{T} \setminus \{\mathcal{T}\} \ . \qquad (2.1\text{d})$$

The variables are: the controls $u_t$, which are the decisions that can be taken at time step $t$ (in this case, the pressure $P_{v,t}$ at the different vertex $v \in V$ of the graph, and the Boolean $o_{a,t}$ stating if a pipe $a \in A$ of the graph is opened or closed); the state of the reservoir $x_t$, as the reservoir is defined as a controlled dynamical system, with state $x_t \in \mathbb{X} \subset \mathbb{R}^n$ (with $\mathbb{X}$ the state space), control $u_t \in \mathbb{U}$ and an evolution function of the controlled dynamical system, $f$. At every time step $t$, when the decision maker takes decision $u_t$ an instantaneous gain denoted by $\mathcal{L}_t(x_t, u_t)$ occurs.

In the last stage, the final state $x_{\mathrm{T}}$ (the quantity of fluids remaining in the reservoir) is valued as $\mathcal{K}(x_{\mathrm{T}})$. Let $\rho$ be the discount factor. The objective function (2.1a) is finally obtained by adding all those terms. Equation (2.1b) define the known initial state of the reservoir. Equation (2.1c) gives the controlled dynamics of the reservoir. Equation (2.1d) states that the allowed controls belong to an admissibility set, which is for each time step $t$ a set-valued mapping which takes a given state $x_t$ of the reservoir and returns the set of allowed controls. Admissibility notably depends on the reservoir pressure, which constrains the different pressures in the petroleum production system. The admissibility set also depends on the production network itself: some pipes can be controlled, while others cannot; or maintenance force facilities to be closed at different periods.

As can be seen in the general formulation (2.1), the implementations consider a deterministic controlled dynamical system. Note that, here, it is assumed a perfect knowledge of the content of the reservoir $x_t$. In implementations later discussed, another formulation with partial observation of the content of the reservoir will be discussed. Since the state $x_t$ is known, the implementations may use dynamic programming to solve this problem.

In order to solve problem (2.1), the implementations use a family of value functions $\mathcal{J}_t \colon \mathbb{X} \longmapsto \mathbb{R}$, where $\mathbb{X}$ is the state space. A policy $\mu = \{\mu_0,...,\mu_{T\text{-}1}\}$ is a set of functions $\mu_t$ that maps states $x_t$ into admissible controls $u_t$. The following proposition is known from the prior art:

Proposition 1. *For every initial state* $x_0 \in \mathbb{X}$ *, the optimal cost* $\mathcal{J}^*(x_0)$ *of the problem* (2.1) *is equal to* $\tilde{\mathcal{J}}_0(x_0)$ *, given by the last step of the following algorithm, which proceed backward in time from final time step T to initial time step* 0.

$$\mathcal{J}_T(x_T) = \mathcal{K}(x_T) , \;\; \forall x_T \in \mathbb{X} \qquad\qquad (2.2a)$$

$$\mathcal{J}_t(x_t) = \min_{u_t \in \mathcal{U}_t^{ad}(x_t)} \Big( \rho^t \mathcal{L}_t(x_t, u_t) + \mathcal{J}_{t+1}\left( f(x_t, u_t) \right) \Big) , \;\; \forall x_t \in \mathbb{X}, \forall t \in \mathbb{T} \setminus \{\mathcal{T}\} \qquad (2.2b)$$

*Furthermore, if*

$$u_t^\star = \mu_t^\star(x_t)$$

*minimizes the right-hand side of* (2.2b) *for each $x_t$ and t, then the policy*

$$\mu^\star = \left\{ \mu_0^\star, \ldots, \mu_{\mathcal{T}-1}^\star \right\}$$

*is optimal.*

To solve Problem 2.1, the implementations compute $\mathcal{J}_0$ by using a dynamic programming algorithm (Algorithm 1 below). For that purpose, the implementations discretize the controls, that now belong to a finite set denoted by $\mathbb{U}_d$ , and the states that belong to a finite set $\mathbb{U}_d$ . The implementations also consider that the value functions follow a multilinear interpolation between the states.

**Algorithm 1:** Dynamic Programming algorithm used to solve Problem (2.1)

```
for x ∈ X_d do
    J_T(x) = K(x);
for t ∈ {T − 1 ... 1} do
    for x ∈ X_d do
        best_value = 0;
        best_controls = 0;
        for u ∈ U_d do
            current_value = J_{t+1}(f(x, u)) + L_t(x, u);
            if current_value ≥ best_value then
                best_value = current_value;
                best_controls = u;
        J_t(x) = best_value;
        μ_t(x) = best_controls;
return J, μ
```

The definition of the dynamical system according to implementations of the invention is now discussed. The dynamical system is defined with a state $x$ and an evolution function $f$ such that, for each time step $t$, $x_{t+1} = f(x_t, u_t)$. The state is given by the formula

$$x_t = \left(V_t^o, V_t^g, V_t^w, V_t^p, P_t^R\right),$$

where the components are defined in table 2.1 below (where $Sm^3$ stands for standard cubic meter, *i.e.* the volume taken by a fluid at standard pressure and temperature condition (1.01325 Bar and 15°C)):

Table 2.1: Definition of the components of the state

| Symbol | Definition |
| --- | --- |
| $V_t^g$ | Amount of oil in the reservoir ($Sm^3$) at time $t$ |
| $V_t^w$ | Amount of free gas in the reservoir ($Sm^3$) at time $t$ |
| $V_t^p$ | Amount of water in the reservoir ($Sm^3$) at time $t$ |
| $P_t^R$ | Total pore volume of the reservoir ($m^3$) at time $t$ <br> Reservoir pressure (*bara*) at time $t$ |

To define the evolution function $f$ of the content of the reservoir between time $t$ and $t + 1$, the amounts of fluids produced during the period $[t, t + 1]$ are used in these implementations. We denote them by $\left(F_t^o, F_t^g, F_t^w\right)$ and they are described in Table 2.2 below. We obtain those production values with the mapping $\Phi : \mathbb{X} \times \mathbb{U} \to \mathbb{R}^3$ such that $(F_t^o, F_t^g, F_t^w) = \Phi(x, u)$. The production mapping $\Phi$ depends on the form and specifications of the production network.

Table 2.2: Definition of the productions

| Symbol | Definition |
|--------|-----------|
| $F_t^o$ | Volume of oil produced ($Sm^3$) during $[t, t+1[$ |
| $F_t^g$ | Volume of gas produced ($Sm^3$) during $[t, t+1[$ |
| $F_t^w$ | Volume of water produced ($Sm^3$) during $[t, t+1[$ |

The following assumptions on the reservoir are made: first, the fluids contained in the reservoir follow a black-oil model; second, it is considered the reservoir is a tank-like reservoir. Using these assumptions, the following result holds: **Proposition 2**. *There exists a function* $\Xi : \mathbb{X} \times \mathbb{U} \to \mathbb{R}$ *such that the following function f*

$$f : (x, u) \mapsto \begin{pmatrix} x^{(1)} - \Phi^{(1)}(x, u) \\ x^{(2)} - \Phi^{(2)}(x, u) + \left[ x^{(1)} R_s(x^{(5)}) - \right. \\ \left. (x^{(1)} - \Phi^{(1)}(x, u)) R_s(\Xi(x, u)) \right] \\ x^{(3)} - \Phi^{(3)}(x, u) \\ x^{(4)} \left( 1 + c_f(\Xi(x, u) - x^{(5)}) \right) \\ \Xi(x, u) \end{pmatrix} \qquad (2.3)$$

*is the dynamics of the reservoir in (2.1c) (with x = ($x^{(1)}$,...,$x^{(5)}$), $R_s$ is the solution gas, and $c_f$ is the pore compressibility of the reservoir).*

Two numerical applications illustrating the use of the material balance formulation are now discussed. The first application is a gas reservoir that can be modeled with two tanks and with a connection of known transmissivity linking the two together. It illustrates how the formulation can be applied to complex cases with multiple tanks. In the second application it is consider is an oil reservoir where pressure is kept constant through water injection. This shows how injection may be taken into account to go beyond the first recovery of oil and gas. All numerical applications were performed on a computer equipped with a Core i7-4700K and 16 GB of memory.

## First application: a gas reservoir with one well

In the first application, it is considered consider a gas reservoir, with production data that comes from a field approaching abandonment. It is a subfield constituted of an isolated reservoir and one well which is part of a larger field which is not considered here. The good geology of this particular case make it perfect for a tank model, as proved by many years of perfectly matched production. Also, the simplicity of the fluids with a high methane purity make the black-oil model a very realistic assumption. The reservoir can be modeled with either one or two tanks, while the well perforation is modeled with a known stationary inflow performance relationship, noted IPR. The two tanks model is illustrated in FIG. 2. The rest of the network is not considered, and only optimization at the bottom of the well is done, without considering any vertical lift performance necessary to lift oil to the surface.

The goal here is to show how simple cases can be tackled with the material balance formulation, and that the formulation can also be applied on cases with multiple reservoirs. It is now presented the state reduction of this real case, and then a model with one tank, and then a model with two tanks.

**Formulation and state reduction:** It is considered that the reservoir contains only gas and water. There is also no water production. The amount of water $V^w$ in the reservoir is therefore stationary, and considered to be a known parameter. Therefore one only needs to consider the evolution of the amount of gas, the pressure and the total pore volume as states variables. The general equation stating that the volume of the fluids in the reservoir must be equal to the total pore volume of the reservoir (Equation (2.17) in Appendix 2.A) thus simplifies here to:

$$V^w \times B_w(P_{t+1}^R) + \left[ V_t^g - F_t^g \right] \times B_g(P_{t+1}^R)$$
$$= V_t^p \left( 1 + c_f(P_{t+1}^R - P_t^R) \right) \qquad (2.4)$$

Finally, since it is known that the pore compressibility $c_f$ may be considered to be a constant, the total pore volume $V^p$ can be expressed as a function of the pressure, i.e. $V_t^p = V_0 e^{c_f P_t^R}$, and Equation (2.4) can therefore be inverted thanks to the $\mathcal{W}$ Lambert function (the inverse relation of $f(w) = we^w$). One thus only needs to consider the amount of gas in the reservoir as the reduced state of reservoir. The details regarding this reduction will be discussed hereinafter. Since an optimization at the bottom of the well is done, one only has one control to consider: the bottom-hole pressure, noted $P_t$. Therefore $x_t = V_t^g$ and $u_t = P_t$.

The optimization problem (2.1) after state and control reduction when considering one tank is given by:

$$\max_{(V_t^g, P_t, P_t^R, F_t^g)} \sum_{t=0}^{T-1} \rho^t r_t F_t^g \qquad (2.5a)$$

$$s.t. \; V_0^g = x_0 , \qquad (2.5b)$$

$$P_t^R = \Psi^{1\mathbf{T}}(V_t^g) , \; \forall t \in \mathbb{T} , \qquad (2.5c)$$

$$F_t^g = \frac{\mathcal{IPR}\left(P_t^R - P_t\right)}{B_g(P_t^R)} , \; \forall t \in \mathbb{T} , \qquad (2.5d)$$

$$V_{t+1}^g = V_t^g - F_t^g , \; \forall t \in \mathbb{T} , \qquad (2.5e)$$

$$0 \le F_t^g \le F_{max}^g , \; \forall t \in \mathbb{T} , \qquad (2.5f)$$

$$V_t^g \ge 0 , \; \forall t \in \mathbb{T} , \qquad (2.5g)$$

$$P_t \ge 0 , \; \forall t \in \mathbb{T} . \qquad (2.5h)$$

Equation (2.5c), the mapping $\Psi^{1T}$ is a function that can be algorithmically computed (as discussed hereinafter) and that takes the volume of gas in the reservoir and returns the reservoir pressure, which is used to compute the production, and is detailed hereinafter. Equation (2.5d) is the specific implementation of the general production mapping $\Phi$ applied to the production network. In this application, we have only one well. Its production is defined thanks to $\mathcal{IPR}$, the inflow performance relationship of the well, which is considered to be a known piecewise linear function. For the one tank model the expression of the production mapping $\Phi$ is

$$\Phi^{1\mathbf{T}}(x_t, u_t) = \frac{\mathcal{IPR}\left(\Psi^{1\mathbf{T}}(x_t) - u_t\right)}{B_g(\Psi^{1\mathbf{T}}(x_t))} = F_t^g .$$

For the two tank model, the expression is

$$\Phi^{2\mathbf{T}}\big(x_t^{(1)}, x_t^{(2)}, u_t\big) = \frac{\mathcal{IPR}\left(\Psi^{2\mathbf{T},(1)}(x_t^{(1)}) - u_t\right)}{B_g(\Psi^{2\mathbf{T},(1)}(x_t^{(1)}))} = F_t^g,$$

with $\Psi^{2\mathrm{T},(1)}$ the function returning the pressure in the first tank. The $\Phi$ has been divided in Equations (2.5c) and (2.5d).

Since one has only one well and since the $\mathcal{IPR}$ is strictly monotonous, the production function of Equation (2.5d) is injective. In the models considered here (one tank or two tanks), one can thus transparently pass from the controls to the production and from the production to the controls without any ambiguity. Moreover, one can define the admissibility set of this application. Here, the graph has only one point (one well), and the bottom-hole pressure $P_t$ is controlled. As a production must be positive (constraint (2.5f)), the one tank model gives

$$\mathcal{U}^{ad}(x_t) = \big[0, P_t^R\big] = \big[0, \Psi^{1\mathbf{T}}(x_t)\big].$$

**One tank gas reservoir model**

**Fitting model to real data.** The implementations use production data from a sector of a real gas field to check that the reservoir model described with the Constraints (2.5c) and (2.5e) after fitting accurately follows real measurements on the gas field. More precisely, the implementations apply a given real production schedule on a part of the field (only one well), and check that the pressure we simulate in the reservoir is close to the measured pressure of that reservoir. The historical production spans over 15 years, and one has monthly values, which is why consider monthly timesteps for Problem (2.5) are considered.

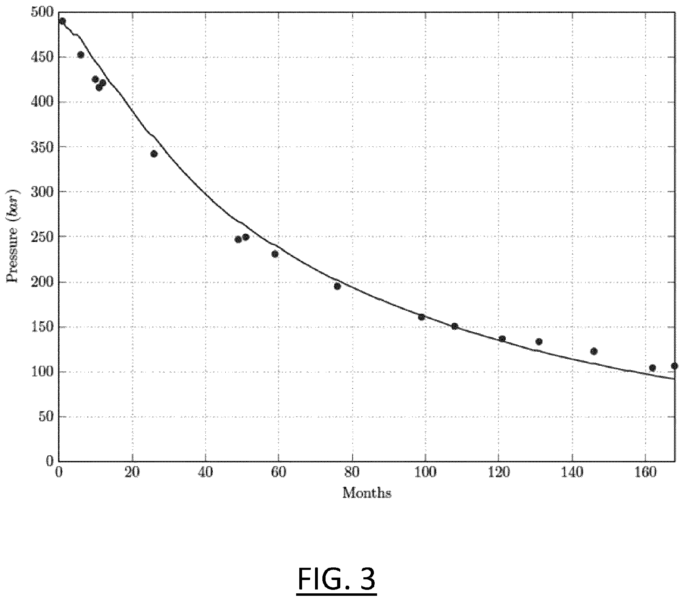

FIG. 3 shows a comparison of the simulated one tank reservoir pressure to the historical measured pressure when applying the same (historical) production schedule. The curve is the simulated pressure in the tank, whereas the dots are the measured pressures. As can be seen in FIG. 3, the one tank model fits the observation. However, there is a gap between the simulated and measured pressures of more than 10%. Since the pressure tends to be higher on the first half of the production, the implementations start by underestimating the decline of the production. Then, during the second half of the production, the predicted pressure is lower than the measured pressure, which means the implementations overestimate the decline of the production. This elastic effect is most likely due to the simplification of removing the secondary tank in the model. Indeed, the secondary tank act as a buffer which react slowly, explaining the extra pressure at the beginning and then sustaining a better value of the pressure latter on.

**Optimization of the production on the one tank approximation.** The implementations use dynamic programming (Algorithm 1) to get an optimal production policy. The implementations consider that the revenue per volume of gas is the historical gas spot price of TTF (Netherlands gas market) from 2006 to 2020, and the implementations do not consider any operational cost.

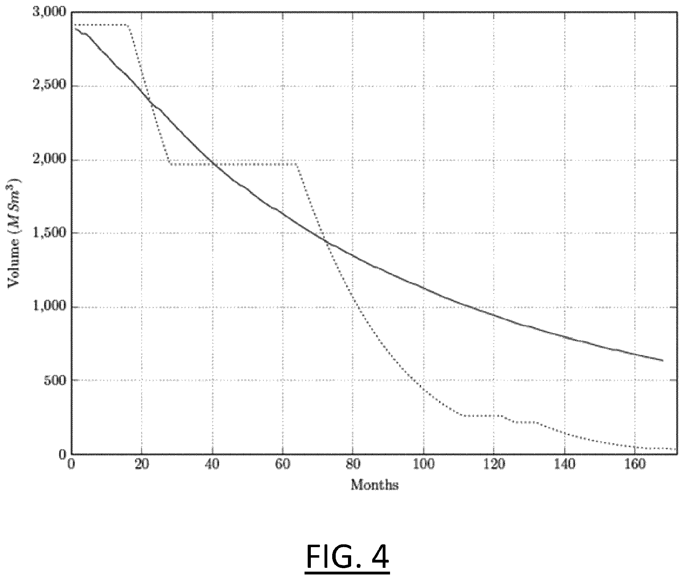

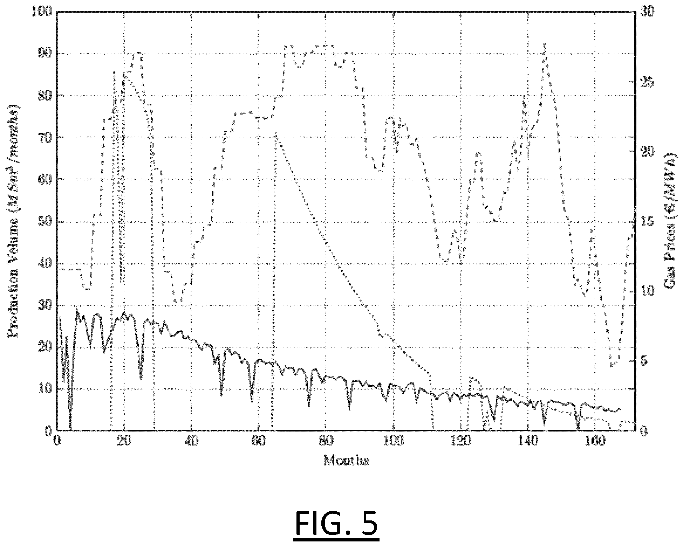

The results of the one tank model are now discussed. The results are illustrated in FIG.s 4 and 5, and summarized in Table 2.3 below. FIG. 4 illustrates the evolution of the content of the reservoir in the one tank model. The doted curve is the optimal trajectory of the amount of gas, while the full-line curve is the trajectory with the historical production. FIG. 5 illustrates the trajectory of the production. The dotted curve is the optimal production in the one tank model, the full-line curve is the historical production, whereas the dashed curve is the average monthly gas price. FIG. 5 shows that the production stops when prices are low as we fully take advantage of the perfect knowledge of the future prices. There is a massive increase in the total gains when using the optimal policy, compared to the real production. One also produces far more over the optimization time period ($2,850\mathrm{Sm}^3$ instead of $2,250\mathrm{Sm}^3$). However, those results are not truly comparable. Indeed, since the considered case is a small part of a much larger production network, one cannot compare the results to the actual production policy used for fitting the model, which was made with the rest of the network in mind. Moreover, the optimization is made at the bottom of the well (BHFP). The implementations only account the inflow performance of the well, not the vertical lift necessary to bring the gas to the surface. The resulting rates are therefore not realistic, reaching values closer to a multi-well development. Furthermore, the historical production was made without knowing future price, and could also have been made with constraints to ensure a minimal production of the field, or having a positive cashflow (constraints due to the contract for exploiting the field). While not directly comparable, this gas reservoir application still illustrates one of the best case scenario of the dynamic programming approach, and shows how much could be gained from using a multistage material balance formulation.

The numerical experiments also reveal that the value function seems to almost be an affine function, that grows with the initial volume of in place gas in the reservoir. Moreover, since the Dynamic Programming algorithm uses a discretization of the state space $\mathbb{X}_d$ and the control space $\mathbb{U}_d$, different uniform discretization were tried for the states and controls spaces to prevent any side effects due to the chosen discretization. One does not observe notable changes in the value function past a 10000 points uniform discretization of the state space and a 20 points discretization of the control space, which are the values we used in this paragraph. Details on the effect of the discretization will be discussed later.

Comparison of the material balance formulation to those using decline curves or oil-deliverability curves is now discussed. Precision on the decline curves formulation and how decline curves are obtained will be discussed later.

First, the following result (for which a proof will be given later) compares the two approaches (decline curves and dynamic programming) on the one tank model:

**Proposition 3.** *The formulation using decline curves, written*

$$\max_{x,u} \quad \sum_{t=0}^{\mathcal{T}} \rho^t \mathcal{L}_t(u_t) \tag{2.6a}$$

$$s.t. \quad F_t^o \leq g\left(\sum_{s=0}^{t-1} F_s^o\right) \ , \quad \forall t \in \mathbb{T} \setminus \{0\} \tag{2.6b}$$

$$u_t \in \mathcal{U}_t^{ad}\left(\sum_{s=0}^{t-1} F_s^o\right) \ , \quad \forall t \in \mathbb{T} \ , \tag{2.6c}$$

*is equivalent to the material balance formulation when the state of the reservoir is one-dimensional (as in the optimization problem* (2.5)).

The implementations generate the decline curve, g, in inequality (2.6b) of the formulation by computing the maximal production value for the same discrete states as the ones used in the dynamic programming approach. The implementations then interpolate the value of g between the different states. When using piecewise linear approximation for the decline curves, the maximization problem 2.6 turns to be MIP (Mixed Integer Problem) with linear constraints and with 170829 binary variables when not using SOS2 variables. The implementations solve that MIP by using a commercial solver, Gurobi 9.1. The results are given in Table 2.3. Since the material balance formulation (2.5) uses a one-dimensional state, the implementations obtain similar results between the material balance formulation and the formulation using a decline curve in accordance with Proposition 3. The two approaches thus yields similar production policies. Note however that the dynamic programming approach has a lower computation time than a naive implementation of the decline curve formulation. Indeed, one could decrease the precision on the decline curve formulation, and use fewer points to describe the decline curve. This would improve its computation time, and could have a negligible impact on the value of the optimization if the remaining points are correctly chosen.

Table 2.3: Comparison between the material balance and decline curve formulation for one tank

|  | Dynamic Programming | Decline Curves |
|---|---|---|
| CPU time (s) | 653 | 3882 |
| Value (M€) | 743 | 743 |

**Two tanks gas reservoir model**

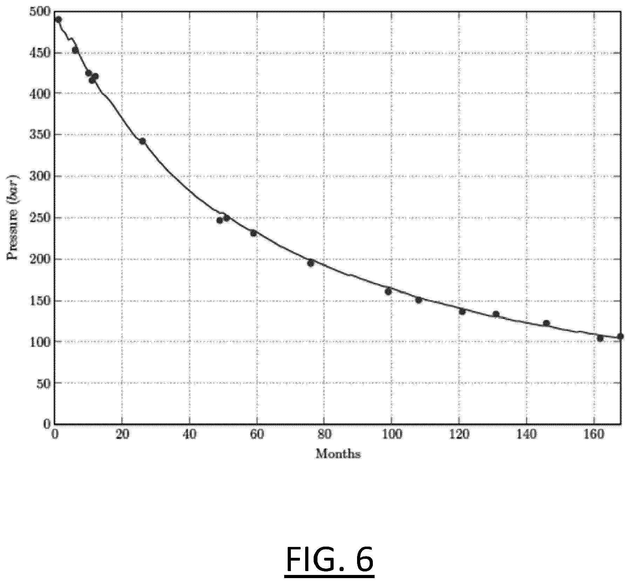

**Fitting data.** The implementations check if the fitted two tanks reservoir model accurately follows real measurement on the gas field. The implementations use the same data as in the one tank case. The two tanks model more accurately fits the observations, as is depicted in FIG. 6 (we have a gap of less than 5% for each measured point). FIG. 6 shows a comparison of the simulated two tanks reservoir pressure to the measured pressure when applying the same production schedule. The curve is the simulated pressure in the first tank, whereas the dots are the measured pressure at the bottom of the well. Since the two tanks model is closer to the observations, it is considered that it is the reference of truth when comparing results of the one tank approximation and the two tanks model.

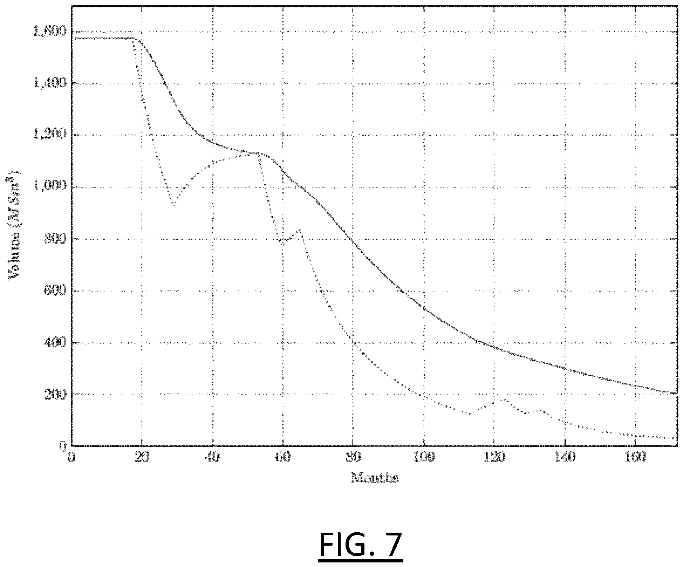

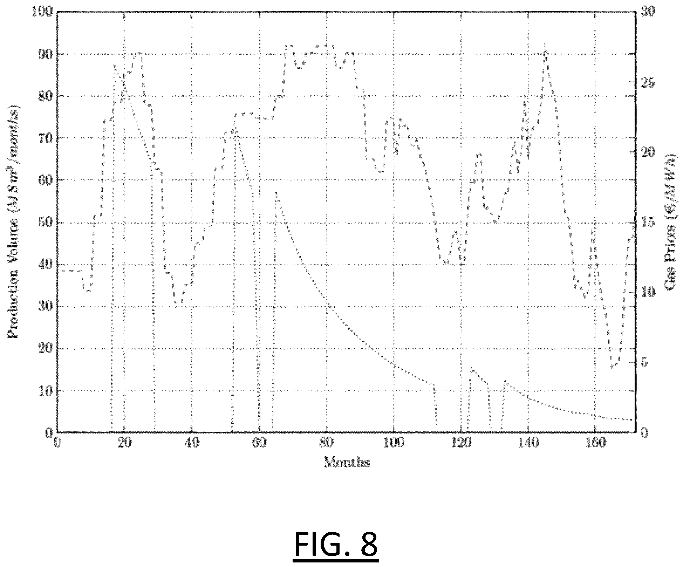

Optimal production with two tanks. It is now discussed the results of the two tanks model. The only changes compared to the one tank model are on the states and the dynamics of the reservoir. The same prices are used, and once again only an optimization at the bottom of the well (BHFP) is done. Details on the obtained optimal controls and states trajectory are given in FIG.s 7 and 8. FIG. 7 illustrates the evolution of the content of the reservoirs when applying the optimal policy in the two tanks model. The dotted curve shows the content of the first tank (linked to the well) while the full-line curve shows the content of the second tank. FIG. 8 illustrates the trajectory of the optimal production in the two tanks model. The dotted curve is the optimal production, whereas the dashed curve is the monthly gas price Once again it is observed that production stops when prices are low, benefiting fully from knowing the future prices. It is also to be noted that more "pauses" are present in the productions when compared to the one tank model (four instead of three). The "pauses" allows the second tank to replenish the first one. Indeed, production resumes at months 50 to 60, before stopping again for five months. One can then observe that the amount of gas in the first tank is replenished, before one resumes production at month 65, at the same date as in the one tank model. One ends up producing some more gas than with the one tank model ($2,900Sm^3$ instead of $2,850Sm^3$).

Numerical experiments also reveal that the initial value function is almost an affine function of the sum of the states. This seems to imply that the one tank and two tanks model should yield similar results. Indeed, if the value function truly depended exclusively on the sum of the states, the optimal control would also be a function of the sum of the states.

Different discretization for the state space were tried. Notably, using more than 400 possible states per tank and 10 possible controls did not yield any significant improvement in the computed value function. Details on the impact of the discretization are given later.

**Comparing the one tank formulation to the two tanks formulation.** To compare the results between the two tanks and one tank formulations, the implementations consider that the two tanks material balance model is the reference. One cannot directly compare the productions, as the production functions $\Phi^{1T}$ and $\Phi^{2T}$ of the one tank and two tanks models differs and one cannot translate the state of the two tanks model in the one tank model. One must therefore return to the actual controls, the bottom-hole pressure $P_t$ However, the production planning given by the one tank optimization is not directly admissible in the two tanks model. Indeed, the admissibility set of the system is

$$\mathcal{U}_{ad}(x_t) = [0, \Psi^{1T}(x_t)]$$

for the one tank model, and $[0, \Psi^{2T,(1)}(x_t^{(1)})]$ for the two tanks model. If one applies the production planning of the one tank optimization without any changes, one sometimes has

$$P_t > P_t^{R,(1)} = \Psi^{2T,(1)}(x_t^{(1)})$$

(with $P_t^{R,(1)}$ the pressure in the first tank), which is outside the admissible set of the two tanks model.

To create an admissible production planning from the one tank optimization, the implementations first consider that the control policy is static. One thus has a series of controls

$$\left\{ u_0^\sharp, \ldots, u_{\mathcal{T}-1}^\sharp \right\}$$

computed with the one tank model. To make it admissible, the implementations project those controls on the admissibility set of the two tanks model, which depends on the state. Let $\tilde{u}_t^\sharp$ be the projection of the controls, and $\tilde{x}_t^\sharp$ the states associated with that projected series. Since

$$\left\{ u_0^\sharp, \ldots, u_{\mathcal{T}-1}^\sharp \right\}$$

is admissible for the one tank model, those controls notably verify that $u_t^\sharp \geq 0$. One only needs to check that $u_t^\sharp$ is lower than the first tank pressure. The implementations use for the projection:

$$\tilde{u}_t^\sharp = \min(u_t^\sharp, \Psi^{2\mathbf{T},(1)}(\tilde{x}_t^{\sharp,(1)})),$$

where $\tilde{x}_t^\sharp$ is defined by

$$\tilde{x}_{t+1}^\sharp = f^{2\mathbf{T}}\left(\tilde{x}_t^\sharp, \tilde{u}_t^\sharp\right),$$

and

$$\tilde{x}_0^\sharp = x_0.$$

This transformation of the one tank model controls make them admissible in the two tanks optimization problem, as one now has $0 \le \tilde{u}_t^\sharp \le \tilde{P}_t^{R,(1)}$. One can now make a comparison between the two models and production planning available in the two tanks model.

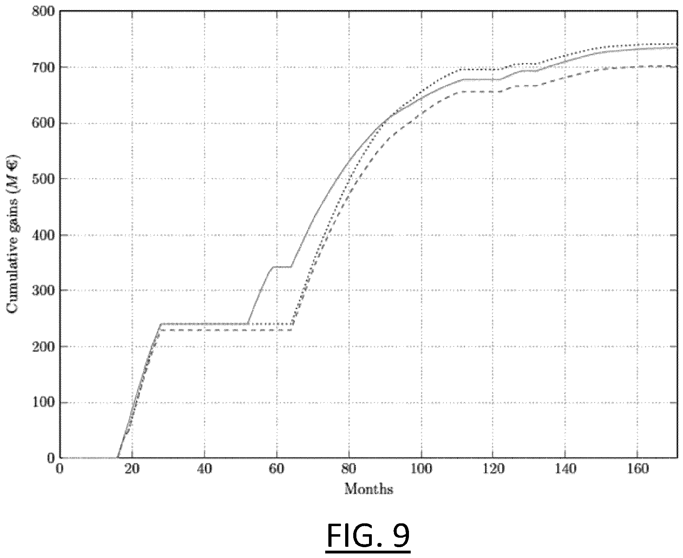

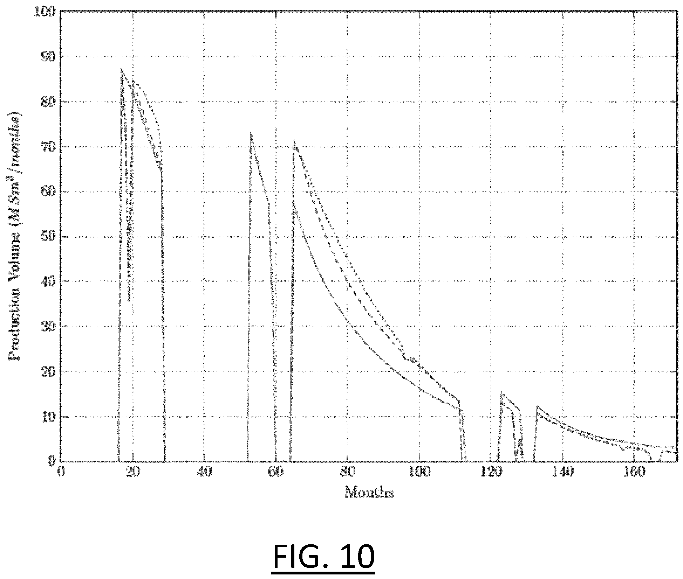

FIG. 9 illustrates the cumulated gains with the two tanks model as reference. The dotted curve is the cumulated gains of the one tank planning in the one tank model, the full-line curve is cumulated gains of the two tanks planning in the two tanks model, and the dashed curve is the cumulated of the one tank planning translated for the two tanks model. FIG. 10 illustrates a comparison of the trajectory of the production with the two tanks model as reference. The dotted curve is the production planning in the one tank model, the full-line curve is for the two tanks model. The dashed curve is the production planning of the one tank model translated in the two tanks model. As depicted in FIG.s 9 and 10, following the production planning given by the one tank optimization problem differs from the production planning given by the two tanks optimization problem. Moreover, the production planning of the one tank model gives lower gains than anticipated, and is worse than the optimal two tanks model planning. The one tank optimization is thus optimistic on the optimal value of the problem when applied in the reference model. Moreover, there is a 5% difference in value between the one tank and two tanks model (a value of 703M€ for the translated one tank production planning against a 736M€ for the two tanks production planning). This discrepancy illustrates how having a more accurate model of the reservoir can have a substantial impact on the optimal planning, all other things being equal. It also shows that contrarily to the assumption presented at the end of the previous paragraph (that the two models could yield similar results if the value function only depended on the sum of the states), the optimal value and control cannot be found with a one tank approximation, and the optimal controls and value functions are not functions of the sum of the states.

**Comparison to decline curves with two tanks.** The decline curve and the material balance formulations were numerically compared in a context where they are known to be equivalent, that is the one tank formulation. It is now discussed numerical experiments in a context where the equivalence is not assured: two tanks connected with a known transmissibility. Decline curves were generated for the two tanks formulation by following a procedure described later As with the comparison between the one tank and the two tanks model, one considers that the two tanks model is the reference. The results returned by the decline curve formulation is an admissible production in the two tanks model, as it is constrained by an admissible production schedule. One can therefore directly compare the values between the two approaches. The results of the optimization of the two formulations are compiled in Table 2.4. One ends up having close results, with a difference in optimal values of 0.5%, but with a large difference in computing times. However, it appeared that such close results were due to the selected price scenario. Using different prices by randomizing the order in which the different prices appear, the gap between the two approaches widen from 0.5% up to 4%. This implies that the initial price considered was an almost best case scenario for the decline curves approach. It also shows that the decline curves approach is far less robust to changes in the price data, and that it cannot benefit as efficiently as the material balance formulation some effects of the two tanks dynamical system, such as waiting for the second tank to empty itself in the first one.

Table 2.4: Comparison between the material balance and decline curve formulation for two tanks with the initial prices sequence.

|  | CPU time (s) | Value (M€) |
| --- | --- | --- |
| Dynamic Programming | 706 | 736 |
| Decline Curves | 7825 | 731 |

Overall, this application demonstrates that the material balance approach can work on complex cases, and that dynamic programming is well suited to optimize an oil production network. Moreover, there can be differences with results from the decline curves approach, which are likely to grow larger with the complexity of the system.

**An oil reservoir with water injection**

The second application is an oil reservoir with water injection. The goal is to demonstrate how the formulation can be used beyond primary recovery cases, on a numerically simple case. It is considered that one has one reservoir which contains both oil and water, produced under pressure maintenance by water injection. Moreover, it is considered that the initial pressure is above the bubble-point, which eliminates the possibility of having free-gas in the reservoir. This allows to have once again a one-dimensional state: either the water (which is used for the numerical applications), or the oil in the reservoir. We have $x_t = V_t^o$ and $u = P_t$. The optimization problem (2.1) now reduces to

$$\max_{(V_t^w, P_t, w_t^{CT})} \sum_{t=0}^{T-1} \left[ \rho^t r_t \alpha \frac{P^R - P_t}{B_o(P^R)} \left[ 1 - w_t^{CT} \right] - \rho^t c_t \alpha \frac{P^R - P_t}{B_w(P^R)} \right] \tag{2.7a}$$

$$s.t. \quad w_t^{CT} = w^{ct} \left( \frac{V_t^w B_w(P^R)}{V^p} \right) , \quad \forall t \in \mathbb{T} , \tag{2.7b}$$

$$V_{t+1}^w = V_t^w - \alpha \frac{P^R - P_t}{B_w(P^R)} \left[ w_t^{CT} - 1 \right] , \quad \forall t \in \mathbb{T} , \tag{2.7c}$$

$$F_{min}^w \le \alpha \frac{P^R - P_t}{B_w(P^R)} \left[ w_t^{CT} - 1 \right] \le F_{max}^w , \quad \forall t \in \mathbb{T} , \tag{2.7d}$$

$$F_{min}^o \le \alpha \frac{P^R - P_t}{B_o(P^R)} \left[ 1 - w_t^{CT} \right] \le F_{max}^o , \quad \forall t \in \mathbb{T} , \tag{2.7e}$$

$$P_t \ge 0 , \quad \forall t \in \mathbb{T} . \tag{2.7f}$$

It is assumed that the water-cut $w^{ct}$ (the amount of water produced when extracting one cubic meter) is given by a piecewise linear function. The water-cut depends on the water saturation $S^w$ (proportion of water in the reservoir). Since the reservoir pressure is kept constant, the total pore volume is constant and the water saturation expression is thus $S_t^w = \frac{V_t^w B_w(P^R)}{V^p}$. This gives constraint (2.7b). Since w a constant pressure in the reservoir is to be kept, one needs to re-inject enough water to replace the extracted oil. Replacing the oil with water gives a new dynamics for $V_t^w$ given in Equation (2.7c) (details are discussed later). Equations (2.7d), (2.7e), (2.7f) are constraints on the controls. Indeed, it is considered that the production follows a simplified Darcy's law

$$F_t = \alpha \left( P^R - P_t \right) \tag{2.8}$$

with $\alpha$ the productivity index of the well, $P_t$ the bottom-hole pressure of the well and $F_t$ the total production (mix of oil and water). Combining Equation (2.8), the water-cut and the dynamics (2.7c), we get the constraints (2.7d), (2.7e). A monthly optimization is done, with the 2000 to 2020 historical Brent prices for oil as the prices in the objective function (2.7a).

As previously discussed, the optimal policy yields more production when prices are high, and stop producing when they are low. The production goes from one bound to the other (0 production, with $P_t = P^R$, and full production, with $P_t = 0$).

The production also does not fully deplete the reservoir, which means that it is not advantageous to completely deplete the reservoir if one wants to maximize the profit over the optimization time frame. Indeed, production slowly diminishes with the "stock" of oil in the reservoir. It is more advantageous to wait for high prices before producing, as it will reduce the possible future production. This leads to letting the reservoir have some residual oil, as it is preferred to wait for a higher price instead of producing when prices are low. As a side effect, numerical experiments reveals that the initial value function is almost linear. However, it is only considered simple constraints on the production. As more constraints will be added to the problem, other behaviors will certainly appear. The CPU time was at 1,575s for a 100,000 discretization, with a value of 3,376Me. Impact of the discretization is discussed later.

Overall, this application shows how one can apply the material balance approach beyond first recovery of oil and gas, and that it can be used on different kinds of reservoir.

It has been presented a new formulation for the management of an oil production system, based on the classical material balance equations. This formulation, where the reservoir is a controlled dynamical system, is amenable to a dynamic programming approach. As it has been shown, this approach gives good results in different cases with either oil or gas. Moreover, the dynamic programming algorithm can naturally be parallelized; therefore, the approach can scale to more complex cases.

It has also been shown that this material balance formulation gets better results than formulations based on decline curves. First, one gets the same results between the material balance and decline curves formulation when considering the first recovery of a one tank system. Second, one can efficiently apply the material balance when considering multiple connected tanks. This is not possible for decline curves, as they need to use a given production schedule to be computed. Third, one can apply the material balance formulation to cases which go beyond the first recovery of hydrocarbons. Indeed, as proved in above one can take into account water injection. Moreover, one does not need to assume that wells are independent, or that they are all bundled with the same cumulated production. Optimization done using the material balance formulation can account for interactions between wells and tanks.

Finally, the dynamic programming algorithm can be used in a stochastic framework. The material balance formulation is amenable to tackle uncertainties on the prices, instead of assuming that prices are known in advance. This will render the optimization process more realistic, as an optimal production policy is highly dependent on prices.

**Detailed construction of the reservoir as a dynamical system**

It is now discussed the construction of the reservoir as a dynamical system. This serves as the proof of Proposition 2.

**Constitutive equations assuming the Black-oil model for the fluids**

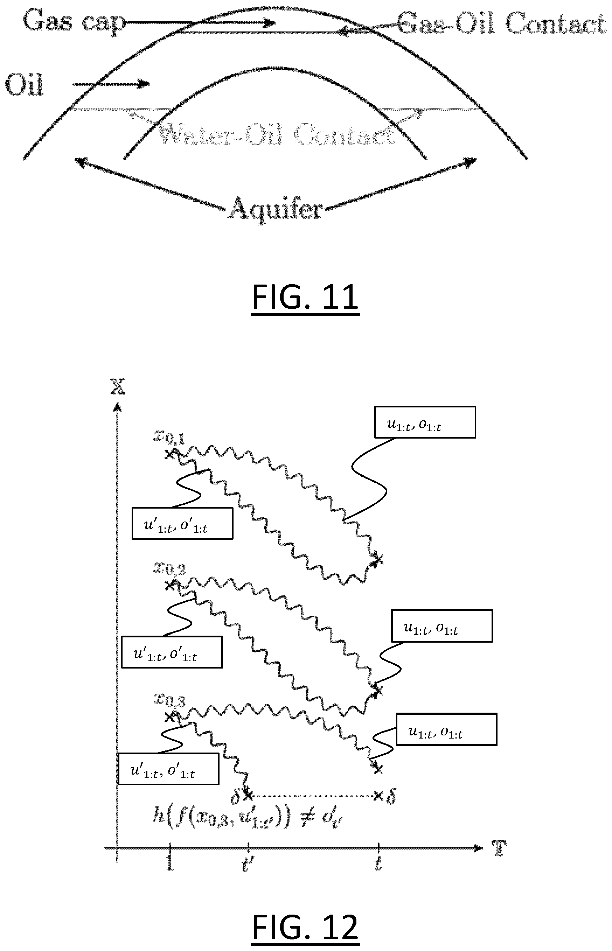

The black-oil model relies on the assumption that there are at most three fluids in the reservoir: oil, gas and water. The fluids can be in up to two phases in the reservoir: a liquid phase, and a gaseous phase. In the liquid phase, one can have a mix of oil with dissolved gas, and water. In the gaseous phase, one can only have free gas. This can be seen in FIG. 11, which is a representation of a reservoir in the black oil-model.

The implementations use standard volume for each of the following components:

- $V^o$ for oil (in the liquid phase)
- $V^g$ for the free gas (in the gaseous phase)
- $V^{dg}$ for the dissolved gas (in the liquid phase)
- $V^\omega$ for the water (in the liquid phase)

It is considered that the temperature in the reservoir is stationary and uniform (this a common assumption for a geological formation such as a reservoir). One needs to compute the place taken for those fluids at different reservoir pressures (we will not need temperature, as it is stationary). To do so, the implementations use PVT functions (Pressure-Volume-Temperature) that have been measured in lab samples. Those functions are defined in Table 2.5 below. It is known that, for a given amount of fluids, the volume taken by that mix is decreasing with pressure. This is useful when proving the uniqueness of the pressure for a given production of the fluids.

Table 2.5: Definition of the PVT functions

| Notations | Description |
|---|---|
| $B_o$ | Oil formation volume factor. It is the volume in barrels occupied in the reservoir, at the prevailing pressure and temperature, by one stock tank barrel of oil plus its dissolved gas. (unit: *rb/stb*) |
| $B_g$ | Gas formation volume factor. It is the volume in barrels that one standard cubic foot of gas will occupy as free gas in the reservoir at the prevailing reservoir pressure and temperature, (unit: *rb/scf*). |
| $B_w$ | Water formation factor. It is the volume occupied in the reservoir by one stock tank barrel of water. (unit: *rb/stb*) |
| $R_s$ | Solution (or dissolved) gas. It is the number of standard cubic feet of gas which will dissolve in one stock tank barrel of oil when both are taken down to the reservoir at the prevailing reservoir pressure and temperature. (unit: *scf/stb*) |

It is considered that the reservoir acts like a tank. This means that its structural integrity is guaranteed, so there is no leakage of any fluids, and there will not be any in the future either. One can therefore write material balance equations (or mass conservation) for each fluid of the reservoir. Let $F^o$, $F^g$ and $F^\omega$ the amount of fluids produced (respectively oil, gas and water).

Using material balance for the oil, one gets

$$V_{t+1}^o = V_t^o - F_t^o \quad \forall t \in \mathbb{T}, \tag{2.9}$$

and, for the water,

$$V_{t+1}^w = V_t^w - F_t^w \quad \forall t \in \mathbb{T}. \tag{2.10}$$

The gas phase requires some more development. At any time, the total amount of dissolved gas in the oil $V^{dg}$ is a function of the amount of oil and the pressure

$$V^{dg} = \delta(V^o, P^R) = V^o \times R_s(P^R). \tag{2.11}$$

Between time $t$ and $t + 1$, the amount of dissolved gas thus evolves from

$$V_t^{dg} = \delta(V_t^o, P_t^R) \text{ to } V_{t+1}^{dg} = \delta(V_{t+1}^{o'}, P_{t+1}^{R'}).$$

Therefore, the quantity of liberated gas $(V_t^{dg} - V_{t+1}^{dg})$ must be added to the gas mass conservation equation. Thus, one has a mass conservation equation for the free gas that can be written as

$$V_{t+1}^g = V_t^g - F_t^g + \underbrace{(V_t^{dg} - V_{t+1}^{dg})}_{liberated\ gas}$$

$$= V_t^g - F_t^g + \left(V_t^o \cdot R_s(P_t^R) - V_{t+1}^o \cdot R_s(P_{t+1}^R)\right)$$

$$= V_t^g - F_t^g + \left(V_t^o \cdot R_s(P_t^R) - (V_t^o - F_t^o) \cdot R_s(P_{t+1}^R)\right)$$

(using Equation (2.9) to transform $V^o_{t+1}$ as an expression depending only on $t$).

Hence, one gets

$$V^g_{t+1} = V^g_t - F^g_t + \left( V^o_t \cdot \left( R_s(P^R_t) - R_s(P^R_{t+1}) \right) \right.$$
$$\left. + F^o_t \cdot R_s(P^R_{t+1}) \right) , \quad \forall t \in \mathbb{T} . \quad (2.12)$$

All the fluids are kept in the pores of the reservoir rocks. Let $V^p$ the total pore volume of the reservoir. As known from prior art, it is considered that the pore compressibility is stationary, hence the total pore volume follows:

$$\frac{V^p_{t+1} - V^p_t}{V^p_t} = c_f \left( P^R_{t+1} - P^R_t \right) , \quad \forall t \in \mathbb{T} . \quad (2.13)$$

The saturations of the fluids are the proportions of the available volume taken by each fluid in the reservoir. Let $S^o$, $S^g$ and $S^\omega$ the saturation of oil, free gas and water. In the reservoir, one has a conservation of the saturation of all the fluids. Indeed, one has:

$$S^o_t + S^g_t + S^w_t = 1 \quad \forall t \in \mathbb{T} , \quad (2.14)$$

rewritten as

$$V^o_t \times B_o(P^R_t) + V^g_t \times B_g(P^R_t) + V^w_t \times B_w(P^R_t) = V^p_t , \forall t \in \mathbb{T} . \quad (2.15)$$

**Reservoir dynamics**

The state of the reservoir is in the implementations defined as $x = (V^o, V^g, V^\omega, V^p, V^R)$. The controls $u_t$ considered are decisions made upon the production network, such as opening or closing a pipe, choosing the well-head or bottom hole pressure. Since the conservation laws in the reservoir are written with the production values, so the production function $\Phi$ is used to transform those controls in production values

$$\Phi(x, u) = (F^o, F^g, F^w) . \quad (2.16)$$

Thanks to Equations (2.9), (2.10), (2.12), (2.13), (2.15) and (2.16) one can define the dynamics $f$ on the state $x$ and controls $u$. Indeed, if one writes Equation (2.15) at time $t + 1$, and express those quantities as functions of the quantities at time $t$ thanks to Equations (2.9), (2.10), (2.12) and (2.13), one gets:

$$(V^o_t - F^o_t) \times B_o(P^R_{t+1}) + (V^w_t - F^w_t) \times B_w(P^R_{t+1})$$
$$+ \left[ V^g_t - F^g_t + V^o_t \times \left( R_s(P^R_t) - R_s(P^R_{t+1}) \right) \right.$$
$$\left. + F^o_t \times R_s(P^R_{t+1}) \right] \times B_g(P^R_{t+1})$$
$$= V^p_t \left( 1 + c_f(P^R_{t+1} - P^R_t) \right) . \quad (2.17)$$

According to prior art, the left-hand side of Equation (2.17) is decreasing with the new reservoir pressure $P^R_{t+1}$. The volume gained by the oil when the gas dissolves into oil due to an increase in pressure $\Delta P$ is lower than the aggregated decrease of volume of the free gas and the other fluids due to that same $\Delta P$. To the contrary, the right-hand side is increasing with the reservoir pressure. Hence, there is function $\Xi: \mathbb{X} \times \mathbb{U} \rightarrow \mathbb{R}^3$ such that $\forall t \in \mathbb{T}$,

$$P_{t+1}^R = \Xi(x_t, u_t)$$

When the PVT function $(B_o, B_g, B_o, R_s)$ are considered piecewise linear, the function $\Xi$ can be computed efficiently (according to algorithm 2 discussed below). Combining Equations (2.9), (2.10), (2.12), (2.13) and using function $\Xi$, the expression of function $f$ of Equation (2.3) follows.

---

**Algorithm 2:** Computing $\Xi$

**Input:** $V_t^o, V_t^g, V_t^w, F_t^g, F_t^o, P_t^R, V_t^p$

list_breaking_points_pressure $\leftarrow list(B_o, B_g, B_w, R_s)$;

for $P \in$ list_breaking_points_pressure do

$\qquad FluidsVolume = (V_t^o - F_t^o) \times B_o(P) + (V_t^w - F_t^w) \times B_w(P) + \left[V_t^g - F_t^g + V_t^o \times (R_s(P_t^R) - R_s(P)) + F_t^o \times R_s(P)\right] \times B_g(P)$;

$\qquad PoreVolume = V_t^p \left(1 + c_f(P - P_t^R)\right)$;

$\qquad$ if $FluidsVolume \geq PoreVolume$ then

$\qquad\qquad$ break;

$\qquad$ end

end

$\alpha_o, \alpha_g, \alpha_w, \alpha_{rs}, \beta_o, \beta_g, \beta_w, \beta_{rs} = linear\_coef\_segment(P)$;

$a = -V_t^o \beta_{rs} \beta_g$;

$b = \beta_o(V_t^o - F_t^o) + \beta_w(V_t^w - F_t^w) + \beta_g\left[V_t^g - F_t^g + (V_t^o + F_t^o)R_s(P_t^R) - V_t^o \beta_{rs}\right]$;

$c = (V_t^o - F_t^o)\alpha_o + (V_t^w - F_t^w)\alpha_w + \left[V_t^g - F_t^g + (V_t^o + F_t^o)R_s(P_t^R) - V_t^o \alpha_{rs}\right]\alpha_g - V_t^p(1 + c_f P^R)$;

$P_{t+1}^R = \frac{-b + \sqrt{4ac}}{2a}$;

---

**Material on state reduction**

It is now discussed how the general dynamics can be simplified in simpler cases.

**Gas reservoir state reduction**

It is here considered a gas reservoir where there is no water production. This is used for the first application previously-discussed. In the case of a gas reservoir with a constant amount of water, one can reduce the state to $x_t = (V_t^g)$. Considering Equation (2.13), since the pore compressibility and the temperature are considered constant, one has

$$\left(\frac{\partial V^p}{\partial P^R}\right)_T = c_f V^p . \qquad (2.18)$$

By integrating (2.18) along $P^R$, one can then express the total pore volume as a function of the pressure:

$$V^p = V_0 e^{(c_f P^R)} . \qquad (2.19)$$

Now the equation stating that the volume of fluids must be equal to the total pore volume (Equation (2.4)) can be rewritten:

$$V^w \times B_w \left( P_{t+1}^R \right) + \left[ V_t^g - F_t^g \right] \times B_g \left( P_{t+1}^R \right) = V_0 e^{\left( c_f P_{t+1}^R \right)} . \qquad (2.20)$$

The left-hand side of Equation (2.20) is a decreasing continuous piecewise linear function of the pressure (the volume of gas and the production being known) whereas the right-hand side is an increasing and continuous function of the pressure. This implies that there is a unique reservoir pressure which verifies Equation (2.20). Moreover, since the left-hand side is piecewise linear, one can compute the reservoir pressure thanks to the $\mathcal{W}$ Lambert function (the inverse relation of $f(w) = we^w$), and since pressure is positive, we use the $\mathcal{W}_0$ branch of the Lambert function. Finally, one obtains a mapping $\Psi$ such that

$$P^R = \Psi \left( V^g \right). \qquad (2.21)$$

$\Psi$ can be computed by adapting Algorithm 2, and using the $\mathcal{W}$ Lambert function instead of the root of a second order polynomial. Therefore, the state is reduced to $x_t = V_t^g$, which leads to the formulation (2.5).

**Oil reservoir with water injection state reduction**

It is now considered the case of an oil reservoir where water injection is used to keep the reservoir pressure constant. This is the focus of the application of the previously-discussed second application. In the case of an oil reservoir with water injection to keep the reservoir pressure constant, one can reduce the state to $x_t = \left( V_t^\omega \right)$. One can consider having two controls, the bottom-hole pressure $P_t$ and the water injection $F_t^{\omega i}$. However, the water injection will be constrained by the production, hence by the bottom-hole pressure, and thus will not be present as a control in the problem formulation. Since pressure is to be kept constant, one needs to re-inject enough water to replace the oil. Keeping the pressure constant means that the pore volume is constant. Moreover, it is considered that the reservoir pressure is higher than the bubble point pressure, which allow to consider that the amount of gas $V^g$ g is null. By using Equation (2.15) on time step $t$ and $t + 1$, one obtains:

$$\left( V_t^w - \underbrace{\left( \Phi^w(V_t^w, P_t) - F_t^{wi} \right)}_{F_t^w} \right) \times B_w \left( P^R \right) +$$

$$\left( V_t^o - \Phi^o(V_t^w, P_t) \right) \times B_o \left( P^R \right)$$

$$= V^p = V_t^w \times B_w \left( P^R \right) + V_t^o \times B_o \left( P^R \right) ,$$

which is simplified as:

$$\left( F_t^{wi} - \Phi^w(V_t^w, P_t) \right) \times B_w \left( P^R \right) = \Phi^o(V_t^w, P_t) \times B_o \left( P^R \right) . \qquad (2.22)$$

The constraint on the net water production can therefore be rewritten:

$$F_t^w = -\frac{F_t^o B_o}{B_w} \qquad (2.23)$$

$\Phi$ can now be expressed as a function of Darcy's law (Equation (2.8)) and using the water-cut function to obtain the total oil produced:

$$V_t^o = \alpha \frac{P^R - P_t}{B_o} \left(1 - w^{ct}\left(V_t^w\right)\right) \qquad (2.24)$$

By combining Equations (2.10), (2.23) and (2.24), one obtains the dynamics shown in Equation (2.7c).

**Details on the impact of the discretization**

**One tank gas reservoir.** In this application, different discretization values have been tried for the states and controls spaces. Results get better each time the number of states or controls used in the loops of Algorithm 1 is increased. The optimal values and CPU times are compiled in Table 2.6. Discretization of the control space has less impact than the discretization of the state space (there is no improvement using more than 10 possible controls). 50 possible controls are used for the rest of the analysis to ensure there is no issue due to the controls space. Moreover, the computation time grows linearly with the number of controls, hence one only gets penalized by a factor of 5 for the computation time compared to being at the most efficient level for the discretization of the controls. One can also remark that going beyond 10000 points for the state's discretization yields no discernible improvement (less than 0.2%). However, the computation time grows exponentially with the state discretization. Hence 10000 points for the states and 20 controls were used.

**Two tanks gas reservoir.** Tried different discretization values for the two reservoirs were tried: 200 × 200 (i.e. the two reservoirs are discretized with 200 points each), 400 × 400, 600 × 600 and 1000 × 1000. Results are summarized in Table 2.7, which shows the computation time of the optimization and the optimal value obtained. As can be seen, the computation time grows exponentially with the discretization, as one needs to compare more and more values when we get a finer discretization. However, performance remains reasonable for the number of time steps considered. One can also remark that going past a 200 × 200 discretization of the states of the reservoir does not improve the optimal value. A very small impact is observed from the discretization of the controls. Indeed, almost no improvement is obtained above 10 possible controls (we hence used 50 possible controls in Table 2.7 to ensure the discretization of the controls will not influence the analysis of the discretization of the state). All the results of §2.4.1.2 were therefore computed with the 400 × 400 discretization for the states, and 20 for the controls.

Table 2.6: Summary of the impact of the discretization of the state space on the one tank formulation, with 50 possible controls

| State discretization | Value (M€) | CPU time (s) |
|---|---|---|
| 100 | 602 | 1.25 |
| 200 | 689 | 1.45 |
| 500 | 725 | 2.5 |
| 1000 | 736 | 7.5 |
| 2000 | 740 | 25.2 |
| 5000 | 742 | 110 |
| 10000 | 743 | 653 |
| 20000 | 743 | 2288 |
| 50000 | 743 | 8142 |

Table 2.7: Impact of the discretization of the state space on the two tanks model, with 50 possible controls

| State discretization | CPU time (s) | Value (M€) |
|---|---|---|
| 50 × 50 | 5.1 | 730 |
| 100 × 100 | 28.3 | 735 |
| 200 × 200 | 115.3 | 736 |
| 4.00 × 400 | 706 | 736 |
| 600 × 600 | 3893 | 736 |
| 1000 × 1000 | 18089 | 736 |

**Oil reservoir with water injection.** Different values for the discretization of the state space of this problem were tried. However, the discretization of the controls had no impact, as the controls only took two different values: either no production, or production at the maximal rate. Therefore 10 possible controls were chosen to be sure to never miss another behavior during the analysis on the impact of the discretization of the states. Table 2.8 compiles the time to solve and the associated results of the optimization depending on the number of points considered for the discretization of the state space. It is to be noted that there is not a lot of gain from going from 10,000 discretization points to 100,000, whereas computation time grows by almost 100 times.

Table 2.8: Summary of the dynamic programming results for the oil reservoir with water injection

| Discretization | Time steps | CPU time (s) | Value (M€) |
| --- | --- | --- | --- |
| 1000 | 240 | 0.35 | 3182 |
| 10000 | 240 | 12.05 | 3358 |
| 100000 | 240 | 1575 | 3376 |

**Additional material on the decline curves formulation**

Usually, formulations using decline curves, as can be seen in the prior art, are of the form:

$$\max_{x,u} \ \sum_{t=0}^{\mathcal{T}} \rho^t \mathcal{L}_t(u_t) \qquad (2.25a)$$

$$s.t. \ F_t^o \leq g\left(\sum_{s=0}^{t-1} F_s^o\right) \ , \ \forall t \in \mathbb{T} \setminus \{0\} \ , \qquad (2.25b)$$

$$u_t \in \mathcal{U}_t^{ad}\left(\sum_{s=0}^{t-1} F_s^o\right) \ , \ \forall t \in \mathbb{T} \ . \qquad (2.25c)$$

Using decline curves, or oil deliverability curves, means using Equation (2.25b) to predict the reservoir's behavior. It states that the maximal rate at time t only depends on the cumulated production until time *t*. In the general case, there is no reason to believe that there is an equivalence between a material balance model for the reservoir and a decline curve represented with function *g*. However, when the state of the material balance formulation can be reduced to a one dimensional state (such as a reservoir which only contains gas), there can be an equivalence between the decline curve and the material balance formulations, as was stated in Proposition 3.

*Proof of Proposition 3.* Let us consider the component $\Phi^g \ : \ \mathbb{X} \times \mathbb{U} \to \mathbb{R}$ of the production function $\Phi$ such that:

$$F_t^g = \Phi^g(x_t, u_t) \ . \qquad (2.26)$$

Therefore, we have:

$$F_t^g \leq \max_u \Phi^g(x_t, u) \ . \qquad (2.27)$$

Moreover, having a one-dimensional state greatly simplifies the dynamics, as we only need to consider one fluid. The dynamics thus simplifies to:

$$x_{t+1} = f(x_t, u_t) = x_t - F_t^g \ . \qquad (2.28)$$

By propagating the simplified dynamics (2.28) and by re-injecting it in Equation (2.27), we get:

$$F_t^g \leq \underbrace{\max_u \Phi^g \left( x_0 - \sum_{s=0}^{t-1} F_s^g, u \right)}_{=g(\sum_{s=0}^{t-1} F_s^g)} . \qquad (2.29)$$

Hence, Equation (2.29) defines the function $g$. The equivalence exists when the state is reduced to one dimension (as similar reasoning can be applied to the other one-dimensional cases).

However, when there are more complex cases, such as a reservoir with both oil and gas, or when there is water encroachment (influx of water in the reservoir from the aquifer), one cannot have a reduction to a one-dimensional state. Decline curves, or oil deliverability curves, will not be equivalent to the material balance system, as they can only represent a one dimensional dynamical system, where the state is the cumulated production. If one has a state that cannot be reduced to one dimension, one can still propagate the dynamics in Equation (2.26):

$$F_t^g = \Phi^g(x_t, u_t)$$
$$= \Phi^g \left( f \left( f \left( \ldots f \left( x_0, u_0 \right), \ldots \right), u_{t-1} \right), u_t \right) .$$

However, there is no reason to believe that there exists a function g in the general case, contrarily to the one-dimensional case. This is why they are generated with a given production planning, *i.e.* a series of controls applied to the reservoir. Given a series of admissible controls

$$\tilde{\mathcal{U}} = \{ \tilde{u}_0, ..., \tilde{u}_T \}$$

one can create an oil-deliverability curve, that takes as argument the total cumulated production and returns the maximal possible production. It however depends on the underlying production planning $\tilde{\mathcal{U}}$ . One can create such function $\tilde{g}_{\tilde{u}}$

through the Algorithm 3 discussed below. Once one has a list of points of $\tilde{g}_{\tilde{u}}$ , one considers a linear interpolation between those points as the decline curve we use in the optimization problem (2.6). In prior art solutions, decline curves are used, *i.e.* oil-deliverability curves with natural depletion at the maximal rate. This means that there is no injection, and the production planning consists of maximal production rates. One can generate those decline curves with a tweaked version of the previous procedure (see Algorithm 4 below).

**Algorithm 3:** Finding the points of the piecewise linear function $\tilde{g}_{\tilde{\mathcal{U}}}$

$control\_to\_apply = \tilde{\mathcal{U}}$;
$current\_state = x_0$;
$cumulated\_production = 0$;
$max\_production = \max_u \Phi^g(current\_state, u)$;
$list\_of\_points = \{(cumulated\_production, max\_production)\}$;
**while** $control\_to\_apply$ $not$ $\emptyset$ **do**
$\quad | \quad \tilde{u} = pop(control\_to\_apply)$;
$\quad | \quad production = \Phi^g(current\_state, \tilde{u})$;
$\quad | \quad cumulated\_production = cumulated\_production + production$;
$\quad | \quad current\_state = f(current\_state, \tilde{u})$;
$\quad | \quad max\_production = \max_u \Phi^g(current\_state, u)$;
$\quad | \quad push(list\_of\_points, (cumulated\_production, max\_production))$;
**end**
**return** $list\_of\_points$

**Algorithm 4:** Finding the points of the piecewise linear function $g$

$current\_state = x_0$;
$cumulated\_production = 0$;
$max\_production = \max_u \Phi^g(current\_state, u)$;
$list\_of\_points = \{(cumulated\_production, max\_production)\}$;
**for** $t$ $from$ $1$ $to$ $\mathcal{T}$ **do**
$\quad | \quad \tilde{u} = \arg\max_{controls} \Phi^g(current\_state, u)$;
$\quad | \quad production = \Phi^g(current\_state, \tilde{u})$;
$\quad | \quad cumulated\_production = cumulated\_production + production$;
$\quad | \quad current\_state = f(current\_state, \tilde{u})$;
$\quad | \quad max\_production = \max_u \Phi^g(current\_state, u)$;
$\quad | \quad push(list\_of\_points, (cumulated\_production, max\_production))$;
**end**
**return** $list\_of\_points$

**Deterministic Partially Observed Markov Decision Process**

Mathematical tools and objects used when considering optimization of a controlled dynamical system under partial observation are now discussed: Partially Observed Markov Decision Process (POMDP). An extensive literature exists on POMDP, most of which focus on the infinite horizon case. Indeed, POMDP can be applied to numerous fields, from medical models to robotics. Algorithms based on Dynamic Programming were design to exploit specific structures in POMDP in order to solve this difficult class of problem. They do so by first reformulate the problem through the use of beliefs (distribution over the state space). One of such algorithms is SARSOP. However, POMDP is still a very difficult class of problem, and often un-tractable in the general case. Instead of focusing on the general POMDP, it is now presented a subclass that is relevant for the oil & gas case: det-POMDP. That subclass of problems is well-known. Moreover, implementations of the method manipulate an even simpler class that is tractable: mon-det-POMDP. Indeed, that new class of problems uses a property on the dynamics and observation to push back the curse of dimensionality.
The det-POMDP class of problems and the main complexity results in the case of finite horizon problems are now discussed. Then, the mon-detPOMDP class will be discussed, *i.e.* where some conditions are added on the dynamics of the system, which leads to improvement on the complexity bounds. Illustration of mon-detPOMDP with a toy problem will finally be discussed: emptying a bathtub when considering partial observations of the level of water.

**Det-POMDP**

det-POMDP stands for Deterministic Partially Observed Markov Decision Process, and corresponds to the subclass of POMDP where uncertainties are only present in the initial state of the system. That is, the transitions from one state to another are deterministic, as are the observations mappings that give the observations knowing the current state and the current control of the system.

Let $(\Omega, \mathcal{F}, \mathbb{P})$ be a probability space, where $\Omega$ is the set of possible outcomes, $\mathcal{F}$ is the associated $\sigma$-field and $\mathbb{P}$ is a probability measure. Let $\mathbb{T} = \{0, \dots, \mathcal{T}\}$ be the discrete time span, and it is defined upon it three processes $X = \{X_t\}_{t\in\mathbb{T}}$, $U = \{U_t\}_{t\in\mathbb{T}}$, and $O = \{O_t\}_{t\in\mathbb{T}}$. For all $t$, $X_t : \Omega \to \mathbb{X}$, $U_t : \Omega \to \mathbb{U}$, and $O_t : \Omega \to \mathbb{O}$ are random variables representing respectively the state, the controls and observation variables of the system at time $t$.

It is assumed that the state process $X$ follows the deterministic dynamics $f_t$, i.e.

$$L_{X_0} = \mu_0$$

$$X_{t+1} = f_t(X_t, U_t), \ \forall t \in \mathbb{T} \setminus \{\mathcal{T}\},$$

where $\mu_0$ is the (known) distribution of the initial state.

It is assumed that the observations are given by the deterministic observations functions $h_t$:

$$O_0 = h_0(X_0)$$

$$O_{t+1} = h_{t+1}(X_{t+1}, U_t), \ \forall t \in \mathbb{T} \setminus \{\mathcal{T}\},$$

It is assumed that for all time $t$, there is a set valued mapping $\mathcal{U}_t^{ad} : \mathbb{X} \to \mathbb{U}$ that defines the admissible controls given a state $x$. The controls must therefore verify:

$$U_t(\omega) \in \mathcal{U}_t^{ad}(X_t(\omega)), \ \forall \omega \in \Omega, \forall t \in \mathbb{T}.$$

The following more compact notation will be used:

$$U_t \in \mathcal{U}_t^{ad}(X_t) \text{ a.s. }, \ \forall t \in \mathbb{T}.$$

Moreover, the decision at time $t$ is taken knowing the history of controls and observation up to time $t$. Accordingly, the control $U_t$ is a function of the controls and observations up to time $t$, which means that $U_t$ has to be measurable with respect to the $\sigma$-field generated by $(O_0, \dots, O_t, U_0, \dots, U_t)$. This non-anticipativity constraint is written as:

$$\sigma(U_t) \subset \sigma(O_0, \dots, O_t, U_0, \dots, U_{t-1}), \ \forall t \in \mathbb{T}.$$

Finally, the cost incurred at each time $t \in \mathbb{T} \setminus \{\mathcal{T}\}$ is given by the function of the state and controls $\mathcal{L}_t$, while the final cost (the cost at time $\mathcal{T}$) is given by the function of the final state $\mathcal{K}$. As the implementations optimize over random variables, it is considered that one optimizes over an additive cost function: the expected value of the sum of instantaneous costs over the time set $\mathbb{T}$ and the final cost:

$$\mathbb{E}\left[\sum_{t=0}^{\mathcal{T}-1} \mathcal{L}_t(X_t, U_t) + \mathcal{K}(X_\mathcal{T})\right] .$$

The formulation of a finite-horizon det-POMDP is hence

$$\mathcal{V}^*(\mu_0) = \min_{\boldsymbol{X}, \boldsymbol{O}, \boldsymbol{U}} \mathbb{E}\left[\sum_{t=0}^{\mathcal{T}-1} \mathcal{L}_t(X_t, U_t) + \mathcal{K}(X_\mathcal{T})\right] \tag{3.1a}$$

$$s.t. \quad L_{\boldsymbol{X}_0} = \mu_0 \tag{3.1b}$$

$$X_{t+1} = f_t(X_t, U_t) , \quad \forall t \in \mathbb{T} \setminus \{\mathcal{T}\} , \tag{3.1c}$$

$$O_0 = h_0(X_0) \tag{3.1d}$$

$$O_{t+1} = h_{t+1}(X_{t+1}, U_t) , \quad \forall t \in \mathbb{T} \setminus \{\mathcal{T}\} , \tag{3.1e}$$

$$U_t \in \mathcal{U}_t^{ad}(X_t) \text{ a.s. }, \quad \forall t \in \mathbb{T} \tag{3.1f}$$

$$\sigma(U_t) \subset \sigma(O_0, \ldots, O_t, U_0, \ldots, U_{t-1}) , \quad \forall t \in \mathbb{T} , \tag{3.1g}$$

To summarize, a det-POMDP is a POMDP with the following characteristics:

- there is no exogenous uncertainties for the dynamics *f* and observation functions *h*,
- the only uncertainty is on the initial state $x_0$ of the dynamic system.

**Some recalls on det-POMDP**

In this paragraph, some results on det-POMDP are discussed. They can be found in the literature. First, det-POMDP are POMDP. This means that all the results and numerical methods that apply to POMDP can be carried over to det-POMDP. Notably, a Dynamic Programming equation can be written on det-POMDP. Moreover, one can derive some complexity results by exploiting the fact that state dynamics and observations mappings are "deterministic". One derives bounds on the cardinality of reachable spaces, which leads to bounds on the number of operations needed to solve the Problem (3.1).

For any distribution $\mu \in \Delta(\mathbb{X})$, where $\Delta(\mathbb{X})$ is the set of probability distribution over the state space $\mathbb{X}$, let $\text{supp}(\mu) \subset \mathbb{X}$ be the support of the distribution $\mu$:

$$\text{supp}(\mu) = \{x \in \mathbb{X} \,|\, \mu(x) > 0\} .$$

**Solving det-POMDP.** The usual way to solve a POMDP consists in reformulating the problem, and use a new state, the beliefs. The whole process is known in the literature]. In the case of det-POMDP, the following result is known from the literature:

**Proposition 4** *Let* $\mathbb{B} = \Delta(\mathbb{X}) \cup \{0\}$ , *let* $b_0 \in \mathbb{B}$ *be the distribution of $X_0$, the Unitas state of Problem* (3.1) *and consider the sequence of value functions* $(V_t)_{t \in T}$ *defined by the following backward induction:*

$$V_T : \mathbb{B} \to \mathbb{R} , \quad b \mapsto \sum_{x \in \mathbb{X}} b(x) \mathcal{K}(x) \tag{3.2}$$

$$V_t : \mathbb{B} \to \overline{\mathbb{R}} , \quad b \mapsto \min_{u \in \mathcal{U}_t^b(b)} \left( \mathcal{C}_t(b, u) + \sum_{o \in \mathbb{O}} Q_{t+1}(b, u, o) V_{t+1}\big(\tau_t(b, u, o)\big) \right) , \tag{3.3}$$

*where for all t, the mappings* $\tau_t : \mathbb{B} \times \mathbb{U} \times \mathbb{O} \to \mathbb{B}$ , $Q_t : \mathbb{B} \times \mathbb{U} \times \mathbb{O} \to [0, 1]$ *and* $\mathcal{C}_t : \mathbb{B} \times \mathbb{U} \to \overline{\mathbb{R}}$ *are given by*

$$\tau_t(b, u, o)(y) = \begin{cases} \dfrac{\sum\limits_{x \in (f_t^u)^{-1}(\{y\})} b(x)}{\sum\limits_{x \in \mathbb{T}_{u,o}^t} b(x)} & if \quad y \in \Gamma_{u,o}^{t+1} \ and \ \mathrm{supp}(b) \cap \mathbb{T}_{u,o}^t \neq \emptyset , \\ 0 & otherwise , \end{cases} \tag{3.4}$$

$$Q_{t+1}(b, u, o) = \begin{cases} \sum\limits_{x \in \mathbb{T}_{u,o}^t} b(x) \ if \ \mathbb{T}_{u,o}^t \neq \emptyset \\ 0 \ otherwise \end{cases} , \tag{3.5}$$

$$\mathcal{C}_t(b, u) = \sum_{x \in \mathbb{X}} b(x) \mathcal{L}_t(x, u) , \tag{3.6}$$

*with* $\Gamma_{u,o}^{t+1} = \Big\{ y \in \mathbb{X} \,\Big|\, \exists x \in \mathbb{X}, f_t(x, u) = y \ and \ h_{t+1}(y, u) = o \Big\}$, $h_t^u(\cdot) := h_t(\cdot, u), f_t^u(\cdot) := f_t(\cdot, u),$ $\mathbb{T}_{u,o}^t = \Big\{ x \in (h_{t+1}^u \circ f_t^u)^{-1}(\{o\}) \Big\}$ *and* $\mathcal{U}_t^b(b) = \bigcap_{\{x \in \mathrm{supp}(b)\}} \mathcal{U}_t^{ad}(x).$

*Then,* $\mathcal{V}^* = V_0(\mu_0)$ *i.e. the optimal value of Problem (3.1) and the value of the mapping $V_0$ at the initial belief* $b_0 = \mu_0$ *are equal.*

*Moreover, a policy* $\pi = (\pi_0, \dots \pi_{\tau-1})$ *(a set of mappings* $\pi_t : \mathbb{B} \to \mathbb{U}$ *) which minimizes the right-hand side of Equation (3.3) for each b and t is an optimal policy of Problem (3.1): the controls given by $U_t = \pi_t(B_t)$ (where $B_t$ is computed thanks to the recursion $B_{t+1} = \tau_t(B_t, U_t, O_{t+1})$, with $B_0 = \mu_0$) are optimal controls of Problem (3.1).*

**Remark 5**. *It is possible that, when considering a given belief b, control u and observation o, we have $\tau_t(b, u, o) = 0$, i.e. there is no successor of belief b such that it is possible to observe o after applying control u. This is why $\omega$e consider that the backspace is* $\mathbb{B} = \Delta(\mathbb{X}) \cup \{0\}$ *to cover that case.*

*Moreover, we consider that $\forall t$, $V_t(0) = +\infty$ to represent the value of an impossible belief*

*Finally, when we obtain $\tau_t(b, u, o) = 0$, we also have that $Q_{t+1}(b, u, o) = 0$. Indeed, $Q_{t+1}(b, u, o)$ represent the probability of observing o at time t + 1 when applying controls u while holding the belief b. By convention, we assume that multiplying a probability of 0 with $+\infty$ is equal to 0. Hence, when multiplying $Q_{t+1}$ by the value function $V_{t+1} \circ \tau_t$ always lead to a finite value. The right-hand side of Equation (3.3) is thus well-defined.*

**Remark 6.** *Equation (3.4) is well-defined. The issue would be a division by 0 if*

$$\sum_{x \in \mathrm{T}_{u,o}^t} b(x) = 0.$$

However, if $y \in \Gamma_{u,o}^{t+1}$ then

$$\mathrm{T}_{u,o}^t \neq \emptyset.$$

The condition thus prevent a sum on, an empty set.

Moreover, if

$$\mathrm{supp}(b) \cap \mathrm{T}_{u,o}^t \neq \emptyset,$$

then the sum is strictly positive. The condition $y \in \Gamma_{u,o}^{t+1}$ and

$$\mathrm{supp}(b) \cap \mathrm{T}_{u,o}^t \neq \emptyset$$

thus prevent a division by 0.

A proof of proposition 4 is discussed hereinafter and extends the known results (discussed in Dimitri P. Bertsekas. Dynamic Programming and Optimal Control, volume I. Athena Scientific, Belmont, MA, USA, 4th edition, 2017. ISBN 9781886529434, which is incorporated herein by reference), which are under the hypothesis that the admissibility set at time $t$ does not depend on the state at time $t$, to the case where the admissibility set depends on the state.

It is still possible to transform the formulation of Problem (3.1) in order to remove the constraint (3.1f) by modifying the cost function. Indeed, let $\overline{\mathcal{L}}_t$ be a modified cost such that $\overline{\mathcal{L}}_t(X_t, U_t) = \mathcal{L}_t(X_t, U_t) + \chi_{\mathcal{U}_t^{ad}(X_t)}(U_t)$. $\chi_{\mathcal{U}_t^{ad}(x)}$ represent, the characteristic function over the admissibility set:

$$\chi_{\mathcal{U}_t^{ad}(x)}(u) = \begin{cases} 0 \text{ if } u \in \mathcal{U}_t^{ad}(x) \\ +\infty \text{ otherwise} \end{cases}$$

Applying a control $u$ that does not belong to the admissibility set $\mathcal{U}_t^{ad}(x)$ will therefore lead to a cost of $+\infty$. Since Problem (3.1) is a minimization problem, any solution with finite value when considering cost functions $\overline{\mathcal{L}}_t$ will therefore satisfy constraint (3.1f).

When using $\overline{\mathcal{L}}_t$, we therefore obtain the following Bellman value functions:

$$\overline{V}_{\mathcal{T}} : \mathbb{B} \to \mathbb{R}, \quad b \mapsto \sum_{x \in \mathbf{X}} b(x)\mathcal{K}(x) \tag{3.7}$$

$$\overline{V}_t : \mathbb{B} \to \overline{\mathbb{R}}, \quad b \mapsto \min_{u \in \mathbf{U}} \left( \overline{C}_t(b,u) + \sum_{o \in \mathbf{O}} Q_{t+1}(b,u,o)\overline{V}_{t+1}\big(\tau_t(b,u,o)\big) \right), \tag{3.8}$$

where $\overline{C}_t(b, u) = \sum_{x \in X} b(x)\overline{\mathcal{L}}_t(x, u)$ . We also assume that if $b(x) = 0$, then $\forall u \in \mathbb{U}$ , $b(x)\overline{\mathcal{L}}_t(x, u) = 0$ .

A proof that the optimal solutions when considering costs $\overline{\mathcal{L}}$ are also optimal solutions of problem 3.1, and leads to the value functions defined in equations (3.2)-(3.3). For the sake of clarity, let $\overline{F}_{t+1}$ be defined by

$$\overline{F}_{t+1} : (b, u, o) \mapsto Q_{t+1}(b, u, o)\overline{V}_{t+1}\big(\tau_t(b, u, o)\big).$$

$$\min_{u \in \mathbb{U}} \left( \overline{C}_t(b, u) + \sum_{o \in O} \overline{F}_{t+1}(b, u, o) \right) = \min_{u \in \mathbb{U}} \left( \sum_{x \in X} b(x)\overline{\mathcal{L}}_t(x, u) + \sum_{o \in O} \overline{F}_{t+1}(b, u, o) \right)$$

$$= \min_{u \in \mathbb{U}} \left( \sum_{x \in X} b(x)\Big[\mathcal{L}_t(x, u) + \chi_{\mathcal{U}_t^{ad(x)}}(u)\Big] + \sum_{o \in O} \overline{F}_{t+1}(b, u, o) \right)$$

$$= \min_{u \in \mathbb{U}} \left( \chi_{\bigcap_{\{x \in supp(b)\}} \mathcal{U}_t^{ad}(x)}(u) + \sum_{x \in X} b(x)\mathcal{L}_t(x, u) + \sum_{o \in O} \overline{F}_{t+1}(b, u, o) \right)$$

$$= \min_{u \in \mathbb{U}} \left( \chi_{\mathcal{U}_t^b(b)}(u) + \sum_{x \in X} b(x)\mathcal{L}_t(x, u) + \sum_{o \in O} \overline{F}_{t+1}(b, u, o) \right)$$

$$= \min_{u \in \mathcal{U}_t^b(b)} \left( \sum_{x \in X} b(x)\mathcal{L}_t(x, u) + \sum_{o \in O} \overline{F}_{t+1}(b, u, o) \right)$$

Therefore:

$$\overline{V}_{t+1} = \min_{u \in \mathbb{U}} \left( \overline{C}_t(b, u) + \sum_{o \in O} Q_{t+1}(b, u, o)\overline{V}_{t+1}\big(\tau_t(b, u, o)\big) \right) =$$

$$\min_{u \in \mathcal{U}_t^b(b)} \left( C_t(b, u) + \sum_{o \in O} Q_{t+1}(b, u, o)\overline{V}_{t+1}\big(\tau_t(b, u, o)\big) \right)$$

As $V_\tau = V_\tau$, then $\forall t \in \mathbb{T}$ , $\overline{V}_t = V_t$ by backward induction. Moreover, the controls $u$ that minimize the right-hand side of Equation (3.8) also minimize the right-hand side of Equation (3.3).

A direct consequence of Dynamic Programming is that, in order to solve Problem (3.1), we only need to compute the Bellman functions $V_t$ for all the beliefs reachable at time t when starting from $b_0$. The sets of reachable beliefs are hence formally defined before presenting some bounds on the size of those sets:

**Definition 7.** *Let* $b_0 \in \mathbb{B}_0$ *be given. Then, for any* $t \in \mathbb{T}$ *, we define,* $\mathbb{B}_t^R(b_0) \subset \mathbb{B}_t$ *, the set of reachable beliefs a time t starting from initial belief $b_0$ by the following induction.*

$$\mathbb{B}_0^R(b_0) = \{b_0\} \quad and \quad \mathbb{B}_{t+1}^R(b_0) = \tau_t(\mathbb{B}_t^R(b_0), \mathbb{U}_d, \mathbb{O}_d) \quad \forall t \in \mathbb{T}\backslash\mathcal{T} .$$

We have the theorem:
**Theorem 8.** *The cardinal of the reachable state space is bounded:*

$$\forall b_0 \in \Delta(\mathbb{X}), \forall t' \geq 0, \left| \bigcup_{t=0}^{t'} \mathbb{B}_t^R(b_0) \right| \leq (1 + |\mathbb{X}|)^{|supp(b_0)|} .$$

**Preliminaries.**

- Given $(\Omega, \mathcal{F}, \mathbb{P})$ a probability space, two finite sets $A$ and $B$, and a measurable mapping $g : A \to B$, the push forward (or image measure) of a distribution $\mu$ on $A$ by $g$ is the distribution $g, \mu$ on $B$ defined by

$$\forall b \in B , \quad g_{\star}\mu(b) = \sum_{a \in g^{-1}(b)} \mu(a) \qquad (3.9)$$

- Let two finite sets $\mathbb{Y}$ and $\mathbb{Z}$ be given and consider a family $T$ of mappings from $\mathbb{Y}$ to $\mathbb{Z}$. Then, for any probability distribution, $\mu$ over $\mathbb{Y}$ we have that

$$\left| \{ \mathcal{T}_{\star}\mu \, | \, \mathcal{T} \in T \} \right| \leq |\mathbb{Z}|^{|\mathrm{supp}(\mu)|} .$$

Indeed, let $\mu \in \Delta(\mathbb{Y})$ be given. For any

$$\mathcal{T} \in T$$

we denote by

$$\mathcal{T}_{|\mathrm{supp}(\mu)}$$

the restriction of the mapping $\mathcal{T}$ to the subset $\mathrm{supp}(\mu) \subset \mathbb{Y}$. For all $z \in \mathbb{Z}$ we have that

$$\begin{aligned}
\mathcal{T}_{\star}\mu(z) &= \mu\big(\mathcal{T}^{-1}(z)\big) = \mu\Big(\big(\mathcal{T}^{-1}(z) \cap \mathrm{supp}(\mu)\big) \cup \big(\mathcal{T}^{-1}(z) \cap (\mathrm{supp}(\mu))^c\big)\Big) \\
&= \mu\big(\mathcal{T}^{-1}(z) \cap \mathrm{supp}(\mu)\big) + \underbrace{\mu\big(\mathcal{T}^{-1}(z) \cap (\mathrm{supp}(\mu))^c\big)}_{=0} \\
&= \mu\big(\mathcal{T}^{-1}_{|\mathrm{supp}(\mu)}(z)\big) \\
&= \big(\mathcal{T}_{|\mathrm{supp}(\mu)}\big)_{\star}\mu(z) .
\end{aligned}$$

Thus, considering

$$T_{\mathrm{supp}(\mu)} = \{ \mathcal{T}_{|\mathrm{supp}(\mu)} \, | \, \mathcal{T} \in T \},$$

we have that

$$\left| \{ \mathcal{T}_{\star}\mu \, | \, \mathcal{T} \in T \} \right| = \left| \{ (\mathcal{T}_{|\mathrm{supp}(\mu)})_{\star}\mu \, | \, \mathcal{T} \in T \} \right| \leq |T_{\mathrm{supp}(\mu)}| \leq |\mathbb{Z}^{\mathrm{supp}(\mu)}| = |\mathbb{Z}|^{|\mathrm{supp}(\mu)|} .$$

A sketch of proof of Theorem 8 is now discussed. Using the fact that state dynamics is deterministic one obtains that a reachable belief at time $t$ is given as a push forward of the initial belief through a mapping which goes from $\mathbb{X}$ to

an augmented set $\overline{\mathbb{X}} = \mathbb{X} \cup \{\delta\}$. $\delta$ is an extra point added to $\mathbb{X}$, the cemetery point, which is used to represent the evolution of the system toward a point which is incompatible with the observations or controls applied. The number of reachable beliefs at time $t$ is therefore bounded by the cardinality of $\overline{\mathbb{X}}^{\mathbb{X}}$, the set of mappings which goes from $\mathbb{X}$ to $\overline{\mathbb{X}} = \mathbb{X} \cup \{\delta\}$.

*Proof.* Now, we give the details of the proof of Theorem 8. We consider an extended state space $\overline{\mathbb{X}} = \mathbb{X} \cup \{\delta\}$ and a self-map on $\overline{\mathbb{X}}$ given as follows

$$\mathcal{T}_{u,o}^{t} : \overline{\mathbb{X}} \to \overline{\mathbb{X}}, \quad \overline{x} \mapsto \begin{cases} f_t(\overline{x}, u) & \text{if} \quad \overline{x} \in \Theta_{u,o}^{t}, \\ \delta & \text{if} \quad \overline{x} \notin \Theta_{u,o}^{t}, \end{cases} \tag{3.10}$$

with $\Theta_{u,o}^{t} = \left\{ \overline{x} \in \mathbb{X} \,\middle|\, \left( h_{t+1}(f_t(\overline{x}, u), u) = o \right) \wedge \left( u \in \mathcal{U}_t^{ad}(\pi(\overline{x}, \mathbb{X})) \right) \right\}$ (here, $\pi(\overline{x}, \mathbb{X})$ is the projection of $\overline{x}$ on $\mathbb{X}$).

We consider a renormalization map $\mathcal{R} : \Delta(\overline{\mathbb{X}}) \to \Delta(\mathbb{X}) \cup \{0\}$ defined by

$$\forall x \in \mathbb{X}, \quad \mathcal{R}(\overline{b})(x) = \begin{cases} 0 & \text{if} \quad \overline{b}(\delta) = 1, \\ \frac{\overline{b}(x)}{1 - \overline{b}(\delta)} & \text{if} \quad \overline{b}(\delta) \neq 1. \end{cases} \tag{3.11}$$

and the extension mapping $\mathcal{E} : \Delta(\mathbb{X}) \to \Delta(\overline{\mathbb{X}})$ defined as follows:

$$\mathcal{E} : \Delta(\mathbb{X}) \to \Delta(\overline{\mathbb{X}}), b \mapsto \overline{b} \text{ such that } \begin{cases} \overline{b}(x) = b(x) & \forall x \in \mathbb{X} \\ \overline{b}(\delta) = 0 \end{cases}. \tag{3.12}$$

We have the following result. For any $u$ and $o$

$$\tau_t(b, u, o) = \mathcal{R}\left( (\mathcal{T}_{u,o}^{t})_* \mathcal{E}(b) \right) \tag{3.13}$$

That is, up to renormalization and extension $\tau_t(b,u,o)$ is the push forward of the belief $b$ by the mapping

$$\mathcal{T}_{u,o}^{t}.$$

Moreover, if we extend the previous notation $\mathcal{T}$ to a sequence of controls $u_{t:t'} \in \mathbb{U}^{t'-t}$ and a sequence of observations $o_{t+1:t'+1} \in \mathbb{O}^{t'-t}$, i.e.:

$$\mathcal{T}_{u_{t:t'}, o_{t+1:t'+1}}^{t:t'} = \mathcal{T}_{u_{t'}, o_{t'+1}}^{t'} \circ \cdots \circ \mathcal{T}_{u_t, o_{t+1}}^{t} \tag{3.14}$$

A reachable belief $b \in \mathbb{B}_t^{\mathrm{R}}(b_0)$, $t > 0$, is thus an element of $\Delta(\mathbb{X})$ such that there exists $u_{0:t-1}$, $o_{1:t}$ which verify

$$b = \mathcal{R}\left(\left(\mathcal{T}^{0:t-1}_{u_{0:t-1},o_{1:t}}\right)_{\star}\mathcal{E}(b_0)\right).$$

Moreover, we have

$$\mathcal{R}\left(\left(\mathcal{T}^{0:t-1}_{u_{0:t-1},o_{1:t}}\right)_{\star}\mathcal{E}\right) \in \mathcal{R}\left(\mathbb{X}^{\mathbb{X}}\right).$$

Using the preliminary, with $\mathbb{Y} = \mathbb{X}$ and $b_0 = \mu$, we hence get that for all $b_0$ in $\Delta(\mathbb{X})$ and for all $t \geq 0$

$$\left|\bigcup_{s=0}^{t} \mathbb{B}^{R}_{s}(b_0)\right| \leq (1 + |\mathbb{X}|)^{|\mathrm{supp}(b_0)|}.$$

**Remark 9.** *Theorem 8 is an improvement of the bound*

$$\forall b_0 \in \Delta(\mathbb{X}), \quad \left|\bigcup_{t=0}^{\infty} \mathbb{B}^{R}_{t}(b_0)\right| \leq (1 + |\mathbb{X}|)^{|\mathbb{X}|}$$

**Proposition 10** *The cardinality of the support of belief decreases when applying the mapping $\tau_t$. More precisely, we have*

$$\forall t \in \mathbb{T}, \quad \forall b \in \mathbb{B}, \quad \forall u \in \mathbb{U}, \quad \sum_{o \in \mathbb{O}} \left|\mathrm{supp}\left(\tau_t(b,u,o)\right)\right| \leq \left|\mathrm{supp}(b)\right|. \qquad (3.15)$$

*We therefore have that*

$$\forall t \in \mathbb{T}, \quad \forall b \in \mathbb{B}, \quad \forall b' \in \tau_t(b,\mathbb{U},\mathbb{O}), \quad \left|\mathrm{supp}(b')\right| \leq \left|\mathrm{supp}(b)\right|. \qquad (3.16)$$

*Proof.* Let $u \in \mathbb{U}$ and $o \in \mathbb{O}$ be given. As a preliminary fact, we note, using the definition of $\Gamma^{t+1}_{u,o}$ given in Proposition 4, that $\Gamma^{t+1}_{u,o'} \cap \Gamma^{t+1}_{u,o''} = \emptyset$ when $o' \neq o''$ as otherwise there would exist $y \in \mathbb{X}$ such that $h_{t+1}(y,u) = o'$ and $h_{t+1}(y, u) = o''$ which is not possible.

Now, given $y \in \mathbb{X}$ and using the definition of $\tau_t$ in Equation (3.4), we obtain that $\tau_t(b, u, o)(y) \neq 0$ implies that $y$ must be in $\Gamma^{t+1}_{u,o}$ and that there must exist $x \in (f^u_t)^{-1}(\{y\})$ such that $b(x) \neq 0$ which gives

$$\mathrm{supp}\left(\tau_t(b,u,o)\right) \subset \left\{y \in \mathbb{X} \,\middle|\, y \in \Gamma^{t+1}_{u,o} \text{ and } (f^u_t)^{-1}(\{y\}) \cap \mathrm{supp}(b) \neq \emptyset\right\}. \qquad (3.17)$$

Then, we successively have that

$$\bigcup_{o\in\mathbb{O}} \mathrm{supp}\big(\tau(b,u,o)\big) \subset \bigsqcup_{o\in\mathbb{O}} \Big\{ y\in\mathbb{X}\,\Big|\, y\in\Gamma_{u,o}^{t+1} \text{ and } (f_t^u)^{-1}(\{y\})\cap\mathrm{supp}(b)\neq\emptyset \Big\}$$

$$\subset \Big\{ y\in\mathbb{X}\,\Big|\,(f_t^u)^{-1}(\{y\})\cap\mathrm{supp}(b)\neq\emptyset \Big\}$$

$$\subset f\big(\mathrm{supp}(b),u\big)\,. \tag{3.18}$$

Using the last inclusion in Equation (3.18), and the fact that the left-hand side of the inclusion is a union composed of disjoints sets (as given by the preliminary fact) we obtain that

$$\sum_{o\in\mathbb{O}} \big|\mathrm{supp}\big(\tau(b,u,o)\big)\big| \leq \big|f\big(\mathrm{supp}(b),u\big)\big| \leq \big|\mathrm{supp}(b)\big|\,, \tag{3.19}$$

which gives Equation (3.15). Then, Equation (3.16) easily follows. Let $u\in\mathbb{U}$ and let $o\in\mathbb{O}$. We have

$$\big|\mathrm{supp}\big(\tau(b,u,o)\big)\big| \leq \sum_{o'\in\mathbb{O}} \big|\mathrm{supp}\big(\tau(b,u,o')\big)\big| \leq \big|\mathrm{supp}(b)\big|\,. \tag{3.20}$$

We hence get Equation (3.16).

Theorem 8 and Proposition 10 yield the following Lemma:

**Lemma 11.** *We have the following bounds on the union on the sets of reachable beliefs for det-POMDP:*

$$\Big|\bigcup_{t=0}^{\mathcal{T}} \mathbb{B}_t^{\mathrm{R}}(b_0)\Big| \leq \min\Big( (1+|\mathbb{X}|)^{|\mathrm{supp}(b_0)|}, |\mathrm{supp}(b_0)|\,|\mathbb{U}|^{\mathcal{T}+1}\Big)\,. \tag{3.21}$$

*Proof.* Using Theorem 8, we have

$$\Big|\bigcup_{t=0}^{\mathcal{T}} \mathbb{B}_t^{\mathrm{R}}(b_0)\Big| \leq (1+|\mathbb{X}|)^{|\mathrm{supp}(b_0)|}\,.$$

The second bound can be obtained by recurrence thanks to Proposition 10. Let us consider the set of attainable beliefs when one applies a sequence of controls $u_{0:t-1}$ when starting in belief $b_0$, which we denote by $B_{u_{0:t-1}}^+(b_0)$:

$$B_{u_{0:t-1}}^+(b_0) = \Big\{ b\in\mathbb{B}\,|\,\exists o_{1:t}\in\mathbb{O}^t, b = \mathcal{R}\Big( \big(\mathcal{T}_{u_{0:t-1},o_{1:t}}^{0:t-1}\big)_\star \mathcal{E}(b_0)\Big)\neq 0\Big\}\,.$$

Using Equation (3.15), we have:

$$\sum_{b\in B_u^+(b_0)} \big|\mathrm{supp}(b)\big| \leq \big|\mathrm{supp}(b_0)\big|\,,$$

and:

$$\sum_{b\in B^+_{u_{0:t}}(b_0)} |\mathrm{supp}(b)| \leq \sum_{b'\in B^+_{u_{0:t-1}}(b_0)} \sum_{b\in\tau_t(b',u_t,\mathbf{O}_d)} |\mathrm{supp}(b)|$$

$$\leq \sum_{b'\in B^+_{u_{0:t-1}}(b_0)} |\mathrm{supp}(b')| . \qquad (\text{using Equation (3.15)})$$

By induction, we thus have $\sum_{b\in B^+_{u_{0:t}}(b_0)} |\mathrm{supp}(b)| \leq |\mathrm{supp}(b_0)|$ .

Moreover, since $\forall b \in B^+_{u_{0:t}}(b_0)$ $|\mathrm{supp}(b)| \geq 1$ (as $0 \notin B^+_{u_{0:t}}(b_0)$ ), we have

$$|B^+_{u_{0:t}}(b_0)| \leq \sum_{b\in B^+_{u_{0:t}}(b_0)} |\mathrm{supp}(b)| .$$

Therefore

$$\forall u_{0:t} \in \mathbb{U}^{t+1}, |B^+_{u_{0:t}}(b_0)| \leq |\mathrm{supp}(b_0)| .$$

Hence, we have:

$$|\mathbb{B}^R_t(b_0)| = \Big| \bigcup_{u_{0:t-1}\in\mathbb{U}^t} B^+_{u_{0:t-1}}(b_0) \Big|$$

$$\leq \sum_{u_{0:t-1}\in\mathbb{U}^t} |B^+_{u_{0:t-1}}(b_0)|$$

$$\leq \sum_{u_{0:t-1}\in\mathbb{U}^t} |\mathrm{supp}(b_0)|$$

$$= |\mathrm{supp}(b_0)||\mathbb{U}|^t .$$

Looking at the union of the reachable beliefs gives us:

$$\Big| \bigcup_{t=0}^{\mathcal{T}} \mathbb{B}^R_t(b_0) \Big| \leq \sum_{t=0}^{\mathcal{T}} |\mathbb{B}^R_t(b_0)|$$

$$\leq \sum_{t=0}^{\mathcal{T}} |\mathrm{supp}(b_0)||\mathbb{U}|^t$$

$$\leq |\mathrm{supp}(b_0)|\frac{|\mathbb{U}|^{\mathcal{T}+1}-1}{|\mathbb{U}|-1}$$

$$\leq |\mathrm{supp}(b_0)||\mathbb{U}|^{\mathcal{T}+1} .$$

As we have

$$\Big| \bigcup_{t=0}^{\mathcal{T}} \mathbb{B}^R_t(b_0) \Big| \leq |\mathrm{supp}(b_0)||\mathbb{U}|^{\mathcal{T}+1}$$

and

$$\left| \bigcup_{t=0}^{T} \right| \le (1 + |\mathbb{X}|)^{|\mathbb{X}|} |$$

which leads to Equation (3.21).

**Det-POMDP with monotonicity (mon-det-POMDP)**

It is now discussed a sub-class of det-POMDP: mon-det-POMDP, which may also be referred to as "Well Separated det-POMDP".

**Definition of mon-det-POMDP**

**Definition 12.** *Let T be a finite set of self-map of* $\mathbb{X}$ *which satisfy the following property. For any given pair* ($\mathcal{T}'$, $\mathcal{T}''$) *in* $T^2$, *if there exists* $x \in \mathbb{X}$ *such that* $\mathcal{T}'(x) = \mathcal{T}''(x)$, *then we must have for all* $x' \in \mathbb{X}$ *one of the three following possibilities:*

$$\mathcal{T}'(x') = \mathcal{T}''(x') \quad or \quad \mathcal{T}'(x') = \delta \quad or \quad \mathcal{T}''(x') = \delta . \qquad (3.22)$$

*A set T satisfying the just described property is called a Monotonous Function Set. Moreover, a det-POMDP such which is such that the set of functions defined in Equations* (3.10) *and* (3.14) *is a Monotonous Function Set is called a mon-det-POMDP.*

The property can also be stated as follows. Suppose that there exists $x \in$

$$\mathcal{T}_1^{-1}(\mathbb{X}) \cap \mathcal{T}_2^{-1}(\mathbb{X})$$

such that

$$\mathcal{T}_1(x) = \mathcal{T}_2(x)$$

then $\mathcal{T}_1$ and $\mathcal{T}_2$ coincide on the set

$$\mathcal{T}_1^{-1}(\mathbb{X}) \cap \mathcal{T}_2^{-1}(\mathbb{X}).$$

Otherwise stated for mon-det-POMDP, if two sequences of controls leads to the same state when starting in state *x*, then applying the two sequences of controls to another state *x'* either leads to the same state, or one sequences leads to the cemetery point. This main property is illustrated on FIG. 12, where the arrows represent two different sequences of controls $u_{1:t}$, $u'_{1:t}$ with their associated sequences of observations $o_{1:t}$, $o'_{1:t}$ such that

$$\mathcal{T}_{u_{1:t}o_{1:t}}\left(x_{0,1}\right) = \mathcal{T}_{u'_{1:t}o'_{1:t}}\left(x_{0,1}\right).$$

This leads to

$$\mathcal{T}_{u_{1:t}o_{1:t}}\left(x_{0,2}\right) = \mathcal{T}_{u'_{1:t}o'_{1:t}}\left(x_{0,2}\right)$$

whereas

$$\mathcal{T}_{u'_{1:t} o'_{1:t}}\left(x_{0,3}\right) = \delta$$

as $h(f\left(x_{0,3}, u'_{1:t}\right)) \neq o'_{t'}$ .

Proposition. 13. *The cardinality of the reachable belief space of a mon-det-POMDP is bounded by the cardinality of the states space and the support of the initial belief:*

$$\left|\bigcup_{t=1}^{\mathcal{T}} \mathbb{B}_t^{\mathrm{R}}(b_0)\right| \leq 2^{|\mathrm{supp}(b_0)|} |\mathbb{X}| .$$

(3.23)

It is now discussed a sketch of proof of proposition 13. When considering a mon-det-POMDP, one can first follow the same reasoning as in the proof of Theorem 8. Indeed, one needs to consider sets of mapping from $\mathbb{X} \longrightarrow \overline{\mathbb{X}}$ that verify equation (3.22).

There can be at most $|\mathbb{X}|$ mappings $\mathcal{T} \in \boldsymbol{T}$ such that $\delta \notin Im(\mathcal{T})$ . The mappings that satisfy Equation (3.22) are derived from the family $\boldsymbol{T}$ by choosing an element $\mathcal{T} \in \boldsymbol{T}$ and choosing if one keeps the value $\mathcal{T}(x)$ for a given element $x \in \mathbb{X}$ , or sending it to the cemetery. One hence gest to the bound $\left|\mathsf{U}_{t=1}^{\mathcal{T}} \mathbb{B}_t^R(b_0)\right| \leq 2^{|\mathbb{X}|} |\mathbb{X}|$ . By then applying the preliminary of the proof of Theorem 8, on gets to Equation (3.23).

*Proof.* Now we give the details. Using the definitions of $\mathcal{T}$ , $\mathcal{R}$ and $\varepsilon$ (Equations (3.10), (3.11), (3.12)), we have:

$$b \in \mathbb{B}_t^{\mathrm{R}}(b_0) \Leftrightarrow \exists (u_{1:t}, o_{1:t}) \in \mathbb{U}^t \times \mathbb{O}^t, b = \mathcal{R}\left(\left(\mathcal{T}_{u_{1:t}, o_{1:t}}^{1:t}\right)_\star \mathcal{E}(b_0)\right) .$$

As there can be only one renormalized value per mapping applied to $b_0$, the reachable belief space is hence bounded by the number of mapping $\mathcal{T}$ . However, the set of mapping $\mathcal{T}$ must verify Equation (3.22).

We first consider the set of mappings $T$ such that $\forall \mathcal{T}$ ,

$$\forall \mathcal{T}, \delta \notin Im(\mathcal{T}).$$

If that set $T$ verifies Equation (3.22), then

$$\forall (\mathcal{T}, \mathcal{T}') \in \boldsymbol{T}^2,$$

if $\exists x \in \mathbb{X}$ such that

$$\mathcal{T}(x) = \mathcal{T}'(x),$$

$$\mathcal{T} = \mathcal{T}'$$

(since $\delta$ is not in

$$Im(\mathcal{T})$$

or

$$Im(\mathcal{T}')$$

). We can thus apply the preliminary, and we have

$$|T| \leq \mathbb{X}.$$

Let us return to the set of mappings

$$\tilde{T} = \left\{ \mathcal{T}^{1:t+1}_{u_{0:t}, o_{1:t+1}} \right\}.$$

. As the mappings verify Equation (3.22),

$$\forall \tilde{\mathcal{T}} \in \tilde{T},$$

$$\exists \mathcal{T} \in \overset{.}{T}$$

such that:

$$\forall x \in \mathbb{X}, \tilde{\mathcal{T}}(x) = \begin{cases} \mathcal{T}(x) \text{ or} \\ \delta \end{cases}.$$

There is therefore at most $2^{|\mathbb{X}|}$ mappings $\tilde{\mathcal{T}}$ per mapping $\mathcal{T}$.

Hence, we have $|\tilde{T}| \leq |\mathbb{X}|2^{|\mathbb{X}|}$.

That reasoning stands for any kind of belief $b \in \Delta(\mathbb{X})$, instead of the reachable beliefs. To get the reachable beliefs sets, we need to consider mapping from supp($b_0$) to $\mathbb{X}$. Using the preliminary of Theorem 8, we therefore get:

$$\left| \bigcup_{t=1}^{\infty} \mathbb{B}^{\mathrm{R}}_t(b_0) \right| \leq 2^{|\mathrm{supp}(b_0)|}|\mathbb{X}|.$$

One is therefore bounded by the size of the underlying MDPs. This seems to imply that the problem with partial information may be tractable if the problems with perfect information are tractable.

**Dynamic Programming algorithm over reduced beliefs sets.**

**Forward computation of the Bellman value functions.** A bound on the reachable belief state $\mathbb{B}^{R}(b_0)$ has been defined, which is the space which contains all the beliefs reachable when starting in belief $b_0$. When computing the Bellman value function defined with Equation (3.3), one hence only needs to consider those beliefs when using a forward Dynamic Programming Algorithm. $\mathbb{B}$ may thus be restricted to $\bigcup_{t=1}^{\mathcal{T}} \mathbb{B}_t^R(b_0)$. Algorithm 5 below solves the problem in

$$\mathcal{O}(|\mathbb{B}||\mathcal{T}||\mathbb{U}||\mathrm{supp}(b_0)|)$$

(at most

$$\mathcal{T}|\mathbb{U}||\mathrm{supp}(b_0)|$$

computations per beliefs), *i.e.* in

$$\mathcal{O}\big(|\mathrm{supp}(b_0)|2^{|\mathrm{supp}(b_0)|}|\mathbb{X}|\mathcal{T}||\mathbb{U}|\big)$$

according to proposition 13.

---

**Algorithm 5:** Computation of value function $V_0(b_0)$

---

**Function** *Value_Computation*(t, b, Values):
  **if** Values(t, b) $\neq \delta$ **then**
    **return** Values(t, b);
  **end**
  best_value = 0;
  **for** $u \in \mathcal{U}_t^b(b)$ **do**
    current_value = $\mathcal{C}_t$(b, u) ;
    future_value = 0;
    **if** t < $\mathcal{T}$ **then**
      **for** o $\in h_{t+1}$(supp($b$),u) **do**
        future_value += $Q_t$(b, u, o) *
        *Value_Computation*(t+1, $\tau_t$ (b, u, o), Values);
      **end**
      current_value += future_value;
    **end**
    **if** current_value > best_value **then**
      best_value = current_value;
    **end**
  **end**
  Values(t, b) = best_value;
  **return** best_value;
**end**
**Initialization:**
  **for** t $\in \mathbb{T}$ **do**
    **for** $b \in \mathbb{B}_t^R(b_0)$ **do**
      Values(b, t) = $\delta$;
    **end**
  **end**
**end**
$V_0(b_0)$ = *Value_Computation*($b_0$, 0, Values);
**return** $V_0(b_0)$

---

**Online computation of the controls with the Bellman value functions.**

Consider at time *t* that the belief of the state of the system is $b \in \mathbb{B}_t^R(b_0)$. Consider that the value functions $V_t$ have all been computed. To find the optimal control $u_t^*$ at time t under belief *b*, one needs to solve:

$$u_t^\star(b) \in \arg\max_u \left\{ \mathcal{C}_t(b,u) + \sum_o Q_{t+1}(b,u,o)V_{t+1}(\tau_t(b,u,o)) \right\} \qquad (3.24)$$

**Example illustration of partial observations: emptying a partially observed bathtub**

This example illustrates a situation with partial observations, which is to empty a bathtub while minimizing an associated cost. The state $x_t$ is one dimensional and consists in the volume of water in the tub, and the control $u_t$ is also one dimensional and is the amount of water that the decision maker decides to remove during time step t. The state is partially observed, and the decision maker has access at time $t$ to $o_t$ which is smaller that the unobserved state $x_t$.

Optimization problem. We now explicit the Problem (3.1) for the bathtub:

$$\min_{X_t, U_t, O_t} \mathbb{E}\left[ \sum_{t=0}^{T} c_t U_t \right] \qquad (3.25a)$$

$$s.t.\ X_0\ with\ known\ distribution\ , \qquad (3.25b)$$

$$X_{t+1} = X_t - U_t\ ,\ \forall t \in \mathbb{T}\ , \qquad (3.25c)$$

$$U_t \in [0, O_t]\ ,\ \forall t \in \mathbb{T}\ , \qquad (3.25d)$$

$$O_t = \max\left\{ o^{(i)} | X_t \geq o^{(i)} \right\}\ ,\ \forall t \in \mathbb{T}\ , \qquad (3.25e)$$

$$\sigma(U_t) \subset \sigma\left( O_0, \ldots, O_t, U_0, \ldots, U_{t-1} \right)\ ,\ \forall t \in \mathbb{T}\ . \qquad (3.25f)$$

Equation (3.25a) is the objective function of the bathtub problem, i.e. the implementation of Equation (3.1a) of Problem 3.1. The cost instantaneous function at time t is defined as $\mathcal{L}_t(u_t) = c_t u_t$ , and hence only depends on the controls.

The observation function h is given by a piece wise constant function which does not depend on the controls $u$. We assume it has $m$ possible values. Let us write $o^{(i)}$ one value of the $h$. $h(x) = \max\{o^{(i)}, x \geq o^{(i)}\}$. We note $[\underline{o_t}, \overline{o_t}]$ the interval such that the states are compatible with the observations $o_t$, i.e. the interval that represents $\{x_t, h(x_t) = o_t\}$. This leads to equation (3.25e), which is the implementation of (3.1e).

We assume that the admissibility set is $\mathcal{U}^{ad}(O_t) = [0, O_t]$ . The state $x$ are therefore always positive as the observation is always smaller than the state. This properly define Equation (3.25d) as the implementation of Equation (3.1f). We can notably remark that in the general problem, the admissibility sets depend on the states and not on the observation. This is not an issue here, as the observations only depends on the states and not on the controls. Hence, we can rewrite the admissibility set as a dumping of the state without any issue: $\mathcal{U}^{ad}(X_t) = [0, h(X_t)] = [0, O_t]$ .

We therefore cannot empty the tub, as we cannot remove more water in the bathtub than the state at any given time. Indeed, we have $O_t \leq X_t$, hence $U_t \leq X_t$. The controls we apply thus ensure that the states are kept positive (having a positive volume of water in the bathtub is thus a constraint that could be added without any impact).

Definition of the dynamics on the belief $\tau$. Let $(b, u, o) \in \mathbb{B} \times \mathbb{U} \times \mathbb{O}$ , and let supp$(b) = \{x_1, \ldots, x_n\}$.

We can rewrite Equation (3.4):

$$\tau(b, u, o)(f(x, u)) = \begin{cases} \dfrac{b(x)}{\displaystyle\sum_{x' \in [\underline{o}-u, \overline{o}-u]} b(x')} & \text{if} \quad x \in [\underline{o}-u, \overline{o}-u] \ , \\ 0 & \text{if} \quad x \notin [\underline{o}-u, \overline{o}-u] \ . \end{cases}$$

Moreover, we can write function $Q$ as:

$$Q : \mathbb{B} \times \mathbb{U} \times \mathbb{O} \to [0, 1], (b, u, o) \mapsto \sum_{x \in [\underline{o}-u, \overline{o}-u]} b(x) \qquad (3.26)$$

Bellman equations for the bathtub problem.

$$V_T : \mathbb{B}_T^R(b_0) \to \mathbb{R} \ , \quad b \mapsto \min_{u \in \mathcal{U}^{ad}(h(x)), x \in \text{supp}(b)} c_T u \qquad (3.27)$$

$$V_t : \mathbb{B}_t^R(b_0) \to \mathbb{R} \ , \quad b \mapsto \min_{u \in \mathcal{U}^{ad}(h(x)), x \in \text{supp}(b)} \left( c_t u + \sum_{o \in \mathbb{O}} \sum_{x-u \in [\underline{o}, \overline{o}]} b(x) V_{t+1}\big(\tau(b, u, o)\big) \right) .$$

$$(3.28)$$

The bathtub problem as a mon-det-POMDP. The bathtub is clearly a mon-det-POMDP: Let $x_1$ be a state, $u_{1:t}$ and $u'_{1:t'}$ be two sequences of controls and let $o_{1:t}$ and $o'_{1:t}$ , be two sequences of observations such that

$$\mathcal{T}_{u_{1:t}, o_{1:t}}(x_1) = \mathcal{T}_{u'_{1:t'}, o'_{1:t'}}(x_1) \neq \delta.$$

.

There exists $F^w \in \mathbb{R}^+$ such that:

$$\mathcal{T}_{u_{1:t}, o_{1:t}}(x_1) = x_1 - F^w \ .$$

$F^w$ is the total amount of water that has been removed from the bathtub when applying the two sequences of controls.
This leads to:

$$\forall x \in \mathbb{X}, \mathcal{T}_{u_{1:t}, o_{1:t}}(x) = \begin{cases} x - F^w \ , \text{ or} \\ \delta \end{cases} ,$$

and

$$\forall x \in \mathbb{X}, \mathcal{T}_{u'_{1:t'}, o'_{1:t'}}(x) = \begin{cases} x - F^w \ , \text{ or} \\ \delta \end{cases} .$$

The bathtub thus verifies Equation (3.22), and is thus a mon-det-POMDP.

**Reformulation of POMDP in the belief space (following previously-discussed reference** Dimitri P. Bertsekas. Dynamic Programming and Optimal Control, volume I. Athena Scientific, Belmont, MA, USA, 4th edition, 2017. ISBN 9781886529434**, which is incorporated herein by reference).**

The usual way to solve a POMDP is to reformulate the problem, and use a new state, the beliefs:

- First, reformulating the imperfect state information as a perfect information case where the state grows with time.
- Second, defining the value functions in the new perfect information case.
- Third, setting out the beliefs as sufficient statics, which allow us to reformulate the value functions.

It is considered the states of the reservoir, the observations and the controls are discretized (i.e. that $x \in \mathbb{X}_d$, $o \in \mathbb{O}_d$, $u \in \mathbb{U}_d$).

**Reformulation as a perfect information controlled dynamical system.**

Definition 14. *The information vector, denoted by $I_t$, contains the all the information the optimizer has access to at time t.*

$$I_t = \left(o_0, \ldots, o_t, u_0, \ldots, u_{t-1}\right), \ \forall t \in \mathbb{T} \setminus \{0\},$$
$$I_0 = o_0 \tag{3.29}$$

**Proposition 15.** *The problem with imperfect state information can be reformulated as a problem with perfect state information, defined by a dynamical system where the state is the information vector I, the controls are the previous controls u, and the disturbance are the observation o:*

$$\mathcal{J}_\pi = \max \ \mathbb{E}_{x_0}\left[\sum_{t \in \mathbb{T}} \tilde{\mathcal{L}}(I_t, \pi_t(I_t))\right]$$

$$s.c. \ I_{t+1} = \left(I_t, o_{t+1}, \pi_t(I_t)\right), \ \forall t \in \mathbb{T} \setminus \{\mathcal{T}\}$$

$$o_{t+1} \sim P\left(\cdot | I_t, \pi_t(I_t)\right), \ \forall t \in \mathbb{T},$$

*Sketch of proof of Proposition 15:*

A policy is a sequence of functions $\pi = \{\pi_0, \ldots, \pi_{t-1}\}$, where each of the function $\pi_t$ takes an information vector $I_t$ as input and returns the corresponding control $u \in \mathbb{U}$. A policy is hence considered admissible if

$$\forall t \in \mathbb{T}, \forall I_t, \pi_t(I_t) \in \mathcal{U}^{ad}(I_t).$$

Note that $\mathcal{U}^{ad}(I)$ is defined as the admissibility set of the last observation of the information vector $(\mathcal{U}^{ad}(I_t) = \mathcal{U}^{ad}(o_t))$.

An admissible policy that maximizes

$$\mathcal{J}_\pi = \mathbb{E}_{x_0}\left[\sum_{t \in \mathbb{T}} \mathcal{L}(x_t, \pi_t(I_t))\right]$$

$$s.c. \ x_{t+1} = f(x_t, \pi_t(I_t)), \ \forall t \in \mathbb{T} \setminus \{\mathcal{T}\}$$

$$o_t = h(x_t) \, , \quad \forall t \in \mathbb{T} \, ,$$

also maximizes Problem (3.1).

Let us now reformulate the problem from imperfect to perfect state information. To do so, we need to define a new dynamical system, whose state at time $t$ is the information vector $I_t$. Indeed, that vector contains all the information available at time $t$.

Using the definition of the information vector (Equation (3.29)), we can define the dynamics on the information vector:

$$I_{t+1} = \left( I_t, o_{t+1}, u_t \right) , \quad \forall t \in \mathbb{T} \, . \tag{3.30}$$

Adding the initial condition

$$I_0 = o_0 \, ,$$

allow us to properly define a controlled dynamical system, where $I$ is the state, $u$ is the control and $o$ is the disturbance. Moreover, we can specify the law of the disturbance process. Indeed, we have:

$$P(o_{t+1}|I_t, u_t) = P(o_{t+1}|I_t, u_t, o_0, \ldots, o_t) \, ,$$

as the disturbances $o_0, \ldots, o_t$ are part of the information vector $I$. Hence, we have a disturbance process that only depends on the current state and controls, and not on the prior disturbances.

Since we have:

$$\mathbb{E}\left[ \mathcal{L}_t(x_t, u_t) \right] = \mathbb{E}\left[ \mathbb{E}_{x_t}\left[ \mathcal{L}(x_t, u_t | I_t, u_t) \right] \right] ,$$

we can reformulate the objective function with the variables of the new dynamical system. Indeed, we can write the new cost-to go function:

$$\tilde{\mathcal{L}}_t(I_t, u_t) = \mathbb{E}_{x_t}\left[ \mathcal{L}_t(x_t, u_t) | I_t, u_t \right] . \tag{3.31}$$

The problem with imperfect state information can thus be reformulated as a problem with perfect state information:

$$\mathcal{J}_\pi = \max \ \mathbb{E}_{x_0}\left[ \sum_{t \in \mathbb{T}} \tilde{\mathcal{L}}(I_t, \pi_t(I_t)) \right]$$

$$s.c. \ \ I_{t+1} = \left( I_t, o_{t+1}, \pi_t(I_t) \right) , \quad \forall t \in \mathbb{T} \setminus \{\mathcal{T}\}$$
$$o_{t+1} \sim P(\cdot | I_t, \pi_t(I_t)) , \quad \forall t \in \mathbb{T} \, ,$$

**Dynamic Programming for the formulation with perfect state information**

The Dynamic Programming Algorithm relies on value functions computation. Their expression is:

$$\mathcal{J}_T(I_T) = \max_{u_T \in \mathcal{U}^{ad}(I_T)} \left\{ \mathbb{E}\{\tilde{\mathcal{L}}_T(I_T, u_T)|I_T, u_T\} \right\}, \qquad (3.32)$$

and

$$\mathcal{J}_t(I_t) = \max_{u_t \in \mathcal{U}^{ad}(I_t)} \left\{ \mathbb{E}_{o_{t+1}}\left( \tilde{\mathcal{L}}_t(I_t, u_t) + \mathcal{J}_{t+1}\big((I_t, o_{t+1}, u_t)\big)|I_t, u_t \right) \right\} \qquad (3.33)$$

$$= \max_{u_t \in \mathcal{U}^{ad}(I_t)} \left\{ \mathbb{E}_{x_t, o_{t+1}}\left( \mathcal{L}_t(x_t, u_t) + \mathcal{J}_{t+1}(I_t, o_{t+1}, u_t)|I_t, u_t \right) \right\}$$

Hence, the formulation using information vector may be solved with a Dynamic Programming algorithm, and has the same optimal value as Problem (3.1). Let $\mathcal{J}$ * be the optimal value functions and $\pi^*$ be the optimal policy obtained through Dynamic Programming algorithm.

**Using beliefs as sufficient statistics**

Sufficient statistics are known from the literature and defined as quantities of smaller dimensions that $I_t$ that summarize all the essential content of $I_t$ as far as controls are concerned.

Sufficient statistics are functions $S_t$ such that there exist functions $H_t$ and $\overline{\mathcal{J}}_t$ that verify:

$$\mathcal{J}_t^\star(I_t) = \max_u H_t(S_t(I_t), u) = \overline{\mathcal{J}}_t(S_t(I_t)),$$

and there exist $\overline{\pi}_t$ such that:

$$\pi_t^\star(I_t) = \overline{\pi}_t\big(S_t(I_t)\big)$$

Proposition 16. *The belief b, i.e., the conditional state distribution knowing the information vector $b_t = P(x_t|I_t)$, are sufficient statistics.*

*Proof.* Here is a sketch of proof of Proposition 16.

We can define a function $G_t$ such that:

$$\mathbb{E}_{x_t}\big[\mathcal{L}_t(x_t, u_t)|I_t, u_t\big] = G_t(b_t, u_t).$$

Let us consider that there exists a function $\tau$ such that $b_{t+1} = \tau(b_t, u_t, o_{t+1})$ (we will explicit it in the discrete case in Looking back at Equation (3.32), we can write:

$$\mathcal{J}_T(I_T) = \max_{u_T \in \mathcal{U}^{ad}(I_T)} \left\{ \mathbb{E}\{\tilde{\mathcal{L}}_T(I_T, u_T)|I_T, u_T\} \right\} = \max_{u_T \in \mathcal{U}^{ad}(o_T)} \left\{ \mathbb{E}_{x_T}\{\mathcal{L}_T(x_T, u_T)|I_T\} \right\}$$

We denote by $C_t$ the cost to go function associated to the belief. It is defined as:

$$C_t(b_t, u_t) = \mathbb{E}_{x_t}\{\mathcal{L}(x_t, u_t)|I_t\}.$$

In the discrete case, we hence write it:

$$C_t(b_t, u_t) = \sum_{x \in \mathbb{X}_d} b_t(x) \mathcal{L}(x, u_t) .$$

We hence have:

$$\mathcal{J}_T(I_T) = \max_{u_T \in \mathcal{U}^{ad}(o_T)} \left\{ \mathbb{E}_{x_T} \{ \mathcal{L}_T(x_T, u_T) | I_T \} \right\} = \max_{u_T \in \mathcal{U}^{ad}(o_T)} C_T(b_T, u_T) = \overline{\mathcal{J}}_T(b_T)$$

Let us now write $\overline{\mathcal{J}}_t$ as functions of $b_t$ and $\overline{\mathcal{J}}_{t+1}$ , which will cement $b$ as sufficient statistics. Looking back at Equation (3.33), we have:

$$\mathcal{J}_t(I_t) = \max_{u_t \in \mathcal{U}^{ad}(I_t)} \left\{ \mathbb{E}_{o_{t+1}} \{ \tilde{\mathcal{L}}_t(I_t, u_t) + \mathcal{J}_{t+1}(I_t, o_{t+1}, u_t) | I_t, u_t \} \right\}$$

$$= \max_{u_t \in \mathcal{U}^{ad}(o_t)} \left\{ \mathbb{E}_{x_t, o_{t+1}} \{ \mathcal{L}_t(x_t, u_t) + \mathcal{J}_{t+1}(I_t, o_{t+1}, u_t) | I_t, u_t \} \right\}$$

$$= \max_{u_t \in \mathcal{U}^{ad}(o_t)} \left\{ C_t(b_t, u_t) + \mathbb{E}_{o_{t+1}} \{ \overline{\mathcal{J}}_{t+1}(\tau(b_t, u_t, o_{t+1})) \} \right\} = \overline{\mathcal{J}}_t(b_t)$$

The beliefs are therefore sufficient statistics.

Since the beliefs are sufficient statistics, they can be used to implement a Dynamics Programing algorithm that can solve Problem (3.1).

Implementations of the method which reformulate the deterministic optimization Problem (2.1) of an oil and gas production network assuming only partial observation are now discussed.

Implementations of the formulation and numerical resolution of a deterministic optimization problem for the management of an oil and gas production system (see Problem (2.1)) according to implementations of the method have been discussed hereinabove. In that formulation, it was considered that oil prices were known (deterministic oil prices) and that the state of the dynamical system modeling the reservoir dynamics was fully observed (i.e. the optimization problem was formulated under a complete observation assumption). Relaxing the deterministic assumption for prices and assuming that prices are driven by a Markov process could easily be taken into account as the deterministic problem was solved by dynamic programming and extensions to stochastic dynamic programming is straightforward.

However, assuming a complete observation of the state dynamics is a too demanding assumption. The state variables depend on the structure of an oil reservoir (which is a geological formation which contains some hydrocarbons) and are not perfectly known when starting to exploit the oil and gas production network. Implementations of the method therefore consider the optimization problem under partial observation, where it is assumed that the initial state of the reservoir is not known but that there is partial information as an initial probability law for the initial state distribution.

Implementations of the method which reformulate the deterministic optimization Problem (2.1) of an oil and gas production network assuming only partial observation are now discussed. This formulation leads to the optimization problem (P) (referred to in the implementations as "Problem (4.1)") which is a mon-det-POMDP. The optimization problem (P), which uses the function $f$ defined by Equation (S), is thus in implementations obtained by the reformulation of Problem (2.1) which is now discussed. Numerical applications are discussed hereinafter and implementations the creation of the relevant spaces to solve this problem is also discussed hereinafter.

**Reminder on the deterministic problem.** The presently-discussed implementations consider a petroleum production system, with at least one reservoir from which the hydrocarbons resources (which are considered to be fluids which follows a black oil model) are extracted. The production system is constituted of pipes, used to transport the fluids; wells, from which the fluids leave the reservoir and enter the network; valves, used to control the network; and pumps used to re-inject fluids in the reservoir. Meanwhile, the reservoir is modeled as a dynamical system thanks to the material balance equations and the black oil model.

It is considered that the topology of the petroleum production system is represented with a graph $\mathcal{G} = (\mathbb{V}, \mathbb{A})$ . $\mathbb{V}$ is the set of vertices, and $\mathbb{A} \subset \mathbb{V}^2$ is the set of arcs. It is also considered at least one reservoir which is modeled as a controlled dynamical system. The state of the reservoir is $x = (V^o, V^g, V^\omega, V^p, P^R)$. The controls $u$ are the opening or closing of pipes $o_a$, $a \in \mathbb{A}$, and choosing the well-head pressure $P_\omega$, $\omega \in \mathbb{V}_{in} \subset \mathbb{V}$. Let *f* be the evolution function of the reservoir,

$$\mathcal{U}^{ad}$$

be the admissibility set of the controls of the production system.

The goal of the implementations is to optimize the production phase, *i.e.* to maximize an economic criterion such as the net present value over multiple time steps. Let $\mathbb{T} = \{0, \ldots, \mathcal{T} - 1\}$ the finite set of the time steps, where $\mathcal{T}$ is a positive integer. The deterministic optimization problem is written as the problem (2.1).

**Adding partial observation.** The implementations take into account the partial observation of the content of the reservoir. Indeed, it is not always possible to see the true content of the reservoir. Instead, it is considered that there is an observation *o*, and an observation function *h* such that $o_t = h(x_t)$. The observations are the reservoir pressure $P^R$, the water-cut $\omega^{ct}$ (proportion of water produced when a volume of fluids is extracted), and the gas-oil ratio $g^{or}$ (proportion of gas produced when a volume of oil is extracted). Those observations allow to properly define the observation function.

**Links to problem (3.1).** The variables of the problem are:

$$x = \left(V^o, V^g, V^w, V^p, P^R\right),$$

$$u = \left((o_a)_{a \in \mathbb{A}}, (P_w)_{w \in \mathbb{V}_{in}}\right),$$

$$o = \left(P^R, w^{ct}, g^{or}\right).$$

The general formulation of the optimization of a petroleum production system under partial observation is:

$$\max_{X,O,U} \quad \mathbb{E}\left[\sum_{t=0}^{\mathcal{T}-1} \mathcal{L}_t(X_t, U_t) + \mathcal{K}(X_T)\right] \tag{4.1a}$$

$$s.t. \quad L_{X_0} = \mu_0, \tag{4.1b}$$

$$X_{t+1} = f(X_t, U_t), \quad \forall t \in \mathbb{T}, \tag{4.1c}$$

$$O_t = h(X_t), \quad \forall t \in \mathbb{T}, \tag{4.1d}$$

$$U_t \in \mathcal{U}_t^{ad}(X_t), \quad \forall t \in \mathbb{T} \tag{4.1e}$$

$$\sigma(U_t) \subset \sigma(O_0, \ldots, O_t, U_0, \ldots, U_{t-1}), \quad \forall t \in \mathbb{T}. \tag{4.1f}$$

It is considered in this paragraph that there is only a *one tank reservoir* in the production system to simplify the description of the problem. Extending the formulation to multiple reservoirs is done by expanding the state vector and observation vector to accommodate each of the reservoir accordingly.

**Objective function.** The objective function of the problem (in Equation (4.1a)) is defined by the cost function $\mathcal{L}$. It is defined as Equation (2.1a). It depends on the production values, which are affected by the observation (reservoir pressure, water-cut and gas-oil ratio). The production values are obtained through the general production function

$\Phi: \mathbb{X} \times \mathbb{U} \to \mathbb{R}^3$ (in the one tank case), and the implementation associate a vector price $r_t$ for the production of each fluid: oil, gas and water. Controls $u$ may also have an associated cost vector c, such as the functioning cost of a pump which re-inject water in the reservoir. All those costs are condensed in the cost function $\mathcal{L}$.

$$\mathcal{L}_t: \mathbb{X} \times \mathbb{U} \to \mathbb{R}, (o, u) \mapsto r_t^T \Phi(x, u) - c^T u .$$

Note that while the general production function $\Phi$ is defined on the state space, it only depends on the observations. There is thus a function $\widetilde{\Phi}: \mathbb{O} \times \mathbb{U} \to \mathbb{R}^3$ such that

$$\forall (x, u) \in \mathbb{X} \times \mathbb{U}, \Phi(x, u) = \widetilde{\Phi}(h(x), u)$$

**Initialization.** The initialization of the state of the reservoir is represented in Equation (4.1b). Here, the implementations initialize the state with the distribution given by previous analysis on the reservoir.

**Dynamics.** For the dynamics of Equation (4.1c), the implementations use the function $f$ previously defined. The dynamics was defined using the general production function $\Phi$ in Equation (2.3). The function $f$ is defined as:

$$f : \mathbb{X} \times \mathbb{U} \to \mathbb{X}, (x, u) \mapsto \begin{pmatrix} x^{(1)} - \Phi(x, u)^{(1)} \\ x^{(2)} - \Phi(x, u)^{(2)} + x^{(1)} R_s(x^{(5)}) \\ \quad - \left(x^{(1)} - \Phi(x, u)^{(1)}\right) R_s\left(\Xi(x, u)\right) \\ x^{(3)} - \Phi(x, u)^{(3)} \\ x^{(4)} \left(1 + c_f(\Xi(x, u) - x^{(5)})\right) \\ \Xi(x, u) \end{pmatrix},$$

where $\Xi$ is an easily computed function. It is now considered that the computation of $f$ is in $\mathcal{O}(1)$, *i.e.* in constant time. Also, $f$ is stationary (not time dependent).

**Observations.** Equation (4.1d) define the observation we have access to. In the management of an oil and gas production system, it is assumed that the observation function $h$ is known, and how those observations depend on the components of the state. The reservoir pressure is directly observed, while the watercut is a function of the water saturation $S^\omega = \frac{V^\omega B_\omega}{V^p}$ and the gas-oil ratio is a function of the free gas saturation $S^g = \frac{V^g B_g}{V^p}$ (with $B_\omega$ and $B_g$ functions of the reservoir pressure).

$$h : \mathbb{X} \to \mathbb{O}, x \mapsto \begin{pmatrix} x^{(5)} \\ w^{ct}\left(x^{(3)}, x^{(4)}, x^{(5)}\right) \\ g^{or}\left(x^{(2)}, x^{(4)}, x^{(5)}\right) \end{pmatrix}$$

Here, the observation only depends on the state itself, not on the controls $u$. Moreover, the observation functions considered are stationary, whereas the observation functions of Problem (3.1) were time dependent and also depended on the previous controls.

**Admissibility set of the controls.** Equation (4.1e) states that for each time step $t$, the controls $u_t$ must belong to an admissibility set $\mathcal{U}_t^{ac}$ which depends on the current state. In this admissibility set is contained all the constraints derived from the production system (capacity of the pipes, allowed pressure range of the different asset which is translated to a pressure range at the different nodes, capacity of treatment of gas and water at the export point). Those constraints are such that they directly depend on the fluids production. There is thus a set $\mathcal{U}_t$ defining all the current ranges of admissible value on the production network such that admissible controls are defined as

$$\forall(x, u) \in \mathbb{X} \times \mathbb{U}, \Phi(x, u) \in \mathcal{U}_t .$$

The admissibility set is therefore defined as the set valued mapping

$$\mathcal{U}_t^{ad} : \mathbb{X} \to \mathbb{U}, x \mapsto \left\{ u \big| \Phi(x, u) \in \mathcal{U}_t \right\} .$$

Note that all those constraints depend on the current observation: as the general production function $\Phi$ only depends on the observations, not on other functions of the state of the reservoir, hence the fluids in the network are functions of the observation and the controls. Since the constraints on the production system are due to the production values and the pressure at the different nodes (which is derived from the controls and the observed reservoir pressure), the admissibility set only depends on the current observation. The implementations therefore also use the set valued mapping $\tilde{\mathcal{U}}_t^{ad} : \mathbb{O} \to \mathbb{U}$ to define the admissibility set which depends on the observation. This simplifies the admissibility of the controls and the policy.

**Non-anticipativity.** Finally, Equation (4.1f) is the non-anticipativity constraint. It states that to choose the controls at time $t$, one only has access to the history of controls and observation up to time $t$.

Only the discrete case is discussed, where it is considered that one has a discrete distribution for the initial state. This means one needs to discuss how the problem is discretized before solving it. The discretization process implemented by the implementations is discussed hereinafter.

**Monotonicity of the management of an oil and gas pro-duction system**

**Assumption 1.** *We assume that there. is an observer* $o_0 \in \mathbb{O}$ *such that* $\forall x \in \text{supp}(\mu_0)$, $h(x) = o_0$.

**Proposition 17.** *Problem (4.1) is a mon-det-POMDP.*

*Proof.* Let us check that $f$ verifies Equation (3.22) for all states in a reachable belief.

First, the production function $\Phi$ depends on the observation, not directly on the state. Hence, for all states $x$ and $x'$ such that $h(x) = h(x')$, then for all $u \in \mathbb{U}$, $\Phi(x, u) = \Phi(x', u)$. For convenience, we therefore define $\tilde{\Phi} : \mathbb{O} \times \mathbb{U} \to \mathbb{R}^3$ the function that takes the observation instead of the state as input: $\forall x \in \mathbb{X}$, $\forall u \in \mathbb{U}$, $\Phi(x, u) = \tilde{\Phi}(h(x), u)$.

We also use the mappings $\mathcal{T}$ as defined in the proof of Theorem 8. We consider an extended state space $\overline{\mathbb{X}} = \mathbb{X} \cup \{\delta\}$, and define $\mathcal{T}$ as

$$\mathcal{T}_{u,o} : \overline{\mathbb{X}} \to \overline{\mathbb{X}}, \bar{x} \mapsto \begin{cases} f(\bar{x}, u) \text{ if } h(f(\bar{x}, u)) = o, \\ \delta \text{ otherwise} \end{cases} .$$

We now detail T:

$$\mathcal{T}_{u,o} : \bar{x} \mapsto \begin{cases} \begin{pmatrix} x^{(1)} - \tilde{\Phi}(h(x), u)^{(1)} \\ x^{(2)} - \tilde{\Phi}(h(x), u)^{(2)} + x^{(1)} R_s(x^{(5)}) - \\ (x^{(1)} - \tilde{\Phi}(h(x), u)^{(1)}) R_s(o^{(1)}) \\ x^{(3)} - \tilde{\Phi}(h(x), u)^{(3)} \\ x^{(4)}(1 + c_f(o^{(1)} - x^{(5)})) \\ o^{(1)} \end{pmatrix} \text{ if } h(f(\bar{x}, u)) = o, \\ \delta \text{ otherwise} \end{cases} . \quad (4.2)$$

Indeed, we have $\forall x \in \mathbb{X}, x^{(5)} = h(x)^{(1)}$ .

First, let $x \in \mathbb{X}$ . According to Equation (4.2), we have that

$$\forall (u, o) \in \mathbb{U} \times \mathbb{O} , \quad \mathcal{T}_{u,o}(x) \in \{h^{-1}(o)\} \cup \{\delta\} .$$

When considering a composition, we hence get

$$\forall x \in \mathbb{X}, \forall (u_{0:t-1}, o_{1:t}) \in \mathbb{U}^t \times \mathbb{O}^t , \quad \mathcal{T}_{u_{0:t-1}, o_{1:t}}(x) \in \{h^{-1}(o_t)\} \cup \{\delta\} .$$

When considering a belief $b$, we hence have $\forall (u, o) \in \mathbb{U} \times \mathbb{O}$ , $\forall x \in \text{supp}(\tau(b, u, o)), h(x) = o.$

Using Assumption 1, we can hence consider that $\forall b \in \bigcup_{t=0}^{\infty} \mathbb{B}_t^R(b_0)$ , $\exists o \in \mathbb{O}$ such that $\forall x \in \text{supp}(b), h(x) = o.$

To verify that Problem (4.1) is a mon-det-POMDP, we need to verify that

$$\forall (\mathcal{T}', \mathcal{T}'') \in \bar{\mathcal{T}}^2 ,$$

such that there exists $x \in \mathbb{X}$ ,

$$\mathcal{T}'(x) = \mathcal{T}''(x),$$

then $\forall x' \in h^{-1}(h(x))$,

$$\mathcal{T}'(x') = \mathcal{T}''(x') \quad \text{or} \quad \mathcal{T}'(x') = \delta \quad \text{or} \quad \mathcal{T}''(x') = \delta .$$

To do so, we analyze the different components of $\mathcal{T}$ . We denote by $\overline{\mathcal{T}}^o$ the restriction of $\mathcal{T}$ to $h^{-1}(o)$, i.e.

$$\overline{\mathcal{T}}^o : h^{-1}(o) \to \mathbb{X} , \quad x \mapsto \mathcal{T}(x)$$

.

The composition of functions $\overline{\mathcal{T}}$ has restrictions on the observations involved in order to be well defined. Indeed, let $(o_i)_{i \in \{1,2,3,4\}} \in \mathbb{O}^4$ , and let $(u, u') \in \mathbb{U}^2$ .

$$\overline{\mathcal{T}}_{u',o_4}^{o_3} \circ \overline{\mathcal{T}}_{u,o_2}^{o_1}$$

is well defined if and only if $o_2 = o_3$. Therefore, we can define without any ambiguity the composition of t functions T by giving a sequence of controls

$$\overline{\mathcal{T}}_{u_{0:(t-1)}, o_{0:t}} = \overline{\mathcal{T}}_{u_{t-1}, o_t}^{o_{t-1}} \circ \overline{\mathcal{T}}_{u_{t-2}, o_{t-1}}^{o_{t-2}} \circ \cdots \circ \overline{\mathcal{T}}_{u0, o_1}^{o_0}$$

$(u_i)_{i \in \{0,...,t-1\}}$ and a sequence of observations $(o_i)_{i \in \{0,...,t\}}$:

We denote by $\overline{T}$ the set of the functions $\overline{\mathcal{T}}$ and their well defined compositions.

First,

$$\forall b \in \bigcup_{t=0}^{\infty} \mathbb{B}_t^{\mathbb{R}}(b_0),$$

$$\exists \mathcal{T} \in \boldsymbol{T}$$

such that

$$b = \mathcal{R}\left((\mathcal{T})_\star \mathcal{E}(b_0)\right).$$

. Such $\mathcal{T}$ is associated to a sequence of controls $(u_i)_{i \in \{0,1,\ldots,t-1\}}$ and a sequence of observations $(o_i)_{i \in \{1,\ldots,t\}}$. When considering

$$\mathcal{T}_{u_{0:(t-1)}, o_{0:t}},$$

with $o_0$ the observation given by Assumption 1, we have that $\forall x \in \mathrm{suppr}(b_0)$,

$$\mathcal{T}_{u_{0:(t-1)}, o_{0:t}}(x) = \mathcal{T}_{u_{0:(t-1)}, o_{1:t}}(x).$$

Hence,

$$\forall b \in \bigcup_{t=0}^{\infty} \mathbb{B}_t^{\mathbb{R}}(b_0),$$

$$\exists \overline{\mathcal{T}} \in \overline{\boldsymbol{T}}$$

such that

$$b = \mathcal{R}\left((\overline{\mathcal{T}})_\star \mathcal{E}(b_0)\right).$$

.

In order to prove that Problem (4.1) is a mon-det-POMDP, we need to prove that $\overline{T}$ is a Monotonous Function Set.

First, let us write a general form of the mapping

$$\mathcal{T}_{u,o}'$$

:

$$\overline{\mathcal{T}}_{u,o}^{o'}, x \mapsto \begin{cases} \begin{pmatrix} x^1 + g_1(o',u) \\ x^{(2)} + g_2(o',u)+ \\ m(o)(x^{(1)} + g_1(o',u)) - m(o')x^{(1)} \\ x^{(3)} + g_3(o',u) \\ x^{(4)}(1 + a(o - o')) \\ o^{(1)} \end{pmatrix} \\ \delta \end{cases}.$$

The composition

$$\overline{\mathcal{T}}_{u_{0:t-1}, o_{0:t}}$$

thus has the following form

$$\overline{\mathcal{T}}_{u_{0:t-1}, o_{0:t}} x \mapsto \begin{cases} \begin{pmatrix} x^1 + \sum_{j=0}^{t-1} g_1(o_j, u_j) \\ x^{(2)} + \sum_{i=0}^{t-1} \left\{ g_2(o_i, u_i) + m(o_{i+1})(x^{(1)} + \sum_{j=0}^{i} \{g_1(o_j, u_j)\}) - \\ m(o_i)(x^{(1)} + \sum_{j=0}^{i-1} g_1(o_j, u_j)) \right\} \\ x^{(3)} + \sum_{j=0}^{t-1} g_3(o_j, u_j) \\ x^{(4)} \prod_{i=0}^{t-1} (1 + a(o_{i+1} - o_i)) \\ o^{(1)} \end{pmatrix} \\ \delta \end{cases}.$$

Let us focus on the different components of $\overline{\mathcal{T}}$. First, we can remark that the components $i \in \{1,3\}$ are of the form

$$(\overline{\mathcal{T}}_{u,o}^{o'})^{(i)}, x \mapsto \begin{cases} x^i + g_i(o',u) \text{, or} \\ \delta \end{cases}.$$

When considering a composition

$$\overline{\mathcal{T}}_{u_{0:(t-1)}, o_{0:t}},$$

we hence have

$$\overline{\mathcal{T}}_{u_{0:(t-1)}, o_{0:t}}^{(i)}, x \mapsto \begin{cases} x^{(i)} + \sum_{j=0}^{t-1} g_i(o_j, u_j) \text{, or} \\ \delta \end{cases}.$$

Let

$$\overline{\mathcal{T}}_{u_{0:(t-1)},o_{0:t}}$$

and

$$\overline{\mathcal{T}}'_{u'_{0:(t'-1)},o'_{0:t'}}$$

two mappings of $\overline{T}$. If there is a states $x \in \mathbb{X}$ such that

$$\overline{\mathcal{T}}_{u_{0:(t-1)},o_{0:t}}(x) = \overline{\mathcal{T}}'_{u'_{0:(t'-1)},o'_{0:t'}}(x) \neq \delta,$$

then we have that $o_0 = o'_0$ and $o_t = o'_{t'}$ . Finally, we have

$$x^{(i)} + \sum_{j=0}^{t-1} g_i(o_j, u_j) = x^{(i)} + \sum_{j=0}^{t'-1} g_i(o'_j, u'_j) ,$$

i.e.

$$\sum_{j=0}^{t-1} g_i(o_j, u_j) = \sum_{j=0}^{t'-1} g_i(o'_j, u'_j) . \qquad (4.3)$$

Hence, $\forall x \in \mathbb{X}$ , we have either

$$\left(\overline{\mathcal{T}}'_{u'_{0:(t'-1)},o'_{0:t'}}\right)^{(i)}(x) = \left(\overline{\mathcal{T}}_{u_{0:(t-1)},o_{0:t}}\right)^{(i)}(x) \quad \text{or} \quad \overline{\mathcal{T}}'_{u'_{0:(t'-1)},o'_{0:t'}}(x) = \delta \quad \text{or} \quad \overline{\mathcal{T}}_{u_{0:(t-1)},o'_{0:t}}(x) = \delta$$

For components $i \in \{1,3\}$, $\overline{T}$ is thus a Monotonous Function Set.

Let us now focus on component 4. The fourth component of $\overline{\mathcal{T}}$ has the following form

$$\left(\overline{\mathcal{T}}'_{u,o}\right)^{(4)}, x \mapsto \begin{cases} x^{(4)}\bigl(1 + a(o - o')\bigr) , \text{ or} \\ \delta \end{cases} .$$

When considering a composition

$$\overline{\mathcal{T}}_{u_{0:(t-1)},o_{0:t}},$$

we hence have

$$\left(\overline{\mathcal{T}}_{u_{0:(t-1)},o_{0:t}}\right)^{(4)}, x \mapsto \begin{cases} x^{(4)} \prod_{i=0}^{t-1}\bigl(1 + a(o_{i+1} - o_i)\bigr) , \text{ or} \\ \delta \end{cases} .$$

Let us once again consider

$$\mathcal{T}_{u_{0:(t-1)},o_{0:t}}$$

and

$$\mathcal{T}'_{u'_{0:(t'-1)},o'_{0:t'}}$$

two mappings of $\overline{T}$. If there is a states $x \in \mathbb{X}$ such that

$$\mathcal{T}_{u_{0:(t-1)},o_{0:t}}(x) = \mathcal{T}'_{u'_{0:(t'-1)},o'_{0:t'}}(x) \neq \delta.$$

We have

$$x^{(4)} \prod_{i=0}^{t-1} \left(1 + a(o_{i+1} - o_i)\right) = x^{(4)} \prod_{i=0}^{t'-1} \left(1 + a(o'_{i+1} - o'_i)\right).$$

As the fourth component of the state *x* must be strictly positive, we hence have

$$\prod_{i=0}^{t-1} \left(1 + a(o_{i+1} - o_i)\right) = \prod_{i=0}^{t'-1} \left(1 + a(o'_{i+1} - o'_i)\right).$$

We once again verify Equation (3.22).

Let us now look at last component, 2. It is of the form

$$\mathcal{T}'^{o'}_{u,o}, x \mapsto \begin{cases} x^{(2)} + g_2(o', u) + m(o)(x^{(1)} + g_1(o', u)) - m(o')x^{(1)} \text{ , or} \\ \delta \end{cases}.$$

When considering a composition

$$\mathcal{T}_{u_{0:(t-1)},o_{0:t}}$$

and by using the component {1}, we hence have

$$\mathcal{T}_{u_{0:(t-1)},o_{0:t}}, x \mapsto \begin{cases} x^{(2)} + \sum_{i=0}^{t-1} \left\{ g_2(o_i, u_i) + m(o_{i+1})(x^{(1)} + \sum_{j=0}^{i} \{g_1(o_j, u_j)\}) - \\ \qquad\qquad\qquad m(o_i)(x^{(1)} + \sum_{j=0}^{i-1} g_1(o_j, u_j)) \right\} \\ \delta \end{cases} \text{ , or } .$$

We can simplify it to

$$\overline{\mathcal{T}}_{u_{0:(t-1)},o_{0:t}}, x \mapsto \begin{cases} x^{(2)} + \sum_{i=0}^{t-1}\left\{ g_2(o_i, u_i) \right\} + m(o_t)\left( x^{(1)} + \sum_{j=0}^{t} g_1(o_j, u_j) \right) - m(o_0)x^{(1)} & , \text{ or} \\ \delta \end{cases}.$$

Let us once again consider

$$\overline{\mathcal{T}}_{u_{0:(t-1)},o_{0:t}}$$

and

$$\overline{\mathcal{T}}'_{u'_{0:(t'-1)},o'_{0:t'}}$$

two mappings of $\overline{\mathcal{T}}$. If there is a states $x \in \mathbb{X}$ such that

$$\overline{\mathcal{T}}_{u_{0:(t-1)},o_{0:t}}(x) = \overline{\mathcal{T}}'_{u'_{0:(t'-1)},o'_{0:t'}}(x) \neq \delta.$$

We have

$$x^{(2)} + \sum_{i=0}^{t-1}\left\{ g_2(o_i, u_i) \right\} + m(o_t)\left( x^{(1)} + \sum_{j=0}^{t} g_1(o_j, u_j) \right) - m(o_0)x^{(1)} =$$
$$x^{(2)} + \sum_{i=0}^{t'-1}\left\{ g_2(o'_i, u'_i) \right\} + m(o'_t)\left( x^{(1)} + \sum_{j=0}^{t'} g_1(o'_j, u'_j) \right) - m(o'_0)x^{(1)}$$

Using Equation (4.3) (which is also verified), and since $o_0 = o'_0$ and $o_t = o'_{t'}$, we have

$$x^{(2)} + \sum_{i=0}^{t-1}\left\{ g_2(o_i, u_i) \right\} + m(o_t)\left( x^{(1)} + \sum_{j=0}^{t} g_1(o_j, u_j) \right) - m(o_0)x^{(1)} =$$
$$x^{(2)} + \sum_{i=0}^{t'-1}\left\{ g_2(o'_i, u'_i) \right\} + \overbrace{m(o'_{t'})}^{=m(o_t)} \underbrace{\left( x^{(1)} + \sum_{j=0}^{t'} g_1(o'_j, u'_j) \right) - \overbrace{m(o'_0)}^{m(o_0)} x^{(1)}}_{=x^{(1)}+\sum_{j=0}^{t} g_1(o_j, u_j)},$$

which leads to

$$x^{(2)} + \sum_{i=0}^{t-1}\left\{ g_2(o_i, u_i) \right\} = x^{(2)} + \sum_{i=0}^{t'-1}\left\{ g_2(o'_i, u'_i) \right\},$$

i.e.

$$\sum_{i=0}^{t-1}\left\{g_2(o_i,u_i)\right\} = \sum_{i=0}^{t'-1}\left\{g_2(o'_i,u'_i)\right\}.$$

Hence, for $x' \in \mathbb{X}$, if $\overline{\mathcal{T}}_{u_{0:(t-1)},o_{0:t}}(x') \neq \delta$ and $\overline{\mathcal{T}}_{u'_{0:(t'-1)},o'_{0:t'}}(x') \neq \delta$, we have

$$\begin{aligned}
\overline{\mathcal{T}}_{u_{0:(t-1)},o_{0:t}}(x')^{(2)} &= x'^{(2)} + \sum_{i=0}^{t-1}\left\{g_2(o_i,u_i)\right\} + m(o_t)\left(x'^{(1)} + \sum_{j=0}^{t} g_1(o_j,u_j)\right) - m(o_0)x'^{(1)}\\
&= x'^{(2)} + \sum_{i=0}^{t'-1}\left\{g_2(o'_i,u'_i)\right\} + m(o_t)\left(x'^{(1)} + \sum_{j=0}^{t} g_1(o_j,u_j)\right) - m(o_0)x'^{(1)}\\
&= x'^{(2)} + \sum_{i=0}^{t'-1}\left\{g_2(o'_i,u'_i)\right\} + m(o'_{t'})\left(x'^{(1)} + \sum_{j=0}^{t'} g_1(o'_j,u'_j)\right) - m(o'_0)x'^{(1)}\\
&= \overline{\mathcal{T}}_{u'_{0:(t'-1)},o'_{0:t'}}(x')^{(2)}.
\end{aligned}$$

Hence, the second component also verifies Equation (3.22). As all the components of $\overline{\mathcal{T}}$ verify Equation (3.22), $\overline{\mathcal{T}}$ is a Monotonous Function Set. Moreover, since for all beliefs $b \in \bigcup_{t=0}^{\infty} \mathbb{B}_t^{\mathrm{R}}(b_0)$, there is

$$\overline{\mathcal{T}} \in \mathcal{T} \;$$

such that

$$b = \mathcal{R}\left((\mathcal{T})_{\star}\mathcal{E}(b_0)\right),$$

Problem (4.1) is a mon-det-POMDP.

Implementations of the optimization where the optimization comprises solving the optimization problem (P), previously discussed, with *f* the function given by the previously-discussed formula (S), in the case where the observations are partial observations are now discussed. In these implementations (P), which corresponds to Problem (4.1), is a det-POMDP. These implementations include discretizing the optimization problem (P), which includes the step of implementing the discretization framework discussed hereinafter, constructing the belief space as discussed hereinafter, constructing the reachable state space as discussed hereinafter, constructing the reachable belief space as discussed hereinafter. The implementations may further include applying any suitable Dynamic Programming Algorithm to solve the discretized problem (P), for example by using Algorithm 1.

**Discretization framework**

As Problem (4.1) is a mon-det-POMDP, discretization of Problem (4.1) is now detailed. Indeed, results on mon-det-POMDP presented in Chapter 3 were for finite state space, controls space and observation space. However, the functions presented in §4.2.1 (i.e. *f* and *h*) are continuous. One thus needs to discretize the functions and controls to get finite sets for the state, controls and observations.

The implementations discretize the observations in *m* values, and consider that there can be up to *d* controls per observations *o*, and those controls belongs to $\tilde{\mathcal{U}}^{ad}(o)$. Hence, it is now considered discretized sets $\mathbb{U}_d$ and $\mathbb{O}_d$ for the controls and observations. It is hence considered a discretized function $h: \mathbb{X} \to \mathbb{O}_d$, and controls

$$u \in \mathbb{U}_d \subset \mathbb{U}_{o \in \mathbb{O}_d} \tilde{\mathcal{U}}^{ad}(o)$$ . The implementations then build the state space by recursively applying the dynamics on the possible initial state with the relevant associated controls. Indeed, for all $x_0 \in \text{supp}(b_0)$ ($b_0$ being the belief on the initial state), the implementations compute the reachable state space $\bigcup_{t=0}^{\mathcal{T}} \mathbb{X}_t^R(x_0)$, where $\mathbb{X}_t^R(x_0)$ is recursively defined as

$$\mathbb{X}_0^R(x_0) = \{0\}$$

$$\mathbb{X}_{t+1}^R(x_0) = \left\{ y \mid \exists x \in \mathbb{X}_t^R, \exists u \in \tilde{\mathcal{U}}^{ad}\big(h(x)\big), y = f(x, u) \right\}$$

The implementations thus yield a discrete space:

$$\mathbb{X}_d = \bigcup_{x_0 \in \text{supp}_{b_0}} \mathbb{X}^R(x_0) .$$

The implementations therefore yield a discretized dynamics $f : \mathbb{X}_d \times \mathbb{U}_d \to \mathbb{X}_d$.

The implementations then define properly dynamics on the beliefs $\tau$. Problem (4.1) is a detPOMDP, and thus satisfies Proposition 4 which states that $\tau$ is entirely defined by $f$ and $h$. By propagating the initial belief $b_0$ with $\tau$, the implementations obtain the discrete reachable belief space $\mathbb{B}^R$:

$$\mathbb{B}^R = \bigcup_{t=1}^{\mathcal{T}} \mathbb{B}_t^R(b_0) .$$

The notations used in the presently-discussed implementations are presented in Table 4.1 below:

Table 4.1: Notations of the spaces

| Symbol | Definitions |
|---|---|
| $\mathbb{U}$ | State space |
| $\mathbb{O}$ | Discretized state space |
| $\mathbb{O}_d$ | Control space |
| $\mathbb{B}^R$ | Discretized control space |
| $\mathbb{X}$ $\mathbb{X}_d$ $\mathbb{U}_d$ Space of the observations $\mathbb{T}$ $\mathbb{B}$ | Discretized space of the observations |
| | Space of the time steps |
| | Space of the beliefs |
| | Space of the reachable beliefs (discrete) |

**Construction of the belief space**

**Controls and observations.** Consider a given discretization of the observer function $\tilde{h} : \mathbb{X} \to \mathbb{O}_d$. The discretized observer function $\tilde{h}$ is constant inside a closed connex part the state space, and $\tilde{h}^{-1}(o)$ is a closed connected part of the state space. It is assumed that oil or gas cannot be injected in the reservoir. That condition imply certain value on the production functions. If there is only one reservoir, the implementations can therefore consider the following. First, the production values form a three dimensional vector:

$$\forall (o, u) \in \mathbb{O} \times \mathbb{U}_d, \tilde{\Phi}(o, u) = \begin{pmatrix} \tilde{\Phi}^{(1)}(o, u) \\ \tilde{\Phi}^{(2)}(o, u) \\ \tilde{\Phi}^{(3)}(o, u) \end{pmatrix} , \quad \tilde{\Phi}^{(1)}(o, u), \tilde{\Phi}^{(2)}(o, u) \geq 0 .$$

Moreover, $\tilde{\Phi}^{(1)}$, $\tilde{\Phi}^{(2)}$ and $\tilde{\Phi}^{(3)}$ impact the observation in a predictable manner:

- $\tilde{\Phi}^{(1)}$ (the production of oil) is such that it decreases the reservoir pressure $P^R$ (the component $o^{(1)}$ of $o$), and increases the water-cut $w^{ct}$ (component $o^{(2)}$) and gas-oil ratio $g^{or}$ (component $o^{(3)}$).

- $\tilde{\Phi}^{(2)}$ (the production of free gas) is such that it decreases the reservoir pressure $P^R$.

- $\tilde{\Phi}^{(3)}$ (the production or injection of water) is such that it decreases the reservoir pressure $P^R$ (but it can be negative and then increase the reservoir pressure), and it increases the water-cut $w^{ct}$ when we re-inject some water.

Therefore, there is a reduction of the number of possible observations each time controls are applied, as the water-cut and gas-oil ratio can only increase with time. Moreover, it also means the observation set $\mathbb{O}_d$ can be ordred. Indeed, when in a given state $x$, with observation $o = \tilde{h}(x)$, applying any controls increases the water-cut $w^{ct}$ and the gas-oil ratio $g^{or}$.

$$\forall (x, u) \in \mathbb{X}_d \times \mathbb{U}_d, \tilde{h}(x)^{(2)} \leq \tilde{h}(f(x, u))^{(2)}, \text{ and } \tilde{h}(x)^{(3)} \leq \tilde{h}(f(x, u))^{(3)}$$

Moreover, when the reservoir pressure $P^R$ increases, so does the water-cut. Hence, by ordering the observation by increasing $w^{ct}$ and $g^{or}$, and decreasing $P^R$, one obtains an ordered observation, where two components ($w^{ct}$ and $g^{or}$) can only increase with time.

To reduce the size of $\mathbb{X}$ , we also consider that the controls are such that the different resulting productions of each fluid are multiple of each other, which allow multiple path to a given state $x_0$ from state $x'$, for example:

$$\exists (u, u') \in (\mathbb{U}_d)^2, \exists x \in \mathbb{X}_d, f(x, u) = f(f(x, u'), u')$$

For a given state $x$ and observation $o = \tilde{h}(x)$, one can therefore order the controls along three directions, such that $u_{i,j,k}^{(o)}$ verifies:

$$f(x, u_{2i,2j,2k}^{(o)}) = f(f(x, u_{i,j,k}^{(o)}), u_{i,j,k}^{(o)}) .$$

It is now considered that there are $l$, $m$ and $n$ controls in the three directions.

Note: we assume here that $\tilde{h}\left( f(x, u_{i,j,k}^{(o)}) \right) = o$ . Moreover, this is an approximation of the state space. Indeed, if we compute $x' = f(x, u_{2i,2j,2k}^{(o)})$ and $x'' = f(f(x, u_{i,j,k}^{(o)}), u_{i,j,k}^{(o)})$ , there is a slight difference between $x'^{(5)}$ and $x''^{(5)}$. However, we consider that $x' = x''$ to reduce the number of states we need to consider.

**Construction of the reachable state space.** It is now discussed an algorithm to efficiently construct the reachable state space $\mathbb{X}^R(x_0)$ , $x_0 \in \text{supp}_{b_0}$. Indeed, the previous assumption on the observation and controls allows to compute the state space more efficiently. It is presented the algorithm for the case where there is an order with the observation which respect the topological order of the state space, i.e. when

$$\forall (o, o') \in \mathbb{O}_d^2, o < o' \Rightarrow \forall (x, x') \in \tilde{h}^{-1}(o) \times \tilde{h}^{-1}(o'), x \notin \mathbb{X}^{\mathrm{R}}(x') \ .$$

That condition implies that if $\tilde{h}(x) < \tilde{h}(x_0)$, then $x'$ cannot be a predecessor of $x$.

The implementations may construct an ordered reachable state space for each $x_0 \in \mathrm{supp}_{b_0}$ thanks to Algorithm 7 (discussed below), which returns the reachable state space and the successors of each state. Algorithm 7 complexity is in $O(d^m \mathcal{T})$. An underlying assumption of the algorithm is that we have an ordered observation set. The algorithm can be adapted to the case where there is only a partial order on the observation with some additional refinement to get an ordered reachable state space.

When considering the previous assumptions on the controls and observations, the observations create a number of separations of the state space $\mathbb{X}$ . On the other hand, applying the controls on a given state gives points that are on a deformed "discrete parallelepiped" (a set of points whose convex hull is a parallelepiped). The form of that parallelepiped depends on the observation. The implementations may create the reachable state space by putting multiple "discrete parallelepipeds" next to each other, until reaching the frontier delimiting the changes to the observation. Crossing the frontier gives new points on another observation, where the implementations may apply that construction again. The implementations continue the algorithm until $\mathcal{T}$ "discrete parallelepipeds" are put in each of the three directions of the controls. The implementations compute the frontier of the "discrete parallelepiped" through the use of Algorithm 6 (discussed below). Finally, the implementations may get the successors of a given state $x$ by the controls $u$ by looking at the order of the other states in ListStates($o$). Getting a list of successors may hence be computed when using Algorithm 7 without changing its complexity.

---

**Algorithm 6:** Function used to find the relevant border states to compute $\mathbb{X}^{\mathrm{R}}(x_0)$

---

**Function** *NewLimits(ListStates, ListLimits, NewStates, o)*:

    LimitsToAdd = [];

    **for** $i \in \{1, \dots l\}$ **do**

        **for** $j \in \{1, \dots m\}$ **do**

            **for** $k \in \{1, \dots n\}$ **do**

                CurrentIndex = (i-1)*(m*n) + (j-1)*n + k;

                **if** $h(NewStates[CurrentIndex]) \neq o$ **then**

                    continue;

                **end**

                **if** $(h(NewStates[CurrentIndex + 1]) \neq o)$ *or* $(h(NewStates[CurrentIndex + n]) \neq o)$ *or* $(h(NewStates[CurrentIndex + m * n]) \neq o)$ **then**

                    append(LimitsToAdd, NewStates[CurrentIndex];

                **end**

            **end**

        **end**

    **end**

**end**

---

---

**Algorithm 7:** Construction of $\mathbb{X}^R(x_0)$ and the list of successors

**Initialization:**

  **for** $o \in \mathbb{O}_d$ **do**

    ListStates$(o) = [\,]$;

    ListLimits$(o) = [\,]$;

    LimitsTime$(o) = [\,]$;

  **end**

  ListStates$(o_0) = [x_0]$;

  ListLimits$(o_0) = [x_0]$;

  LimitsTime$(o_0) = [0]$;

**end**

**for** $o \in \mathbb{O}_d$ **do**

  NotFinished $= (|\text{ListLimits}(o)| < 1)$;

  **while** $NotFinished = True$ **do**

    x$=$ pop(ListLimits);

    t $=$ pop(LimitsTime) $+ 1$;

    **if** $t > \mathcal{T}$ **then**

      continue;

    **end**

    NewStates $= f(\text{x}, \mathbb{U}_d^{(o)})$;

    **if** NewStates $\not\subset h^{(-1)}(\text{o})$ **then**

      **for** $o' \in \mathbb{O}_d, o' > o$ **do**

        StatesToAdd $=$ NewStates $\cap h^{(-1)}(\text{o'})$ append(ListStates(o'), StatesToAdd);

        append(ListLimits(o'), StatesToAdd);

        append(LimitsTime(o'), t $*$ ones($|StatesToAdd|$));

      **end**

    **end**

    LimitsToAdd $=$ NewLimits(ListStates, ListLimits, NewStates, o));

    append(ListStates(o), NewStates$\cap h^{(-1)}(\text{o})$);

    append(ListLimits(o), LimitsToAdd);

    append(LimitsTime(o), t $*$ ones($|LimitsToAdd|$));

    **if** $|\text{ListLimits}(o)| < 1$ **then**

      NotFinished $=$ False;

    **end**

  **end**

**end**

---

**Construction of the reachable belief space.** Now that the state space is constructed, the construction of the reachable belief space is discussed. To do so, the implementations browse through the ordered state space. As the states and successors are known, one only needs to go through the successors of each belief to get the ordered belief state thanks to Algorithm 9, which is in $\mathcal{O}\left(md|\text{supp}_{b_0}||\mathbb{B}^R|\right)$. The algorithm uses a representation of the belief similar to the Tables presented in Michael L. Littman, Algorithms for Sequential Decision Making, PhD thesis, Brown University, 1996, which is incorporated herein by reference.

Indeed, the implementations represent beliefs as tables $D_b$ of size $|\text{supp}_{b_0}|$.

Each component of the table represents the state the system would be if the initial state was $x_{0,i} \in \text{supp}_{b_0}$.

Hence, each component is in $\mathbb{X}_d \cup \{\delta\}$, where $\delta$ is an added element, the cemetery, which represents an empty state. When the i-th component of $D_b$ is $\delta$, it means that the initial state could not have been $x_{0,i}$.

With this representation, the implementations get the different probability of each component:

$$b(x) = \frac{\sum_{i \in \left\{1,\dots,|\text{supp}_{b_0}|\right\}, D_b(i)=x} b_0(x_{0,i})}{\sum_{j \in \left\{1,\dots,|\text{supp}_{b_0}|\right\}, D_b(j) \neq \delta} b_0(x_{0,j})}$$

Moreover, the probability of going from b to b' = $\tau(b, u, o)$ (i.e. for b' a successor of b) is given by:

$$Q(b, u, o) = \frac{\sum_{i \in \left\{1,\dots,|\text{supp}_{b_0}|\right\}, D_{b'}(i)=\delta} b_0(x_{0,i})}{\sum_{j \in \left\{1,\dots,|\text{supp}_{b_0}|\right\}, D_b(j) \neq \delta} b_0(x_{0,j})}$$

Algorithm 9 simply uses function *Successors* (defined in Algorithm 8) to find the successors of a given belief. The beliefs added are ordered since the different states space are ordered due to how the discretization of the controls is chosen. Hence beliefs are always added after all their predecessors, which means that the implementations go through $\mathbb{B}^R$ only once.

---

**Algorithm 8:** Function returning the successors of a given belief $b$ that share a given observation $o$

**Function** $Successors(D_b, o')$:
    BeliefSuccessors = [];
    **for** $i \in \left\{1, \dots, |\text{supp}_{b_0}|\right\}$ **do**
        **if** $D_b[i] = \delta$ **then**
            Successors[i] = $\delta$ * ones(d);
        **else**
            Successors[i] = StatesSuccessors($D_b[i]$, o');
        **end**
    **end**
    **for** $index \in Index(\mathbb{U}_d^{(o)})$ **do**
        **if** $Successors[:][index] \neq \delta * ones(|\text{supp}_{b_0}|)$ **then**
            append(BeliefSuccessors, Successors[:][index]);
        **end**
    **end**
    **return** *BeliefSuccessors*
**end**

---

**Algorithm 9:** Construction of the reachable belief space $\mathbb{B}^R$

```
Initialization:
    for o ∈ 𝕆_d do
        𝔹^R(o) = [];
        BeliefsToAdd(o) = [];
        NextBeliefs(o) = [];
    end
    𝔹^R(o_0) = [D_b(b_0)];
    BeliefsToAdd(o_0) = [D_b(b_0)];
end
for o ∈ 𝕆_d do
    NotFinished = True;
    if |BeliefsToAdd(o)| < 1 then
        NotFinished = False;
    end
    while NotFinished=True do
        D_b = pop(BeliefsToAdd(o));
        for o' ∈ 𝕆_d, o' ≥ o do
            NextBeliefs(o') = Successors(D_b, o');
            for D_b' ∈ NextBeliefs(o') do
                if D_b' ∉ BeliefsToAdd(o') then
                    append(BeliefsToAdd(o'), D_b');
                    append(𝔹^R(o'), D_b');
                end
            end
        end
        if |BeliefsToAdd(o)| < 1 then
            NotFinished = False;
        end
    end
end
```

After applying Algorithm 9, the implementations have the belief space and the different transitions between the different beliefs. The implementations may therefore apply Algorithm 5 to solve Problem (4.1).

**First application: oil reservoir with water injection**

It is now discussed the case of an oil reservoir where the pressure is kept constant by reinjecting water in the reservoir. The deterministic version of that problem was treated hereinabove. A partial observation of the content of the reservoir is now added.

The state is reduced to the vector $x_t = (V_t^\omega, V_t^p)$, whereas the control is the bottom-hole pressure $x_t = P_t$.

Enough water is injected to keep the pressure constant, hence the amount of water injected is not a control itself, but is deduced from the bottom-hole pressure P. The observation is the water-cut $w^{ct}$.

Full formulation

$$\max_{(V_t^w, P_t, w_t^{ct})} \sum_{t=0}^{T-1} \left[ \rho^t r_t \alpha \frac{P^R - P_t}{B_o(P^R)} [1 - w_t^{ct}] - \rho^t c_t \alpha \frac{P^R - P_t}{B_w(P^R)} \right] \qquad (4.4\text{a})$$

$$s.t. \ L_{V_0^w, V_0^p} = \mu_0 , \qquad (4.4\text{b})$$

$$w_t^{ct} = WCT \left( \frac{V_t^w B_w(P^R)}{V^p} \right) , \ \forall t \in \mathbb{T} , \qquad (4.4\text{c})$$

$$V_{t+1}^w = V_t^w - \alpha \frac{P^R - P_t}{B_w(P^R)} [w_t^{ct} - 1] , \ \forall t \in \mathbb{T} , \qquad (4.4\text{d})$$

$$F_{min}^w \leq \alpha \frac{P^R - P_t}{B_w(P^R)} w_t^{ct} \leq F_{max}^w , \ \forall t \in \mathbb{T} , \qquad (4.4\text{e})$$

$$F_{min}^o \leq \alpha \frac{P^R - P_t}{B_o(P^R)} [1 - w_t^{ct}] \leq F_{max}^o , \ \forall t \in \mathbb{T} , \qquad (4.4\text{f})$$

$$P_t \geq 0 , \ \forall t \in \mathbb{T} , \qquad (4.4\text{g})$$

$$\sigma(P_t) \in \sigma(w_0^{ct}, \ldots, w_t^{ct}, P_0, \ldots, P_{t-1}) , \ \forall t \in \mathbb{T} . \qquad (4.4\text{h})$$

The state space $\mathbb{X}$ and the belief space $\mathbb{B}$ are created thanks to Algorithms 7 and 9. When considering $|\mathbb{U}_d| = 10$, $|\mathbb{O}_d| = 10$, $|\text{supp}(b_0)| = 10$, $T = 100$, one obtains Table 4.2. The bounds obtained with Theorem 8 and Proposition 13 are of, respectively, $2{,}9^{47}$ and $57226240$. This is therefore far lower than any of the two bounds presented (by a factor of $10^{41}$ for the general det-POMDP bound, and of around 50 for the mon-det-POMDP bound).

The size of the problem is such that it can be solved in a reasonable time: the generation of the problem was made in 3200 seconds (applying both Algorithms 7 and 9), while the solving time was of 400 seconds (applying Algorithm 1). The code may be parallelized.

Table 4.2: Size of the sets computed thanks to Algorithms 7 and 9

| Set considered | Cardinal of the set |
| --- | --- |
| | 55885 |
| $\mathbb{X}$ $\mathbb{B}$ | 809665 |

The implementation of the method on a computer is now discussed.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 13 shows an example of the system, wherein the system is a client computer system, *e.g.* a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks; and CD-ROM disks 1040. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively, or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method.

## Claims

1. A computer-implemented method for multiperiod optimization of oil and/or gas production, the method comprising:

   - providing:

     ◦ a controlled dynamical system describing the evolution over time of a state of an oil and/or gas reservoir,
     ◦ a time-dependent admissible set of controls, the controls describing actions respecting constraints for controlling oil and/or gas flow and/or pressure,
     ◦ time-dependent observations of the content of the reservoir,

   - optimizing, with respect to the state of the reservoir, the controls and the observations, an expected value over a given time span of an objective production function of the state, the controls and the observations.

2. The method of claim 1, wherein the controlled dynamical system comprises evolution equations derived from material balance equations and/or black oil models.

3. The method of claim 2, wherein the controlled dynamical system is of the type:

$$x_{t+1} = f(x_t, u_t),$$

where $t$ represents the time, $x_t$ the state of the reservoir at time $t$, and $u_t$ the controls at time $t$, and where $f$ is of the type:

$$f : (x, u) \mapsto \begin{pmatrix} x^{(1)} - \Phi^{(1)}(x, u) \\ x^{(2)} - \Phi^{(2)}(x, u) + \left[ x^{(1)} R_s\left(x^{(5)}\right) - \right. \\ \left. \left( x^{(1)} - \Phi^{(1)}(x, u) \right) R_s\left(\Xi(x, u)\right) \right] \\ x^{(3)} - \Phi^{(3)}(x, u) \\ x^{(5)}\left( 1 + c_f(\Xi(x, u) - x^{(5)}) \right) \\ \Xi(x, u) \end{pmatrix}$$

where:

- $x = (x^{(1)}, x^{(2)}, x^{(3)}, x^{(4)}, x^{(5)})$,
- $R_s$ represents dissolved gas,
- $c_f$ represents the pore compressibility of the reservoir,
- $(x, u) : \mapsto \Phi(x, u)$ represents production values as a function of $(x, u)$,
- $\Xi$ is a function such that $P^R_{t+1} = \Xi(x_t, u_t)$ , where $P^R$ represents a reservoir pressure.

4. The method of any one of claims 1 to 3, wherein the optimizing comprises solving an optimization problem of the type:

$$\min_{X,O,U} \mathbb{E}\left[ \sum_{t=0}^{\mathcal{T}-1} L_t(X_t, U_t) + K(X_{\mathcal{T}}) \right]$$

$$s.t. L_{X_0} = \mu_0$$

$$X_{t+1} = f(X_t, U_t), \forall t \in \mathbb{T},$$

$$O_t = h(X_t), \forall t \in \mathbb{T},$$

$$U_t \in U_t^{ad}(X_t), \forall t \in \mathbb{T},$$

$$\sigma(U_t) \subset \sigma(O_0, \dots, O_t, U_0, \dots, U_{t-1}), \forall t \in \mathbb{T},$$

where:

- $X, O, U$ are respectively the state of the reservoir, the observations, and the controls,
- 

$$\mathbb{T} = \{0, \dots, \mathcal{T}\}$$

is a finite set of time steps, where $\mathcal{T}$ is a positive integer,
- $L_t$ is the objective production function at time $t$,
-

$$K(X_{\mathcal{T}})$$

is an objective final production function,
- $\mu_0$ is a probability distribution representing an initial state of the reservoir,
- $X_{t+1} = f(X_t, U_t)$ corresponds to the dynamical system,
- $h$ is an observation function,
- $U_t^{ad}$ represents a set of admissible controls at time $t$.

5. The method of any one of claims 1 to 4, wherein the observations comprise partial observations.

6. The method of claim 5, wherein the observations depend only on the state of the reservoir.

7. The method of claim 6, wherein the observations are observations functions of the form

$$O_t = h(X_t),$$

where $X_t$, $O_t$ represent respectively the state of the reservoir and the observations at time $t$, and where $h$ is of the type

$$h(x) = \begin{pmatrix} x^{(5)} \\ \omega^{ct}(x^{(3)}, x^{(4)}, x^{(5)}) \\ g^{or}(x^{(2)}, x^{(4)}, x^{(5)}) \end{pmatrix},$$

where $w^{ct}$ is a function representing a water-cut and $g^{or}$ is a function representing a gas-oil ratio, and where $x = (x^{(1)}, x^{(2)}, x^{(3)}, x^{(4)}, x^{(5)})$.

8. The method of any one of claims 5 to 7, wherein the optimization comprises solving an optimization problem that is a Deterministic Partially Observed Markov Decision Process (det-POMDP).

9. The method of claim 8, wherein the optimization comprises discretizing the optimization problem.

10. The method of claim 9, wherein discretizing the optimization problem comprises providing a discrete control set and a discrete observation set and building a discrete space state by recursively applying the dynamics on a given initial state with associated controls, the discrete space state being a set of the space states reachable from the given initial state.

11. The method of claim 10, wherein discretizing the optimization problem comprises constructing a state of beliefs, which are probabilities on the discrete state space.

12. The method of claim 11, wherein the Deterministic Partially Observed Markov Decision Process has monotonicity, such that the state of reachable beliefs is included in a subset of the probability space.

13. A computer program comprising instructions for performing the method of any one of claims 1 to 12.

14. A computer-readable data storage medium having recorded thereon the computer program of claim 13.

15. A computer system comprising a processor coupled to a memory, the memory having recorded thereon the computer program of claim 13.

FIG. 1

FIG. 2

## FIG. 3

## FIG. 4

## FIG. 5

## FIG. 6

## FIG. 7

## FIG. 8

FIG. 9

## FIG. 10

# FIG. 11

# FIG. 12

1000

1010

CPU

1070

RAM

1020

Mass storage
devices controler

Display

1080

1030

Hard
drive

CDROM

Haptic
device

1090

1040

B
U
S

Network Adapter

Video
RAM

1100

1050

Network

GPU

1060

1110

## FIG. 13

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/130696 A1 (DAVIDSON JEFFREY E [US] ET AL) 24 May 2012 (2012-05-24) <br> * abstract * <br> * figures 1-3 * <br> * paragraph [0008] - paragraph [0009] * <br> * paragraph [0020] * <br> * paragraph [0042] * <br> * paragraph [0047] - paragraph [0048] * <br> * paragraph [0050] * <br> ----- | 1-15 | INV. <br> E21B43/00 |
| A | AWASTHI UTSAV ET AL: "Multiperiod optimization model for oilfield production planning: bicriterion optimization and two-stage stochastic programming model", OPTIMIZATION AND ENGINEERING, SPRINGER NEW YORK LLC, US, <br> vol. 20, no. 4, 19 July 2019 (2019-07-19), pages 1227-1248, XP036914101, ISSN: 1389-4420, DOI: 10.1007/S11081-019-09455-0 [retrieved on 2019-07-19] <br> * abstract * <br> * the whole document * <br> ----- | 1-15 | |
| A | Bonet Blai: "Deterministic POMDPs Revisited", <br> , <br> 9 May 2012 (2012-05-09), XP055920685, Retrieved from the Internet: URL:https://arxiv.org/ftp/arxiv/papers/1205/1205.2659.pdf [retrieved on 2022-05-12] <br> * abstract * <br> * the whole document * <br> ----- <br> -/-- | 8-12 | TECHNICAL FIELDS SEARCHED (IPC) <br><br> E21B |

The present search report has been drawn up for all claims

| Place of search | Date of completion of the search | Examiner |
|---|---|---|
| The Hague | 12 May 2022 | Hustedt, Bernhard |

EPO FORM 1503 03.82 (P04C01)

**page 1 of 2**

Europäisches
Patentamt

European
Patent Office

Office européen
des brevets

## EUROPEAN SEARCH REPORT

Application Number

EP 21 30 6844

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| L | CYRILLE VESSAIRE ET AL: "Multistage Optimization of a Petroleum Production System with Material Balance Model", ARXIV.ORG, CORNELL UNIVERSITY LIBRARY, 201 OLIN LIBRARY CORNELL UNIVERSITY ITHACA, NY 14853, 4 January 2022 (2022-01-04), XP091130347, * the whole document * | 1-15 | |

TECHNICAL FIELDS
SEARCHED (IPC)

The present search report has been drawn up for all claims

| Place of search | Date of completion of the search | Examiner |
|---|---|---|
| The Hague | 12 May 2022 | Hustedt, Bernhard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 21 30 6844

This annex lists the patent family members relating to the patent documents cited in  the above-mentioned European search report.
The members are as contained in the European Patent Office EDP file on
The European Patent Office is in no way liable for these particulars which are merely given for the purpose of information.

12-05-2022

| Patent document cited in search report | | Publication date | Patent family member(s) | | Publication date |
|---|---|---|---|---|---|
| US 2012130696 | A1 | 24-05-2012 | BR 112012002907 | A2 | 05-04-2016 |
| | | | CA 2766437 | A1 | 17-02-2011 |
| | | | CN 102473232 | A | 23-05-2012 |
| | | | EP 2465073 | A1 | 20-06-2012 |
| | | | US 2012130696 | A1 | 24-05-2012 |
| | | | WO 2011019421 | A1 | 17-02-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DIMITRI P. BERTSEKAS.** Dynamic Programming and Optimal Control. Athena Scientific, 2017, vol. I
- Algorithms for Sequential Decision Making. **MICHAEL L. LITTMAN.** PhD thesis. Brown University, September 1996